# EUROPEAN PATENT APPLICATION

(11) **EP 4 593 090 A1**
(43) Date of publication of application: **30.07.2025**
(21) Application number: 23873274.7
(22) Date of filing: 27.09.2023
(51) Int. Cl.: H01L 31/107, H01L 31/0352

(54) **SINGLE-PHOTON AVALANCHE DIODE, ELECTRONIC DEVICE, AND LIDAR DEVICE**

(30) Priority: 28.09.2022 KR 20220122968; 11.09.2023 KR 20230120623
(71) Applicant: Trupixel Inc., Daejeon 34138 (KR)
(72) Inventor: LEE, Myung-Jae, Seoul 02792 (KR); PARK, Eun Sung, Seoul (KR)
(74) Representative: Sander, Rolf
(86) International application number: PCT/KR2023/015143
(87) International publication number: WO 2024/072167

(57) **Abstract**

The single-photon avalanche diode includes a heavily doped region, a first lightly doped region covering the heavily doped region, a guard ring provided on a side surface of the first lightly doped region, a first well covering the first lightly doped region and the guard ring, and a contact electrically connected to the first well, wherein the heavily doped region, the first lightly doped region, and the guard ring have a first conductivity type, and the first well and the contact have a second conductivity type.

## Description

### [Technical Field]

The present disclosure relates to single-photon avalanche diodes, electronic devices, and LiDAR devices.

### [Background Art]

The Avalanche Photodiode (APD) is a solid-stage light detector in which a high bias voltage is applied to the PN conjugation to provide a high first step gain from Avalanche Multiplication. When a photon with enough energy to release the electron reaches the photo diode, an electron-hole pair (EHP) is generated. The high electric field accelerates the photogenerated electrons quickly to (+) side, and the additional electrons-hole pairs are generated in succession by the impact ionization by such acceleration electrons. And then the electrons accelerate to the anode. Similarly, the holes are accelerated quickly toward (-) side and causes the same phenomenon. This process repeats the process leading to the Avalanche of the output current pulse and light generation electrons. Thus, APD is a semiconductor-based device that operates similarly to photomultiplier tubes. The linear mode APD is an effective amplifier that can control the bias voltage to set a gain and obtain tens of to thousands of gains in linear mode.

Single-Photon Avalanche Diode (SPAD) is an APD in which the P-N bonding part is biased more than breakdown voltage to operate in the GEIGER mode. SPAD can generate a very large current, and as a result, a pulse signal that can be easily measured with a quenching resistor (or quenching circuit) can be obtained. That is, the SPAD operates as a device that generates a large pulse signal compared to the linear mode APD. After the triggering the Avalanche, the quenching resistance or the quenching circuit is used to reduce the bias voltage under the breakdown voltage for quenching the Avalanche process. Once the Avalanche Process is quenched, the bias voltage is rising back over the breakdown voltage so that the SPAD is reset for the detection of another photon. The above process can be referred to as re-biasing of SPAD.

SPAD can be configured with quenching resistance or circuit, recharge circuits, memory, gate circuits, counter, and time-digital converter. SPAD pixels are semiconductor-based, so it can be easily arrayed.

### [Disclosure]

### [Technical Problem]

A technical problem is to provide single-photon avalanche diodes, electronic devices, and LiDAR devices with improved noise characteristics.

A technical problem is to provide single-photon avalanche diodes, electronic devices, and LiDAR devices with improved efficiency.

A technical problem is to provide single-photon avalanche diodes with low breakdown voltage and electronic devices and LiDAR devices including the same.

A technical problem is to provide single-photon avalanche diodes operating without forming a guard ring, and electronic devices and LiDAR devices including the same.

A technical problem is to provide single-photon avalanche diodes, electronic devices, and LiDAR devices that operate more stably.

A technical problem is to provide single-photon avalanche diodes with enhanced characteristics together with improved guard rings, and electronic devices and LiDAR devices including the same.

However, the technical problems are not limited to the above disclosure.

### [Technical Solution]

According to an embodiment, a single-photon avalanche diode comprises a heavily doped region, a first lightly doped region covering the heavily doped region, a guard ring provided on a side surface of the first lightly doped region, a first well covering the first lightly doped region and the guard ring, and a contact electrically connected to the first well. The heavily doped region, the first lightly doped region, and the guard ring have a first conductivity type. The first well and the contact have a second conductivity type.

The single-photon avalanche diode further comprises, a relief area provided between the first well and the contact. The relief region has the second conductivity type and has a lower doping concentration than the contact.

The single-photon avalanche diode further comprises, a polysilicon pattern provided on the guard ring.

The single-photon avalanche diode further comprises, a second lightly doped region provided on the first lightly doped region; and a second well provided between the second lightly doped region and the first well. The second lightly doped region and the second well have the second conductivity type.

The guard ring protrudes from a top surface of the second well.

According to an embodiment, a single-photon avalanche diode comprises a heavily doped region, a first lightly doped region covering the heavily doped region, a guard ring provided on a side surface of the first lightly doped region, a first well covering the first lightly doped region and the guard ring, and a contact electrically connected to the first well. The heavily doped region and the guard ring have a first conductivity type. The first lightly doped region, the first well, and the contact have a second conductivity type.

The single-photon avalanche diode further comprises, a second well provided on the first lightly doped region. The second well has the second conductivity type.

A top surface of the second well is disposed higher than a top surface of the guard ring.

The single-photon avalanche diode further comprises, a relief region provided between the first well and the contact. The relief region has the second conductivity type and has a lower doping concentration than the contact.

The single-photon avalanche diode further comprises, a polysilicon pattern provided on the guard ring.

According to an embodiment, an electronic device comprises a single-photon avalanche diode including a heavily doped region, a first lightly doped region covering the heavily doped region, a guard ring provided on a side surface of the first lightly doped region, a first well covering the first lightly doped region and the guard ring, and a contact electrically connected to the first well. The heavily doped region, the first lightly doped region, and the guard ring have a first conductivity type. The first well and the contact have a second conductivity type.

According to an embodiment, a LiDAR device comprises electronic devices. The electronic device includes a single-photon avalanche diode. The the single-photon avalanche diode includes a heavily doped region, a first lightly doped region covering the heavily doped region, a guard ring provided on a side surface of the first lightly doped region, a first well covering the first lightly doped region and the guard ring, and a contact electrically connected to the first well. The heavily doped region, the first lightly doped region, and the guard ring have a first conductivity type. The first well and the contact have a second conductivity type.

### [Advantageous Effects]

The present disclosure may provide single-photon avalanche diodes, electronic devices, and LiDAR devices with improved noise characteristics.

The present disclosure may provide single-photon avalanche diodes, electronic devices, and LiDAR devices with improved efficiency.

The present disclosure may provide single-photon avalanche diodes with low breakdown voltage and electronic devices and LiDAR devices including the same.

The present disclosure may provide single-photon avalanche diodes operating without forming a guard ring, and electronic devices and LiDAR devices including the same.

The present disclosure may provide single-photon avalanche diodes, electronic devices, and LiDAR devices that operate more stably.

The present disclosure may provide single-photon avalanche diodes with enhanced characteristics together with improved guard rings, and electronic devices and LiDAR devices including the same.

The effects of the invention are not limited to the above disclosure.

### [Description of Drawings]

FIG. 1 is a plan view of a single-photon avalanche diode (SPAD) according to example embodiments.
FIG. 2 is a cross-sectional view of the single-photon avalanche diode (SPAD) of FIG. 1 taken along line A-A'.
FIG. 3 is a plan view of a single-photon avalanche diode (SPAD) according to example embodiments.
FIG. 4 is a cross-sectional view of the single-photon avalanche diode (SPAD) of FIG. 3 taken along line B-B'.
FIG. 5 is a plan view of a single-photon avalanche diode (SPAD) according to example embodiments.
FIG. 6 is a cross-sectional view of the single-photon avalanche diode (SPAD) of FIG. 5 taken along line C-C'.
FIG. 7 is a plan view of a single-photon avalanche diode (SPAD) according to example embodiments.
FIG. 8 is a cross-sectional view of the single-photon avalanche diode (SPAD) of FIG. 7 taken along line D-D'.
FIG. 9 is a plan view of a single-photon avalanche diode (SPAD) according to example embodiments.
FIG. 10 is a cross-sectional view of the single-photon avalanche diode (SPAD) of FIG. 9 taken along line E-E'.
FIG. 11 is a plan view of a single-photon avalanche diode (SPAD) according to example embodiments.
FIG. 12 is a cross-sectional view of the single-photon avalanche diode (SPAD) of FIG. 11 taken along line F-F'.
FIG. 13 is a plan view of a single-photon avalanche diode (SPAD) according to example embodiments.
FIG. 14 is a cross-sectional view of the single-photon avalanche diode (SPAD) of FIG. 13 taken along line G-G'.
FIG. 15 is a plan view of a single-photon avalanche diode (SPAD) according to example embodiments.
FIG. 16 is a cross-sectional view of the single-photon avalanche diode (SPAD) of FIG. 15 taken along line H-H'.
FIG. 17 is a plan view of a single-photon avalanche diode (SPAD) according to example embodiments.
FIG. 18 is a cross-sectional view of the single-photon avalanche diode (SPAD) of FIG. 17 taken along line I-I'.
FIG. 19 is a plan view of a single-photon avalanche diode (SPAD) according to example embodiments.
FIG. 20 is a cross-sectional view of the single-photon avalanche diode (SPAD) of FIG. 19 taken along line J-J'.
FIG. 21 is a plan view of the single-photon avalanche diode of FIG. 2 according to an example embodiment.
FIG. 22 is a plan view of the single-photon avalanche diode of FIG. 2 according to an example embodiment.
FIG. 23 is a plan view of the single-photon avalanche diode of FIG. 2 according to an example embodiment.
FIG. 24 is a plan view of the single-photon avalanche diode of FIG. 2 according to an example embodiment.
FIG. 25 is a plan view of the single-photon avalanche diode of FIG. 2 according to an example embodiment.
FIG. 26 is a plan view of the single-photon avalanche diode of FIG. 2 according to an example embodiment.
FIG. 27 is a cross-sectional view corresponding to line H-H' of FIG. 15 illustrating a single-photon avalanche diode according to example embodiments.
FIG. 28 is a cross-sectional view corresponding to line H-H' of FIG. 15 illustrating a single-photon avalanche diode according to example embodiments.
FIG. 29 is a plan view of a single-photon avalanche diode (SPAD) according to example embodiments.
FIG. 30 is a cross-sectional view of the single-photon avalanche diode (SPAD) of FIG. 29 taken along line I-I'.
FIG. 31 is a plan view of a single-photon avalanche diode (SPAD) according to example embodiments.
FIG. 32 is a cross-sectional view of the single-photon avalanche diode (SPAD) of FIG. 31 taken along line J-J'.
FIG. 33 is a cross-sectional view of a single-photon detector according to an example embodiment.
FIG. 34 is a cross-sectional view of a single-photon detector according to an example embodiment.
FIG. 35 is a cross-sectional view of a single-photon detector according to an example embodiment.
FIG. 36 is a top view of the first diffraction pattern of FIG. 35.
FIG. 37 is a cross-sectional view of a single-photon detector according to an example embodiment.
FIG. 38 is a top view of a single-photon detector array according to an example embodiment.
FIG. 39 is a cross-sectional view taken along line K-K' of FIG. 38.
FIG. 40 is a top view of the output pattern, the bias pattern, and the shield pattern of FIG. 39.
FIG. 41 is a cross-sectional view taken along line K-K' of FIG. 38.
FIG. 42 is a cross-sectional view taken along line K-K' of FIG. 38.
FIG. 43 is a cross-sectional view taken along line K-K' of FIG. 38.
FIG. 44 is a cross-sectional view taken along line K-K' of FIG. 38.
FIG. 45 is a cross-sectional view taken along line K-K' of FIG. 38.
FIG. 46 is a cross-sectional view taken along line K-K' of FIG. 38.
FIG. 47 is a cross-sectional view taken along line K-K' of FIG. 38.
FIG. 48 is a block diagram for describing an electronic device according to an example embodiment.
FIGS. 49 and 50 are conceptual diagrams illustrating cases in which a LiDAR device according to an example embodiment is applied to a vehicle.
FIG. 51 is a cross-sectional view of a single-photon detector according to an example embodiment.
FIG. 52 is a cross-sectional view taken along line K-K' of FIG. 38.

### [Best Mode]

According to an embodiment, a single-photon avalanche diode comprises a heavily doped region, a first lightly doped region covering the heavily doped region, a guard ring provided on a side surface of the first lightly doped region, a first well covering the first lightly doped region and the guard ring, and a contact electrically connected to the first well. The heavily doped region, the first lightly doped region, and the guard ring have a first conductivity type. The first well and the contact have a second conductivity type.

According to an embodiment, a single-photon avalanche diode comprises a heavily doped region, a first lightly doped region covering the heavily doped region, a guard ring provided on a side surface of the first lightly doped region, a first well covering the first lightly doped region and the guard ring, and a contact electrically connected to the first well. The heavily doped region and the guard ring have a first conductivity type. The first lightly doped region, the first well, and the contact have a second conductivity type.

According to an embodiment, an electronic device comprises a single-photon avalanche diode including a heavily doped region, a first lightly doped region covering the heavily doped region, a guard ring provided on a side surface of the first lightly doped region, a first well covering the first lightly doped region and the guard ring, and a contact electrically connected to the first well. The heavily doped region, the first lightly doped region, and the guard ring have a first conductivity type. The first well and the contact have a second conductivity type.

According to an embodiment, a LiDAR device comprises electronic devices. The electronic device includes a single-photon avalanche diode. The the single-photon avalanche diode includes a heavily doped region, a first lightly doped region covering the heavily doped region, a guard ring provided on a side surface of the first lightly doped region, a first well covering the first lightly doped region and the guard ring, and a contact electrically connected to the first well. The heavily doped region, the first lightly doped region, and the guard ring have a first conductivity type. The first well and the contact have a second conductivity type.

### [Mode for Invention]

Hereinafter, with reference to the accompanying drawings, the embodiments of the present disclosure will be described in detail. In the following drawings, the same reference code refers to the same component, and the size of each component in the drawings may be exaggerated for the clarity and convenience of the description. On the other hand, the embodiments described below are only an example, and various variations are possible from these embodiments.

Hereinafter, what is described as "on" may include not only being directly on contact but also being on non-contact.

Singular expressions include plural expressions unless the context clearly dictates otherwise. In addition, when a certain component is said to "include", this means that it may further include other components without excluding other components unless otherwise stated.

In addition, terms such as "unit" or "part" described in the specification mean a unit that processes at least one function or operation.

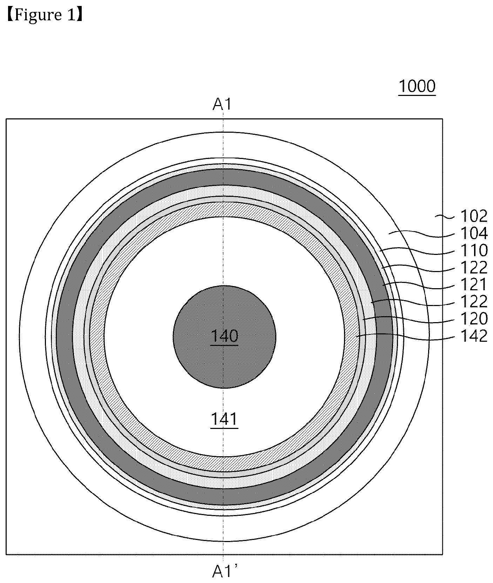

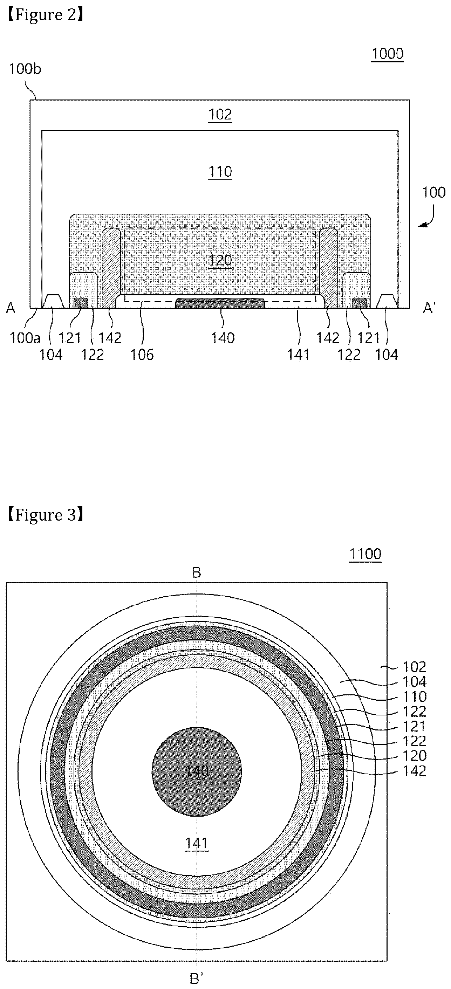

FIG. 1 is a plan view of a single-photon avalanche diode (SPAD) according to example embodiments. FIG. 2 is a cross-sectional view of the single-photon avalanche diode (SPAD) of FIG. 1 taken along line A-A'.

Referring to FIGS. 1 and 2, a single-photon avalanche diode (SPAD) 1000 may be provided. The single-photon avalanche diode (SPAD) 1000 may be referred to as a Geiger-mode Avalanche diode (Geiger-mode APD, G-APD). The single-photon avalanche diode (SPAD) 1000 may include a buried region 110, a first well 120, a first heavily doped region 140, a first lightly doped region 141, a first guard ring 142, a first contact 121, a first relief region 122, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the first well 120, the first heavily doped region 140, the first lightly doped region 141, the first guard ring 142, the first contact 121, and the first relief region 122 may be formed by implanting impurities into the semiconductor substrate 100. In the semiconductor substrate 100, the buried region 110, the first well 120, the first heavily doped region 140, the first lightly doped region 141, the first guard ring 142, the first contact 121, and the first relief region 122 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The first well 120 may be provided in the semiconductor substrate 100. The buried region 110 may be disposed between the first well 120 and the back side 100b. The upper and side surfaces of the first well 120 may be in direct contact with the buried region 110. The conductivity type of the first well 120 may be p-type. For example, the doping concentration of the first well 120 may be 1x10¹⁵ ~ 1x10¹⁸ cm⁻³. In one example, the first well 120 may have a uniform doping concentration. In one example, the doping concentration of the first well 120 may be smaller as it is closer to the front side 100a of the single-photon avalanche diode (SPAD) 1100.

The first heavily doped region 140 may be provided between the first well 120 and the front side 100a. The first heavily doped region 140 may be exposed on the front side 100a. The conductivity type of the first heavily doped region 140 may be n-type. The first heavily doped region 140 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the first heavily doped region 140 may be 1x10¹⁵ ~ 2x10²⁰ cm⁻³. In one example, the first heavily doped region 140 may be electrically connected to at least one of an external power supply, a DC-to-DC converter, and other power management integrated circuits. In one example, the first heavily doped region 140 may be electrically connected to at least one of a quenching resistor (or quenching circuit) and other pixel circuits. A quenching resistor or quenching circuitry may be configured to stop the avalanche effect and allow the single photon avalanche diode (SPAD) 1000 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1000 or receive signals from the single-photon avalanche diode (SPAD) 1000.

The first lightly doped region 141 may be configured to form a depletion region 106. The size of the depletion region 106 is shown as an example and is not limited. When reverse bias is applied to the single-photon avalanche diode (SPAD) 1000, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The first lightly doped region 141 may be configured to reduce or prevent a single-channel effect that occurs as the size of the semiconductor device decreases. For example, the single-channel effect may be that an electric current flows through the single-photon Avalanche diode 1000 even though no photons are incident. The first lightly doped region 141 may be provided between the first heavily doped region 140 and the first well 120. The first lightly doped region 141 may contact the upper and side surfaces of the first heavily doped region 140. The first lightly doped region 141 may be exposed on the front side 100a. On the front side 100a, the first lightly doped region 141 may surround the first heavily doped region 140. The conductivity type of the first lightly doped region 141 may be n-type. The first lightly doped region 141 may have a lower doping concentration than the first heavily doped region 140. For example, the doping concentration of the first lightly doped region 141 may be 1x10¹⁵ ~ 1x10¹⁹ cm⁻³. As The first lightly doped region 141 is used to form the depletion region 106, the tunneling noise and trap-assisted tunneling noise of the single-photon avalanche diode (SPAD) 1000 may be reduced, and the operating wavelength band of the single-photon avalanche diode (SPAD) 1000 may be widened.

The first guard ring 142 may be provided on the side of the first lightly doped region 141. The first guard ring 142 may surround the first lightly doped region 141. For example, the first guard ring 142 may have a ring shape extending along the side of the first lightly doped region 141. The first guard ring 142 may be in direct contact with the first lightly doped region 141. In another example, the first guard ring 142 may be spaced apart from the first lightly doped region 141. The first guard ring 142 may be exposed on the front side 100a. On the front side 100a, the first guard ring 142 may surround the first lightly doped region 141. The first guard ring 142 may be extended along a direction from the front side 100a to the back side 100b. The distance between the first guard ring 142 and the back side 100b may be less than the distance between the first lightly doped region 141 and the back side 100b. The first guard ring 142 may be spaced apart from the buried region 110 by the first well 120. The conductivity type of the first guard ring 142 may be n-type. The doping concentration of the first guard ring 142 may be lower than the doping concentration of the first lightly doped region 141. For example, the doping concentration of the first guard ring 142 may be 1x10¹⁵ ~ 5x10¹⁷ cm⁻³. The first guard ring 142 may improve breakdown characteristics of the single-photon avalanche diode (SPAD) 1000. Specifically, the first guard ring 142 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

The first contact 121 may be provided on the side of the first guard ring 142. The first contact 121 may be provided on the opposite side of the first lightly doped region 141 with the first guard ring 142 interposed therebetween. The first contact 121 may be exposed on the front side 100a. On the front side 100a, the first contact 121 may surround the first guard ring 142. In another example, a plurality of first contacts 121 may be provided. In this case, the plurality of contacts may each be electrically connected to a circuitry outside the single-photon avalanche diode (SPAD) 1000. The conductivity type of the first contact 121 may be a p-type. The doping concentration of the first contact 121 may be higher than the doping concentration of the first well 120. For example, the doping concentration of the first contact 121 may be 1x10¹⁵ ~ 2x10²⁰ cm⁻³. In one example, the first contact 121 may be electrically connected to at least one of an external power supply, a DC-to-DC converter, and other power management integrated circuits. In one example, the first contact 121 may be electrically connected to at least one of a quenching resistor (or quenching circuit) and other pixel circuits.

The first relief region 122 may be provided between the first contact 121 and the first well 120. The first relief region 122 may be electrically connected to the first contact 121 and the first well 120. The first relief region 122 may relieve the difference between the first contact 121 and the first well 120. The first relief region 122 may be extended along the first contact 121. The first relief region 122 may be provided on the side and top surfaces of the first contact 121. For example, the first relief region 122 may be in direct contact with the side and top surfaces of the first contact 121. The top and one side surfaces of the first relief region 122 may contact the first well 120. The other side surface of the first relief region 122 is exposed by the first well 120 and may contact the buried region 110. The first relief region 122 may be exposed on the front side 100a. On the front side 100a, the first relief region 122 may surround the first guard ring 142. The first relief region 122 may be spaced apart from the first guard ring 142. The first well 120 may extend between the first relief region 122 and the first guard ring 142. For example, a region between the first relief region 122 and the first guard ring 142 may be filled with the first well 120. Between the first relief region 122 and the first guard ring 142, the first well 120 may be exposed on the front side 100a. In one example, the first well 120 may not be provided in a region adjacent to the front side 100a. For example, a region adjacent to the front side 100a between the first relief region 122 and the first guard ring 142 may be filled with the substrate region 102. Between the first relief region 122 and the first guard ring 142, the substrate region 102 may be exposed on the front side 100a. The conductivity type of the first relief region 122 may be a p-type. The doping concentration of the first relief region 122 may be lower than the doping concentration of the first contact 121 and may be similar to or higher than the doping concentration of the first well 120. For example, the doping concentration of the first relief region 122 may be 1x10¹⁵ ~ 5x10¹⁷ cm⁻³.

The device isolation pattern 104 may be provided on the side surface of the first relief region 122. The device isolation pattern 104 may be exposed on the front side 100a. On the front side 100a, the device isolation pattern 104 may surround the first relief region 122. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1000 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the first relief region 122 and the substrate region 102 as well as the buried region 110. In another example, the device isolation pattern 104 may be formed to contact the first contact 121. In another example, the single-photon avalanche diode (SPAD) 1000 may not include a device isolation pattern 104. Each region may have a conductivity type opposite to the conductivity type described above. For example, regions described as having n-type may have a p-type, and regions described as having p-type may have n-type.

The present disclosure uses the first lightly doped region 141 to form the depletion region 106, so that tunneling noise characteristics and trap-assisted tunneling noise characteristics are improved, and a single-photon avalanche diode (SPAD) 1000 operating in a wide wavelength band is provided.

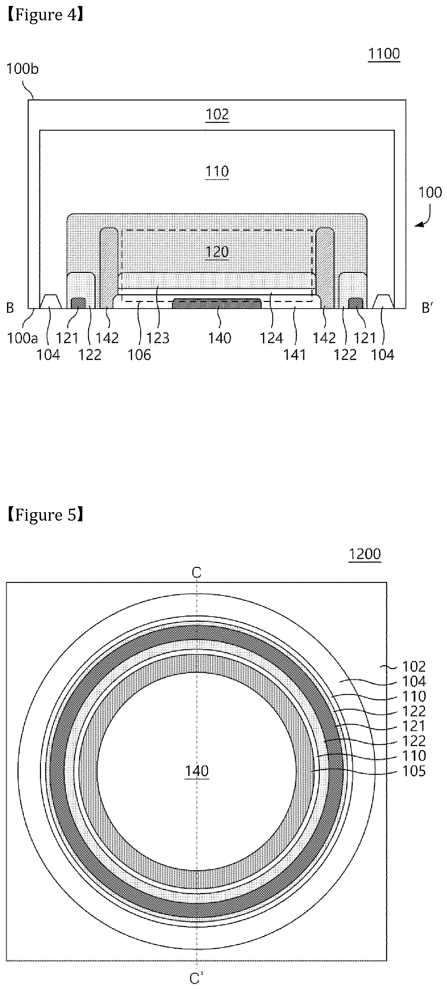

FIG. 3 is a plan view of a single-photon avalanche diode (SPAD) according to example embodiments. FIG. 4 is a cross-sectional view of the single-photon avalanche diode (SPAD) of FIG. 3 taken along line B-B'.

Referring to FIGS. 3 and 4, a single-photon avalanche diode (SPAD) 1100 may be provided. The single-photon avalanche diode (SPAD) 1100 may be referred to as a Geiger-mode Avalanche diode (Geiger-mode APD, G-APD). The single-photon avalanche diode (SPAD) 1100 may include a buried region 110, a first well 120, a first heavily doped region 140, a first lightly doped region 141, a first guard ring 142, a first contact 121, a first relief region 122, a second well 123, a second lightly doped region 124, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the first well 120, the first heavily doped region 140, the first lightly doped region 141, the first guard ring 142, the first contact 121, the first relief region 122, the second well 123, and the second lightly doped region 124 may be formed by implanting impurities into the semiconductor substrate 100. In the semiconductor substrate 100, the buried region 110, the first well 120, the first heavily doped region 140, the first lightly doped region 141, the first guard ring 142, the first contact 121, the first relief region 122, the second well 123, and the second lightly doped region 124 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-3

The first well 120 may be provided in the semiconductor substrate 100. The buried region 110 may be disposed between the first well 120 and the back side 100b. The upper and side surfaces of the first well 120 may be in direct contact with the buried region 110. The conductivity type of the first well 120 may be p-type. For example, the doping concentration of the first well 120 may be 1x10¹⁵ ~ 1x10¹⁸ cm⁻³. In one example, the first well 120 may have a uniform doping concentration. In one example, the doping concentration of the first well 120 may be smaller as it is closer to the front side 100a of the single-photon avalanche diode (SPAD) 1100.

The first heavily doped region 140 may be provided between the first well 120 and the front side 100a. The first heavily doped region 140 may be exposed on the front side 100a. The conductivity type of the first heavily doped region 140 may be n-type. The first heavily doped region 140 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the first heavily doped region 140 may be 1x10¹⁵ ~ 2x10²⁰ cm⁻³. In one example, the first heavily doped region 140 may be electrically connected to at least one of an external power supply, a DC-to-DC converter, and other power management integrated circuits. In one example, the first heavily doped region 140 may be electrically connected to at least one of a quenching resistor (or quenching circuit) and other pixel circuits. A quenching resistor or quenching circuitry may be configured to stop the avalanche effect and allow the single photon avalanche diode (SPAD) 1100 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1100 or receive signals from the single-photon avalanche diode (SPAD) 1100.

The first lightly doped region 141 may be configured to form a depletion region 106. The size of the depletion region 106 is shown as an example and is not limited. When reverse bias is applied to the single-photon avalanche diode (SPAD) 1100, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The first lightly doped region 141 may be configured to reduce or prevent a single-channel effect that occurs as the size of the semiconductor device decreases. For example, the single-channel effect may be that an electric current flows through the single-photon Avalanche diode 1100 even though no photons are incident. The first lightly doped region 141 may be provided between the first heavily doped region 140 and the first well 120. The first lightly doped region 141 may contact the upper and side surfaces of the first heavily doped region 140. The first lightly doped region 141 may be exposed on the front side 100a. On the front side 100a, the first lightly doped region 141 may surround the first heavily doped region 140. The conductivity type of the first lightly doped region 141 may be n-type. The first lightly doped region 141 may have a lower doping concentration than the first heavily doped region 140. For example, the doping concentration of the first lightly doped region 141 may be 1x10¹⁵ ~ 1x10¹⁹ cm⁻³.

The first guard ring 142 may be provided on the side of the first lightly doped region 141. The first guard ring 142 may surround the first lightly doped region 141. For example, the first guard ring 142 may have a ring shape extending along the side of the first lightly doped region 141. The first guard ring 142 may be in direct contact with the first lightly doped region 141. In another example, the first guard ring 142 may be spaced apart from the first lightly doped region 141. The first guard ring 142 may be exposed on the front side 100a. On the front side 100a, the first guard ring 142 may surround the first lightly doped region 141. The first guard ring 142 may be extended along a direction from the front side 100a to the back side 100b. The distance between the first guard ring 142 and the back side 100b may be less than the distance between the first lightly doped region 141 and the back side 100b. The first guard ring 142 may be spaced apart from the buried region 110 by the first well 120. The conductivity type of the first guard ring 142 may be n-type. The doping concentration of the first guard ring 142 may be lower than the doping concentration of the first lightly doped region 141. For example, the doping concentration of the first guard ring 142 may be 1x10¹⁵ ~ 5x10¹⁷ cm⁻³. The first guard ring 142 may improve breakdown characteristics of the single-photon avalanche diode (SPAD) 1100. Specifically, the first guard ring 142 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

The first contact 121 may be provided on the side of the first guard ring 142. The first contact 121 may be provided on the opposite side of the first lightly doped region 141 with the first guard ring 142 interposed therebetween. The first contact 121 may be exposed on the front side 100a. On the front side 100a, the first contact 121 may surround the first guard ring 142. In another example, a plurality of first contacts 121 may be provided. In this case, the plurality of contacts may each be electrically connected to a circuitry outside the single-photon avalanche diode (SPAD) 1100. The conductivity type of the first contact 121 may be a p-type. The doping concentration of the first contact 121 may be higher than the doping concentration of the first well 120. For example, the doping concentration of the first contact 121 may be 1x10¹⁵ ~ 2x10²⁰ cm⁻³. In one example, the first contact 121 may be electrically connected to at least one of an external power supply, a DC-to-DC converter, and other power management integrated circuits. In one example, the first contact 121 may be electrically connected to at least one of a quenching resistor (or quenching circuit) and other pixel circuits.

The first relief region 122 may be provided between the first contact 121 and the first well 120. The first relief region 122 may be electrically connected to the first contact 121 and the first well 120. The first relief region 122 may relieve the difference between the first contact 121 and the first well 120. The first relief region 122 may be extended along the first contact 121. The first relief region 122 may be provided on the side and top surfaces of the first contact 121. For example, the first relief region 122 may be in direct contact with the side and top surfaces of the first contact 121. The top and one side surfaces of the first relief region 122 may contact the first well 120. The other side surface of the first relief region 122 is exposed by the first well 120 and may contact the buried region 110. The first relief region 122 may be exposed on the front side 100a. On the front side 100a, the first relief region 122 may surround the first guard ring 142. The first relief region 122 may be spaced apart from the first guard ring 142. The first well 120 may extend between the first relief region 122 and the first guard ring 142. For example, a region between the first relief region 122 and the first guard ring 142 may be filled with the first well 120. Between the first relief region 122 and the first guard ring 142, the first well 120 may be exposed on the front side 100a. In one example, the first well 120 may not be provided in a region adjacent to the front side 100a. For example, a region adjacent to the front side 100a between the first relief region 122 and the first guard ring 142 may be filled with the substrate region 102. Between the first relief region 122 and the first guard ring 142, the substrate region 102 may be exposed on the front side 100a. The conductivity type of the first relief region 122 may be a p-type. The doping concentration of the first relief region 122 may be lower than the doping concentration of the first contact 121 and may be similar to or higher than the doping concentration of the first well 120. For example, the doping concentration of the first relief region 122 may be 1x10¹⁵ ~ 5x10¹⁷ cm⁻³.

Unlike the single-photon avalanche diode 1000 described with reference to FIGS. 1 and 2, the single-photon avalanche diode 1100 may further include a second well 123 and a second lightly doped region 124. The second well 123 may be provided between the first lightly doped region 141 and the first well 120. The second well 123 may be in contact with the first well 120. The second well 123 may be provided in an inner region of the first guard ring 142 having a ring shape. From the perspective looking at the front side 100a, the second well 123 may be surrounded by the first guard ring 142. The conductivity type of the second well 123 may be p-type. For example, the doping concentration of the second well 123 may be 1x10¹⁵ to 5x10¹⁷ cm⁻³. The second well 123 may strengthen the avalanche effect by increasing the electric field in the depletion region. The second well 123 may allow electrons or holes in the first well 120 to better move to the first heavily doped region 140.

The second lightly doped region 124 may be provided between the second well 123 and the first lightly doped region 141. The second lightly doped region 124 may contact the second well 123 and the first lightly doped region 141. The second lightly doped region 124 may be provided in an inner region of the first guard ring 142 having a ring shape. From the perspective of looking at the front side 100a, the second lightly doped region 124 may be surrounded by the first guard ring 142. The conductivity type of the second lightly doped region 124 may be p-type. The second lightly doped region 124 may have a doping concentration lower than that of the first contact 121. For example, the doping concentration of the second lightly doping region 124 may be 1x10¹⁵ to 1x10¹⁸ cm⁻³.

By forming a PN junction using the first lightly doped region 141 and the second lightly doped region 142, the tunneling noise and trap-assisted tunneling noise of the single-photon avalanche diode 1100 may be reduced, and a single-photon avalanche diode 1100 operating in a wide wavelength band may be provided.

The device isolation pattern 104 may be provided on the side surface of the first relief region 122. The device isolation pattern 104 may be exposed on the front side 100a. On the front side 100a, the device isolation pattern 104 may surround the first relief region 122. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1100 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the first relief region 122 and the substrate region 102 as well as the buried region 110. In another example, the device isolation pattern 104 may be formed to contact the first contact 121. In another example, the single-photon avalanche diode (SPAD) 1100 may not include a device isolation pattern 104. Each region may have a conductivity type opposite to the conductivity type described above. For example, regions described as having n-type may have a p-type, and regions described as having p-type may have n-type.

The present disclosure uses the first lightly doped region 141 and the second lightly doped region 124 to form a PN junction, so that tunneling noise characteristics and trap-assisted tunneling noise characteristics are improved, and a single-photon avalanche diode (SPAD) 1100 operating in a wide wavelength band is provided.

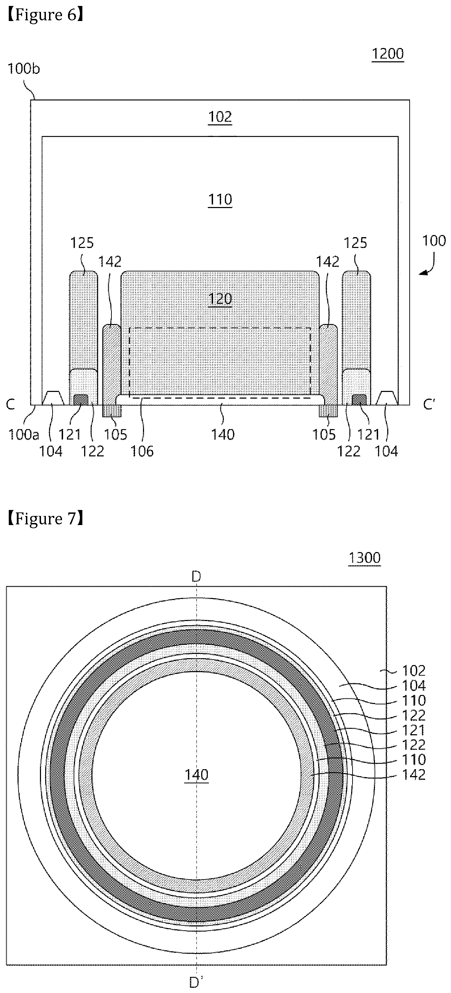

FIG. 5 is a plan view of a single-photon avalanche diode (SPAD) according to example embodiments. FIG. 6 is a cross-sectional view of the single-photon avalanche diode (SPAD) of FIG. 5 taken along line C-C'.

Referring to FIGS. 5 and 6, a single-photon avalanche diode (SPAD) 1200 may be provided. The single-photon avalanche diode (SPAD) 1200 may be referred to as a Geiger-mode Avalanche diode (Geiger-mode APD, G-APD). The single-photon avalanche diode (SPAD) 1200 may include a buried region 110, a first well 120, a first heavily doped region 140, a first guard ring 142, a first contact 121, a first relief region 122, an additional relief region 125, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the first well 120, the first heavily doped region 140, the first guard ring 142, the first contact 121, the first relief region 122, and the additional relief region 125 may be formed by implanting impurities into the semiconductor substrate 100. In the semiconductor substrate 100, the buried region 110, the first well 120, the first heavily doped region 140, the first guard ring 142, the first contact 121, the first relief region 122, and the additional relief region 125 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm⁻³. In one example, the buried region 110 may have a uniform doping concentration. In one example, the doping concentration of the buried region 110 may be smaller as it is closer to the front side 100a.

The first well 120 may be provided in the semiconductor substrate 100. The buried region 110 may be disposed between the first well 120 and the back side 100b. The upper and side surfaces of the first well 120 may be in direct contact with the buried region 110. The conductivity type of the first well 120 may be p-type. For example, the doping concentration of the first well 120 may be 1x10¹⁵ ~ 1x10¹⁸ cm⁻³. In one example, the first well 120 may have a uniform doping concentration. In one example, the doping concentration of the first well 120 may be smaller as it is closer to the front side 100a of the single-photon avalanche diode (SPAD) 1100.

The first heavily doped region 140 may be configured to form a depletion region 106. The size of the depletion region 106 is shown as an example and is not limited. When reverse bias is applied to the single-photon avalanche diode (SPAD) 1200, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The first heavily doped region 140 may be exposed on the front side 100a. The first heavily doped region 140 may be provided between the first well 120 and the front side 100a. The first heavily doped region 140 and the first well 120 may be arranged along a direction from the front side 100a to the back side 100b. The width of the first heavily doped region 140 may be larger than the width of the first well 120. The widths may be sized along a direction parallel to the front side 100a. As the first well 120 is configured to have a smaller width than the first heavily doped region 140, the electric field may be formed to have a large magnitude in a region adjacent to the interface between the first well 120 and the first heavily doped region 140. Accordingly, the premature breakdown phenomenon due to unintended electric field concentration is prevented, and the operational stability of the single-photon avalanche diode 1200 may be improved. For example, the single-photon avalanche diode 1200 may operate stably even if it does not include the guard ring 142 described in other embodiments.

The first heavily doped region 140 may protrude from the side surface of the first well 120. The conductivity type of the first heavily doped region 140 may be n-type. The first heavily doped region 140 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the first heavily doped region 140 may be 1x10¹⁵ ~ 2x10²⁰ cm⁻³. In one example, the first heavily doped region 140 may be electrically connected to at least one of an external power supply, a DC-to-DC converter, and other power management integrated circuits. In one example, the first heavily doped region 140 may be electrically connected to at least one of a quenching resistor (or quenching circuit) and other pixel circuits. A quenching resistor or quenching circuitry may be configured to stop the avalanche effect and allow the single photon avalanche diode (SPAD) 1200 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1200 or receive signals from the single-photon avalanche diode (SPAD) 1200.

The first guard ring 142 may be provided on the sides of the first well 120 and the first heavily doped region 140. The first guard ring 142 may surround the first well 120 and the first heavily doped region 140. For example, the first guard ring 142 may have a ring shape extending along the side of the first well 120 and the first heavily doped region 140. The first guard ring 142 may be in direct contact with the first well 120 and the first heavily doped region 140. In another example, the first guard ring 142 may be spaced apart from the first well 120 and the first heavily doped region 140. The first guard ring 142 may be exposed on the front side 100a. On the front side 100a, the first guard ring 142 may surround the first lightly doped region 141. The first guard ring 142 may be extended along a direction from the front side 100a to the back side 100b. The distance between the first guard ring 142 and the back side 100b may be less than the distance between the first heavily doped region 140 and the back side 100b. The distance between the first guard ring 142 and the back side 100b may be greater than the distance between the first well 120 and the back side 100b. The first guard ring 142 may contact the buried region 110. The conductivity type of the first guard ring 142 may be n-type. The doping concentration of the first guard ring 142 may be lower than the doping concentration of the first heavily doped region 140. For example, the doping concentration of the first guard ring 142 may be 1x10¹⁵ ~ 5x10¹⁷ cm⁻³. The first guard ring 142 may improve breakdown characteristics of the single-photon avalanche diode (SPAD) 1200. Specifically, the first guard ring 142 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

A polysilicon pattern 105 may be provided on the front side 100a. The polysilicon pattern 105 may overlap the first guard ring 142 along a direction from the front side 100a to the back side 100b. The polysilicon pattern 105 may be in direct contact with the first guard ring 142. As the polysilicon pattern 105 is formed on the first guard ring 142, the characteristics of preventing premature breakdown of the first guard ring 142 may be improved. In one embodiment, a voltage may be applied to the polysilicon pattern 105 as needed to improve the characteristics of preventing premature breakdown of the first guard ring 142. For example, a required constant voltage, AC voltage, or pulsed DC voltage may be applied to the polysilicon pattern 105. In one embodiment, the polysilicon pattern 105 may be electrically connected to the anode or cathode of the single-photon avalanche diode 1200 to apply a voltage. For example, the polysilicon pattern 105 may be electrically connected to the heavily doped region 140 or the first contact 121. The configuration in which the polysilicon pattern 105 is provided on the first guard ring 142 may be provided not only in this embodiment, but also on other guard rings described herein or near the corners of the depletion region.

The first contact 121 may be provided on the side of the first guard ring 142. The first contact 121 may be provided on the opposite side of the first heavily doped region 140 with the first guard ring 142 interposed therebetween. The first contact 121 may be exposed on the front side 100a. On the front side 100a, the first contact 121 may surround the first guard ring 142. In another example, a plurality of first contacts 121 may be provided. In this case, the plurality of contacts may each be electrically connected to a circuitry outside the single-photon avalanche diode (SPAD) 1200. The conductivity type of the first contact 121 may be a p-type. The doping concentration of the first contact 121 may be higher than the doping concentration of the first well 120. For example, the doping concentration of the first contact 121 may be 1x10¹⁵ ~ 2x10²⁰ cm⁻³. In one example, the first contact 121 may be electrically connected to at least one of an external power supply, a DC-to-DC converter, and other power management integrated circuits. In one example, the first contact 121 may be electrically connected to at least one of a quenching resistor (or quenching circuit) and other pixel circuits.

The first relief region 122 may be provided between the first contact 121 and the buried region 110. The first relief region 122 may be electrically connected to the first contact 121 and the buried region 110. The first relief region 122 may relieve the difference between the first contact 121 and the buried region 110. The first relief region 122 may be extended along the first contact 121. The first relief region 122 may be provided on the side and top surfaces of the first contact 121. For example, the first relief region 122 may be in direct contact with the side and top surfaces of the first contact 121. The top and side surfaces of the first relief region 122 may contact the buried region 110. The first relief region 122 may be exposed on the front side 100a. On the front side 100a, the first relief region 122 may surround the first guard ring 142. The first relief region 122 may be spaced apart from the first guard ring 142. The buried region 110 may extend between the first relief region 122 and the first guard ring 142. For example, a region between the first relief region 122 and the first guard ring 142 may be filled with the buried region 110. Between the first relief region 122 and the first guard ring 142, the buried region 110 may be exposed on the front side 100a. In one example, the first well 120 may not be provided in a region adjacent to the front side 100a. For example, a region adjacent to the front side 100a between the first relief region 122 and the first guard ring 142 may be filled with the substrate region 102. Between the first relief region 122 and the first guard ring 142, the substrate region 102 may be exposed on the front side 100a. The conductivity type of the first relief region 122 may be a p-type. The doping concentration of the first relief region 122 may be lower than the doping concentration of the first contact 121 and may be similar to or higher than the doping concentration of the first well 120. For example, the doping concentration of the first relief region 122 may be 1x10¹⁵ ~ 5x10¹⁷ cm⁻³.

Additional relief region 125 may be provided on the top surface of relief region 122. Additional relief region 125 may be in direct contact with relief region 122. The side surfaces of the additional relief region 125 may be aligned with the side surfaces of the relief region 122. The additional relief region 125 may extend along a direction from the front side 100a to the back side 100b. The distance between the additional relief region 125 and the back side 100b may be smaller than the distance between the first guard ring 142 and the back side 100b. The conductivity type of the additional relief region 125 may be p-type. For example, the doping concentration of the additional relief region 125 may be 1x10¹⁵ to 1x10¹⁸ cm⁻³. The additional relief region 125 and the first relief region 122 may improve the electrical connection characteristics of the first contact 121 and the buried region 110. For example, additional relief region 125 and first relief region 122 may be configured to reduce or prevent voltage drop when a voltage is applied to buried region 110 through first contact 121. The additional relief region 125 and the first relief region 122 may be configured to uniformly apply voltage to the buried region 110.

The device isolation pattern 104 may be provided on the side surface of the first relief region 122. The device isolation pattern 104 may be exposed on the front side 100a. On the front side 100a, the device isolation pattern 104 may surround the first relief region 122. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1200 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the first relief region 122 and the substrate region 102 as well as the buried region 110. In another example, the device isolation pattern 104 may be formed to contact the first contact 121. In another example, the single-photon avalanche diode (SPAD) 1200 may not include a device isolation pattern 104. Each region may have a conductivity type opposite to the conductivity type described above. For example, regions described as having n-type may have a p-type, and regions described as having p-type may have n-type.

In one embodiment, the first lightly doped region 141 described with reference to FIGS. 1 and 2 may be further provided between the first heavily doped region 140 and the first well 120. Accordingly, the single-photon avalanche diode 1200 may have improved tunneling noise characteristics and trap-assisted tunneling noise characteristics. The single-photon avalanche diode 1200 may be operated in a wide wavelength band.

The present disclosure may provide a single-photon avalanche diode 1200 with improved operational stability.

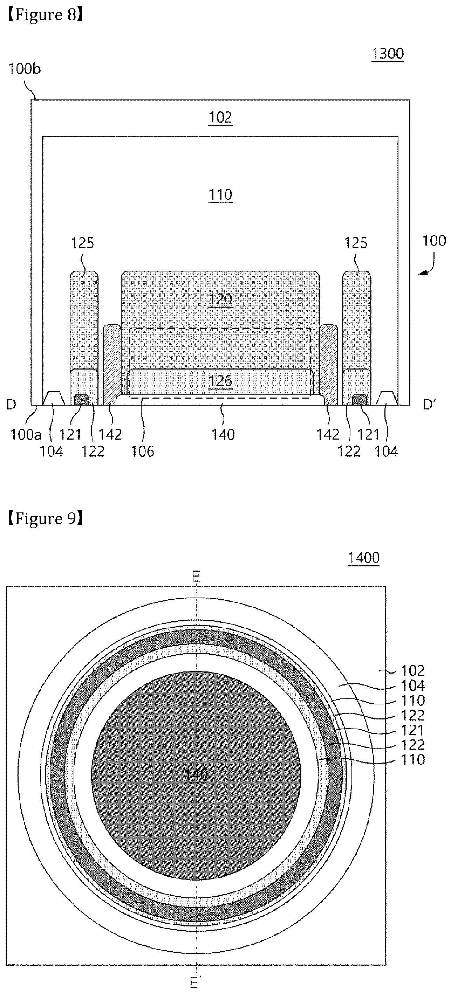

FIG. 7 is a plan view of a single-photon avalanche diode (SPAD) according to example embodiments. FIG. 8 is a cross-sectional view of the single-photon avalanche diode (SPAD) of FIG. 7 taken along line D-D'.

Referring to FIGS. 7 and 8, a single-photon avalanche diode (SPAD) 1300 may be provided. The single-photon avalanche diode (SPAD) 1300 may be referred to as a Geiger-mode Avalanche diode (Geiger-mode APD, G-APD). The single-photon avalanche diode (SPAD) 1300 may include a buried region 110, a first well 120, a first heavily doped region 140, a first guard ring 142, a first contact 121, a first relief region 122, an additional relief region 125, a third well 126, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the first well 120, the first heavily doped region 140, the first guard ring 142, the first contact 121, the first relief region 122, the additional relief region 125, and the third well 126 may be formed by implanting impurities into the semiconductor substrate 100. In the semiconductor substrate 100, the buried region 110, the first well 120, the first heavily doped region 140, the first guard ring 142, the first contact 121, the first relief region 122, the additional relief region 125, and the third well 126 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The first well 120 may be provided in the semiconductor substrate 100. The buried region 110 may be disposed between the first well 120 and the back side 100b. The upper and side surfaces of the first well 120 may be in direct contact with the buried region 110. The conductivity type of the first well 120 may be p-type. For example, the doping concentration of the first well 120 may be 1x10¹⁵ ~ 1x10¹⁸ cm⁻³. In one example, the first well 120 may have a uniform doping concentration. In one example, the doping concentration of the first well 120 may be smaller as it is closer to the front side 100a of the single-photon avalanche diode (SPAD) 1100.

The first heavily doped region 140 may be configured to form a depletion region 106. The size of the depletion region 106 is shown as an example and is not limited. When reverse bias is applied to the single-photon avalanche diode (SPAD) 1300, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The first heavily doped region 140 may be exposed on the front side 100a. The first heavily doped region 140 may be provided between the first well 120 and the front side 100a. The first heavily doped region 140 and the first well 120 may be arranged along a direction from the front side 100a to the back side 100b. The width of the first heavily doped region 140 may be larger than the width of the first well 120. The widths may be sized along a direction parallel to the front side 100a.

The first heavily doped region 140 may protrude from the side surface of the first well 120. The conductivity type of the first heavily doped region 140 may be n-type. The first heavily doped region 140 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the first heavily doped region 140 may be 1x10¹⁵ ~ 2x10²⁰ cm⁻³. In one example, the first heavily doped region 140 may be electrically connected to at least one of an external power supply, a DC-to-DC converter, and other power management integrated circuits. In one example, the first heavily doped region 140 may be electrically connected to at least one of a quenching resistor (or quenching circuit) and other pixel circuits. A quenching resistor or quenching circuitry may be configured to stop the avalanche effect and allow the single photon avalanche diode (SPAD) 1300 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1300 or receive signals from the single-photon avalanche diode (SPAD) 1300.

The first guard ring 142 may be provided on the sides of the first well 120 and the first heavily doped region 140. The first guard ring 142 may surround the first well 120 and the first heavily doped region 140. For example, the first guard ring 142 may have a ring shape extending along the side of the first well 120 and the first heavily doped region 140. The first guard ring 142 may be in direct contact with the first well 120 and the first heavily doped region 140. In another example, the first guard ring 142 may be spaced apart from the first well 120 and the first heavily doped region 140. The first guard ring 142 may be exposed on the front side 100a. On the front side 100a, the first guard ring 142 may surround the first lightly doped region 141. The first guard ring 142 may be extended along a direction from the front side 100a to the back side 100b. The distance between the first guard ring 142 and the back side 100b may be less than the distance between the third well 126 and the back side 100b. The first guard ring 142 may contact the buried region 110. The conductivity type of the first guard ring 142 may be n-type. The doping concentration of the first guard ring 142 may be lower than the doping concentration of the first heavily doped region 140. For example, the doping concentration of the first guard ring 142 may be 1x10¹⁵ ~ 5x10¹⁷ cm⁻³. The first guard ring 142 may improve breakdown characteristics of the single-photon avalanche diode (SPAD) 1300. Specifically, the first guard ring 142 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

The first contact 121 may be provided on the side of the first guard ring 142. The first contact 121 may be provided on the opposite side of the first heavily doped region 140 with the first guard ring 142 interposed therebetween. The first contact 121 may be exposed on the front side 100a. On the front side 100a, the first contact 121 may surround the first guard ring 142. In another example, a plurality of first contacts 121 may be provided. In this case, the plurality of contacts may each be electrically connected to a circuitry outside the single-photon avalanche diode (SPAD) 1300. The conductivity type of the first contact 121 may be a p-type. The doping concentration of the first contact 121 may be higher than the doping concentration of the first well 120. For example, the doping concentration of the first contact 121 may be 1x10¹⁵ ~ 2x10²⁰ cm⁻³. In one example, the first contact 121 may be electrically connected to at least one of an external power supply, a DC-to-DC converter, and other power management integrated circuits. In one example, the first contact 121 may be electrically connected to at least one of a quenching resistor (or quenching circuit) and other pixel circuits.

The first relief region 122 may be provided between the first contact 121 and the buried region 110. The first relief region 122 may be electrically connected to the first contact 121 and the buried region 110. The first relief region 122 may relieve the difference between the first contact 121 and the buried region 110. The first relief region 122 may be extended along the first contact 121. The first relief region 122 may be provided on the side and top surfaces of the first contact 121. For example, the first relief region 122 may be in direct contact with the side and top surfaces of the first contact 121. The top and side surfaces of the first relief region 122 may contact the buried region 110. The first relief region 122 may be exposed on the front side 100a. On the front side 100a, the first relief region 122 may surround the first guard ring 142. The first relief region 122 may be spaced apart from the first guard ring 142. The buried region 110 may extend between the first relief region 122 and the first guard ring 142. For example, a region between the first relief region 122 and the first guard ring 142 may be filled with the buried region 110. Between the first relief region 122 and the first guard ring 142, the buried region 110 may be exposed on the front side 100a. In one example, the first well 120 may not be provided in a region adjacent to the front side 100a. For example, a region adjacent to the front side 100a between the first relief region 122 and the first guard ring 142 may be filled with the substrate region 102. Between the first relief region 122 and the first guard ring 142, the substrate region 102 may be exposed on the front side 100a. The conductivity type of the first relief region 122 may be a p-type. The doping concentration of the first relief region 122 may be lower than the doping concentration of the first contact 121 and may be similar to or higher than the doping concentration of the first well 120. For example, the doping concentration of the first relief region 122 may be 1x10¹⁵ ~ 5x10¹⁷ cm⁻³.

The third well 126 may be provided between the first heavily doped region 140 and the first well 120. The third well 126 may be in direct contact the first heavily doped region 140 and the first well 120. The third well 126 may be disposed on the top surface of the first heavily doped region 140. The conductivity type of the third well 126 may be p-type. For example, the doping concentration of the third well 126 may be 1x10¹⁵ to 5x10¹⁷ cm⁻³. The third well 126 may have a smaller width than the first heavily doped region 140. The width may be a size along a direction parallel to the front side 100a. As the third well 126 has a smaller width than the first heavily doped region 140, an electric field with a large magnitude is generated in a region adjacent to the interface between the third well 126 and the first heavily doped region 140 (i.e., a region adjacent to the PN junction surface). Accordingly, a premature breakdown phenomenon due to unintended electric field concentration may be prevented, and the operational stability of the single-photon avalanche diode 1300 may be improved.

Additional relief region 125 may be provided on the top surface of relief region 122. Additional relief region 125 may be in direct contact with relief region 122. The side surfaces of the additional relief region 125 may be aligned with the side surfaces of the relief region 122. The additional relief region 125 may extend along a direction from the front side 100a to the back side 100b. The distance between the additional relief region 125 and the back side 100b may be smaller than the distance between the first guard ring 142 and the back side 100b. The conductivity type of the additional relief region 125 may be p-type. For example, the doping concentration of the additional relief region 125 may be 1x10¹⁵ to 1x10¹⁸ cm⁻³. The additional relief region 125 and the first relief region 122 may improve the electrical connection characteristics of the first contact 121 and the buried region 110. For example, additional relief region 125 and first relief region 122 may be configured to reduce or prevent voltage drop when a voltage is applied to buried region 110 through first contact 121. The additional relief region 125 and the first relief region 122 may be configured to uniformly apply voltage to the buried region 110.

The device isolation pattern 104 may be provided on the side surface of the first relief region 122. The device isolation pattern 104 may be exposed on the front side 100a. On the front side 100a, the device isolation pattern 104 may surround the first relief region 122. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1300 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the first relief region 122 and the substrate region 102 as well as the buried region 110. In another example, the device isolation pattern 104 may be formed to contact the first contact 121. In another example, the single-photon avalanche diode (SPAD) 1300 may not include a device isolation pattern 104. Each region may have a conductivity type opposite to the conductivity type described above. For example, regions described as having n-type may have a p-type, and regions described as having p-type may have n-type.

In one embodiment, the first lightly doped region 141 described with reference to FIGS. 1 and 2 may be further provided between the first heavily doped region 140 and the third well 126. Accordingly, the single-photon avalanche diode 1300 may have improved tunneling noise characteristics and trap-assisted tunneling noise characteristics. The single-photon avalanche diode 1300 may be operated in a wide wavelength band.

The present disclosure may provide a single-photon avalanche diode 1300 in which the third well 126 is configured to have a width smaller than the first heavily doped region 140. An electric field with high magnitude may be formed in a region adjacent to the interface between the third well 126 and the first heavily doped region 140 of the single-photon avalanche diode 1300 (i.e., a region adjacent to the PN junction surface). Accordingly, a single-photon avalanche diode 1300 may be provided in which premature breakdown due to unintended electric field concentration is prevented and operational stability is improved.

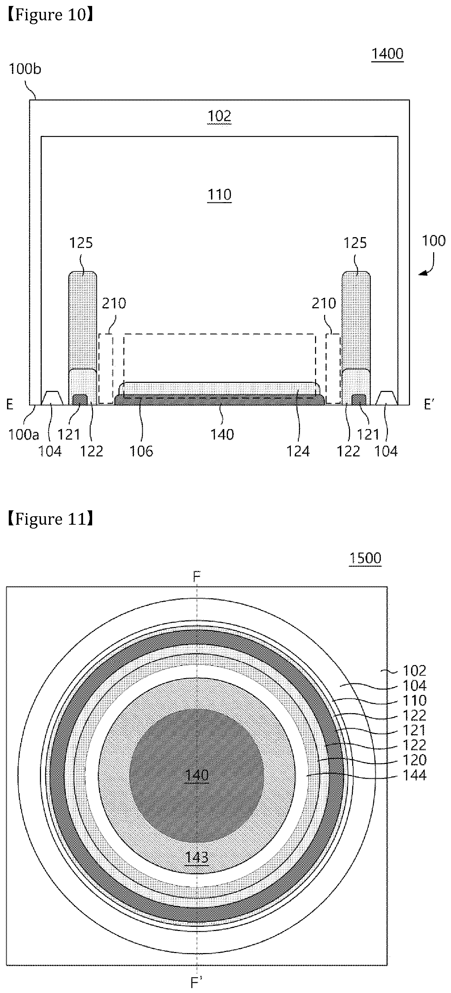

FIG. 9 is a plan view of a single-photon avalanche diode (SPAD) according to example embodiments. FIG. 10 is a cross-sectional view of the single-photon avalanche diode (SPAD) of FIG. 9 taken along line E-E'.

Referring to FIGS. 9 and 10, a single-photon avalanche diode (SPAD) 1400 may be provided. The single-photon avalanche diode (SPAD) 1400 may be referred to as a Geiger-mode Avalanche diode (Geiger-mode APD, G-APD). The single-photon avalanche diode (SPAD) 1400 may include a buried region 110, a first heavily doped region 140, a second lightly doped region 124, a first contact 121, a first relief region 122, an additional relief region 125, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the first heavily doped region 140, the second lightly doped region 124, the first contact 121, the first relief region 122, and the additional relief region 125 may be formed by implanting impurities into the semiconductor substrate 100. In the semiconductor substrate 100, the buried region 110, the first heavily doped region 140, the second lightly doped region 124, the first contact 121, the first relief region 122, and the additional relief region 125 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the doping concentration of the buried region 110 may be smaller as it is closer to the front side 100a.

The first heavily doped region 140 may be configured to form a depletion region 106. The size of the depletion region 106 is shown as an example and is not limited. When reverse bias is applied to the single-photon avalanche diode (SPAD) 1400, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The first heavily doped region 140 may be exposed on the front side 100a.

The conductivity type of the first heavily doped region 140 may be n-type. The first heavily doped region 140 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the first heavily doped region 140 may be 1x10¹⁵ ~ 2x10²⁰ cm⁻³. In one example, the first heavily doped region 140 may be electrically connected to at least one of an external power supply, a DC-to-DC converter, and other power management integrated circuits. In one example, the first heavily doped region 140 may be electrically connected to at least one of a quenching resistor (or quenching circuit) and other pixel circuits. A quenching resistor or quenching circuitry may be configured to stop the avalanche effect and allow the single photon avalanche diode (SPAD) 1400 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1400 or receive signals from the single-photon avalanche diode (SPAD) 1400.

The second lightly doped region 124 may be configured to form a depletion region 106. The second lightly doped region 124 may be provided between the first heavily doped region 140 and the buried region 110. The second lightly doped region 124 may be in contact with the first heavily doped region 140 and the buried region 110. The second lightly doped region 124 may be disposed on the top surface of the first heavily doped region 140. The second lightly doped region 124 may have a smaller width than the first heavily doped region 140. The width may be a size along a direction parallel to the front side 100a. As the second lightly doped region 124 has a smaller width than the first heavily doped region 140, an electric field with a large magnitude is generated in a region adjacent to the interface between the second lightly doped region 124 and the first heavily doped region 140 (i.e., a region adjacent to the PN junction surface). Accordingly, a premature breakdown phenomenon due to unintended electric field concentration may be prevented, and the operational stability of the single-photon avalanche diode 1300 may be improved. The conductivity type of the second lightly doped region 124 may be p-type. For example, the doping concentration of the second lightly doped region 124 may be 1x10¹⁵ to 1x10¹⁸ cm⁻³.

The first contact 121 may be provided on the side surfaces of the first heavily doped region 140 and the second lightly doped region 124. The first contact 121 may be exposed on the front side 100a. On the front side 100a, the first contact 121 may surround the first heavily doped region 140 and the second lightly doped region 124. In another example, a plurality of first contacts 121 may be provided. In this case, the plurality of contacts may each be electrically connected to a circuitry outside the single-photon avalanche diode (SPAD) 1400. The conductivity type of the first contact 121 may be a p-type. The doping concentration of the first contact 121 may be higher than the doping concentration of the buried region 110. For example, the doping concentration of the first contact 121 may be 1x10¹⁵ ~ 2x10²⁰ cm⁻³. In one example, the first contact 121 may be electrically connected to at least one of an external power supply, a DC-to-DC converter, and other power management integrated circuits. In one example, the first contact 121 may be electrically connected to at least one of a quenching resistor (or quenching circuit) and other pixel circuits.

The first relief region 122 may be provided between the first contact 121 and the buried region 110. The first relief region 122 may be electrically connected to the first contact 121 and the buried region 110. The first relief region 122 may relieve the difference between the first contact 121 and the buried region 110. The first relief region 122 may be extended along the first contact 121. The first relief region 122 may be provided on the side and top surfaces of the first contact 121. For example, the first relief region 122 may be in direct contact with the side and top surfaces of the first contact 121. The top and side surfaces of the first relief region 122 may contact the buried region 110. The first relief region 122 may be exposed on the front side 100a. On the front side 100a, the first relief region 122 may surround the first heavily doped region 140 and the second lightly doped region 124. The first relief region 122 may be spaced apart from the first first heavily doped region 140 and the second lightly doped region 124. The buried region 110 may extend between the first relief region 122 and the first heavily doped region 140. For example, a region between the first relief region 122 and the first heavily doped region 140 and a region between the first relief region 122 and the second lightly doped region 124 may be filled with the buried region 110. Between the first relief region 122 and the first heavily doped region 140, the buried region 110 may be exposed on the front side 100a. In one example, the buried region 110 may not be provided in a region adjacent to the front side 100a. For example, a region adjacent to the front side 100a between the first relief region 122 and the first heavily doped region 140 and between the first relief region 122 and the second lightly doped region 124 may be filled with the substrate region 102. Between the first relief region 122 and the first heavily doped region 140, the substrate region 102 may be exposed on the front side 100a. The conductivity type of the first relief region 122 may be a p-type. The doping concentration of the first relief region 122 may be lower than the doping concentration of the first contact 121. For example, the doping concentration of the first relief region 122 may be 1x10¹⁵ ~ 5x10¹⁷ cm⁻³.

Additional relief region 125 may be provided on the top surface of relief region 122. Additional relief region 125 may be in direct contact with relief region 122. The side surfaces of the additional relief region 125 may be aligned with the side surfaces of the relief region 122. The additional relief region 125 may extend along a direction from the front side 100a to the back side 100b. The distance between the additional relief region 125 and the back side 100b may be smaller than the distance between the second lightly doped region 124 and the back side 100b. The conductivity type of the additional relief region 125 may be p-type. For example, the doping concentration of the additional relief region 125 may be 1x10¹⁵ to 1x10¹⁸ cm⁻³. The additional relief region 125 and the first relief region 122 may improve the electrical connection characteristics of the first contact 121 and the buried region 110. For example, additional relief region 125 and first relief region 122 may be configured to reduce or prevent voltage drop when a voltage is applied to buried region 110 through first contact 121. The additional relief region 125 and the first relief region 122 may be configured to uniformly apply voltage to the buried region 110.

A virtual guard ring 210 may be provided on the side surfaces of the first heavily doped region 140 and the second lightly doped region 124. The virtual guard ring 210 may be formed as the doping concentration of the buried region 110 decreases closer to the front side 100a. The virtual guard ring 210 may be a portion of the buried region 110 or the substrate region 102 that may serve as a guard ring for the first heavily doped region 140 and the second lightly doped region 124 due to the low doping concentration of impurities. Specifically, the virtual guard ring 210 may relieve concentration of the electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106. The breakdown characteristics of the single-photon avalanche diode 1400 may be improved by the virtual guard ring 210. The virtual guard ring 210 may surround the first heavily doped region 140, the second lightly doped region 124, and the depletion region 106. For example, the virtual guard ring 210 may have a ring shape extending along the side surfaces of the first heavily doped region 140, the second lightly doped region 124, and the depletion region 106.

The device isolation pattern 104 may be provided on the side surface of the first relief region 122. The device isolation pattern 104 may be exposed on the front side 100a. On the front side 100a, the device isolation pattern 104 may surround the first relief region 122. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1400 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the first relief region 122 and the substrate region 102 as well as the buried region 110. In another example, the device isolation pattern 104 may be formed to contact the first contact 121. In another example, the single-photon avalanche diode (SPAD) 1400 may not include a device isolation pattern 104. Each region may have a conductivity type opposite to the conductivity type described above. For example, regions described as having n-type may have a p-type, and regions described as having p-type may have n-type.

The present disclosure may use the first heavily doped region 140 and the second lightly doped region 124 to form a PN junction. A single-photon avalanche diode 1400 may be provided that has improved tunneling noise characteristics and trap-assisted tunneling noise characteristics and operates in a wide wavelength band.

The present disclosure may provide a single-photon avalanche diode 1300 in which the second lightly doped region 124 is configured to have a width smaller than the first heavily doped region 140. An electric field with high magnitude may be formed in a region adjacent to the interface between the second lightly doped region 124 and the first heavily doped region 140 of the single-photon avalanche diode 1400 (i.e., a region adjacent to the PN junction surface). Accordingly, a single-photon avalanche diode 1400 may be provided in which premature breakdown due to unintended electric field concentration is prevented and operational stability is improved.

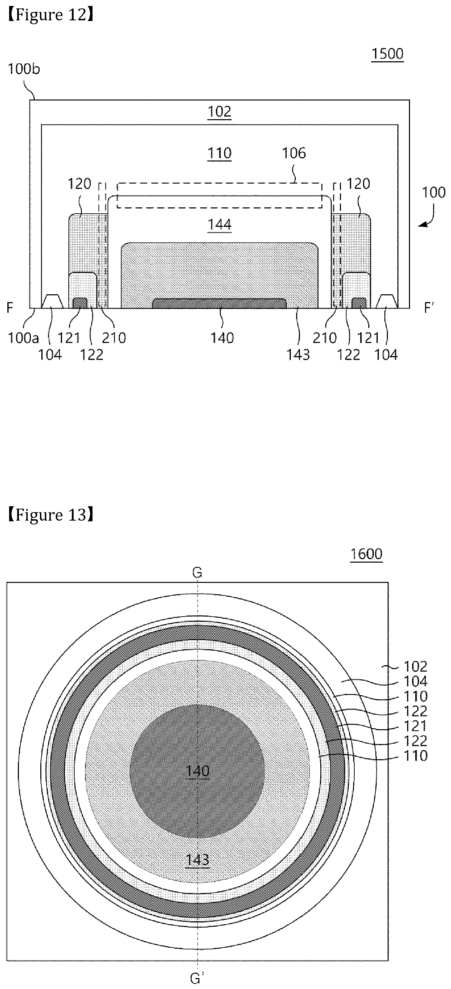

FIG. 11 is a plan view of a single-photon avalanche diode (SPAD) according to example embodiments. FIG. 12 is a cross-sectional view of the single-photon avalanche diode (SPAD) of FIG. 11 taken along line F-F'.

Referring to FIGS. 11 and 12, a single-photon avalanche diode (SPAD) 1500 may be provided. The single-photon avalanche diode (SPAD) 1500 may be referred to as a Geiger-mode Avalanche diode (Geiger-mode APD, G-APD). The single-photon avalanche diode (SPAD) 1500 may include a buried region 110, a first well 120, a first heavily doped region 140, a fourth well 143, a fifth well 144, a first contact 121, a first relief region 122, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the first well 120, the first heavily doped region 140, the fourth well 143, the fifth well 144, the first contact 121, and the first relief region 122 may be formed by implanting impurities into the semiconductor substrate 100. In the semiconductor substrate 100, the buried region 110, the first well 120, the first heavily doped region 140, the fourth well 143, the fifth well 144, the first contact 121, and the first relief region 122 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The first heavily doped region 140 may be provided between the first well 120 and the front side 100a. The first heavily doped region 140 may be exposed on the front side 100a. The conductivity type of the first heavily doped region 140 may be n-type. The first heavily doped region 140 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the first heavily doped region 140 may be 1x10¹⁵ ~ 2x10²⁰ cm⁻³. In one example, the first heavily doped region 140 may be electrically connected to at least one of an external power supply, a DC-to-DC converter, and other power management integrated circuits. In one example, the first heavily doped region 140 may be electrically connected to at least one of a quenching resistor (or quenching circuit) and other pixel circuits. A quenching resistor or quenching circuitry may be configured to stop the avalanche effect and allow the single photon avalanche diode (SPAD) 1500 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1500 or receive signals from the single-photon avalanche diode (SPAD) 1500.

The fourth well 143 may be provided between the first heavily doped region 140 and the buried region 110. The fourth well 143 may contact the top and side surfaces of the first heavily doped region 140. The fourth well 143 may be exposed on the front side 100a. On the front side 100a, the fourth well 143 may surround the first highly concentrated doped region 140. The conductivity type of the fourth well 143 may be n-type. For example, the doping concentration of the fourth well 143 may be 1x10¹⁵ to 5x10¹⁷ cm⁻³.

The fifth well 144 may be configured to form a depletion region 106. The size of the depletion region 106 is shown as an example and is not limited. When reverse bias is applied to the single-photon avalanche diode (SPAD) 1500, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The fifth well 144 may be provided between the fourth well 143 and the buried region 110. The fifth well 144 may contact the top and side surfaces of the fourth well 143. The fifth well 144 may be in contact with the buried region 110. The fifth well 144 may be exposed on the front side 100a. On the front side 100a, the fifth well 144 may surround the fourth well 143. The conductivity type of the fifth well 144 may be n-type. For example, the doping concentration of the fifth well 144 may be 1x10¹⁵ to 1x10¹⁸ cm⁻³.

The depletion region 106 may be formed at a required depth by the fourth well 143 and the fifth well 144. The depth may refer to the distance from the front side 100a along the direction from the front side 100a to the back side 100b. Depending on the depth of the depletion region 106, the detection efficiency according to the wavelength band of the single-photon avalanche diode 1500 may vary. For example, the wavelength band over which the single-photon avalanche diode 1500 has high detection efficiency may be controlled by the depth of the depletion region 106. Accordingly, the present disclosure may provide a single-photon avalanche diode 1500 with high detection efficiency for a required wavelength band.

The first well 120 may be provided on the side surface of the fifth well 144. The first well 120 may surround the side surface of the fifth well 144. For example, the first well 120 may extend along the side surface of the fifth well 144. The fifth well 144 may protrude from the top surface of the first well 120. The conductivity type of the first well 120 may be p-type. For example, the doping concentration of the first well 120 may be 1x10¹⁵ ~ 1x10¹⁸ cm⁻³. In one example, the first well 120 may have a uniform doping concentration. In one example, the doping concentration of the first well 120 may be smaller as it is closer to the front side 100a of the single-photon avalanche diode (SPAD) 1100.

The first contact 121 may be provided on the side of the fifth well 144. The first contact 121 may be provided on the opposite side of the fourth well 143 with the fifth well 144 interposed therebetween. The first contact 121 may be exposed on the front side 100a. On the front side 100a, the first contact 121 may surround the fifth well 144. In another example, a plurality of first contacts 121 may be provided. In this case, the plurality of contacts may each be electrically connected to a circuitry outside the single-photon avalanche diode (SPAD) 1500. The conductivity type of the first contact 121 may be a p-type. The doping concentration of the first contact 121 may be higher than the doping concentration of the first well 120. For example, the doping concentration of the first contact 121 may be 1x10¹⁵ ~ 2x10²⁰ cm⁻³. In one example, the first contact 121 may be electrically connected to at least one of an external power supply, a DC-to-DC converter, and other power management integrated circuits. In one example, the first contact 121 may be electrically connected to at least one of a quenching resistor (or quenching circuit) and other pixel circuits.

The first relief region 122 may be provided between the first contact 121 and the first well 120. The first relief region 122 may be electrically connected to the first contact 121 and the first well 120. The first relief region 122 may relieve the difference between the first contact 121 and the first well 120. The first relief region 122 may be extended along the first contact 121. The first relief region 122 may be provided on the side and top surfaces of the first contact 121. For example, the first relief region 122 may be in direct contact with the side and top surfaces of the first contact 121. The top and one side surfaces of the first relief region 122 may contact the first well 120. The other side surface of the first relief region 122 is exposed by the first well 120 and may contact the buried region 110. The first relief region 122 may be exposed on the front side 100a. On the front side 100a, the first relief region 122 may surround the fifth well 144. The first relief region 122 may be spaced apart from the fifth well 144. The first well 120 may extend between the first relief region 122 and the fifth well 144. For example, a region between the first relief region 122 and the fifth well 144 may be filled with the first well 120. Between the first relief region 122 and the fifth well 144, the first well 120 may be exposed on the front side 100a. In one example, the first well 120 may not be provided in a region adjacent to the front side 100a. For example, a region adjacent to the front side 100a between the first relief region 122 and the fifth well 144 may be filled with the buried region 110. Between the first relief region 122 and the fifth well 144, the buried region 110 may be exposed on the front side 100a. For example, a region adjacent to the front side 100a between the first relief region 122 and the fifth well 144 may be filled with the substrate region 102. Between the first relief region 122 and the fifth well 144, the substrate region 102 may be exposed on the front side 100a. The conductivity type of the first relief region 122 may be a p-type. The doping concentration of the first relief region 122 may be lower than the doping concentration of the first contact 121 and may be similar to or higher than the doping concentration of the first well 120. For example, the doping concentration of the first relief region 122 may be 1x10¹⁵ ~ 5x10¹⁷ cm⁻³.

A virtual guard ring 210 may be provided on the side surface of the fifth well 144. The virtual guard ring 210 may be formed as the doping concentration of the first well 120 decreases closer to the front side 100a. The virtual guard ring 210 may be a portion of the buried region 110 or the substrate region 102 that may serve as a guard ring for the fourth well 143 and the fifth well 144 due to the low doping concentration of impurities. Specifically, the virtual guard ring 210 may relieve concentration of the electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106. The breakdown characteristics of the single-photon avalanche diode 1500 may be improved by the virtual guard ring 210. The virtual guard ring 210 may surround the fourth well 143 and the fifth well 144. For example, the virtual guard ring 210 may have a ring shape extending along the side surface of the fifth well 144.

The device isolation pattern 104 may be provided on the side surface of the first relief region 122. The device isolation pattern 104 may be exposed on the front side 100a. On the front side 100a, the device isolation pattern 104 may surround the first relief region 122. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1500 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the first relief region 122 and the substrate region 102 as well as the buried region 110. In another example, the device isolation pattern 104 may be formed to contact the first contact 121. In another example, the single-photon avalanche diode (SPAD) 1500 may not include a device isolation pattern 104. Each region may have a conductivity type opposite to the conductivity type described above. For example, regions described as having n-type may have a p-type, and regions described as having p-type may have n-type.

The present disclosure may provide a single-photon avalanche diode 1500 with high detection efficiency for a required wavelength band.

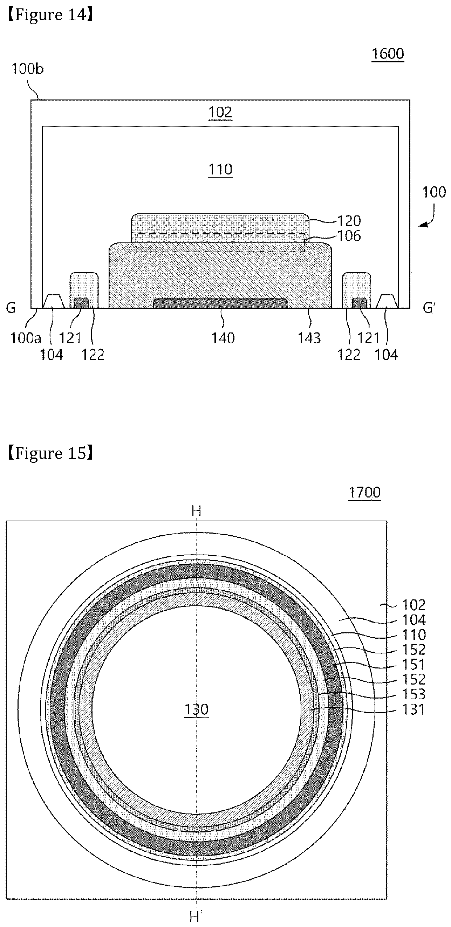

FIG. 13 is a plan view of a single-photon avalanche diode (SPAD) according to example embodiments. FIG. 14 is a cross-sectional view of the single-photon avalanche diode (SPAD) of FIG. 13 taken along line G-G'.

Referring to FIGS. 13 and 14, a single-photon avalanche diode (SPAD) 1600 may be provided. The single-photon avalanche diode (SPAD) 1600 may be referred to as a Geiger-mode Avalanche diode (Geiger-mode APD, G-APD). The single-photon avalanche diode (SPAD) 1600 may include a buried region 110, a first well 120, a first heavily doped region 140, a fourth well 143, a first contact 121, a first relief region 122, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the first well 120, the first heavily doped region 140, the fourth well 143, the first contact 121, and the first relief region 122 may be formed by implanting impurities into the semiconductor substrate 100. In the semiconductor substrate 100, the buried region 110, the first well 120, the first heavily doped region 140, the fourth well 143, the first contact 121, and the first relief region 122 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The first heavily doped region 140 may be provided between the first well 120 and the front side 100a. The first heavily doped region 140 may be exposed on the front side 100a. The conductivity type of the first heavily doped region 140 may be n-type. The first heavily doped region 140 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the first heavily doped region 140 may be 1x10¹⁵ ~ 2x10²⁰ cm⁻³. In one example, the first heavily doped region 140 may be electrically connected to at least one of an external power supply, a DC-to-DC converter, and other power management integrated circuits. In one example, the first heavily doped region 140 may be electrically connected to at least one of a quenching resistor (or quenching circuit) and other pixel circuits. A quenching resistor or quenching circuitry may be configured to stop the avalanche effect and allow the single photon avalanche diode (SPAD) 1600 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1600 or receive signals from the single-photon avalanche diode (SPAD) 1600.

The fourth well 143 may be configured to form a depletion region 106. The size of the depletion region 106 is shown as an example and is not limited. When reverse bias is applied to the single-photon avalanche diode (SPAD) 1600, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The fourth well 143 may be provided between the first heavily doped region 140 and the buried region 110. The fourth well 143 may contact the top and side surfaces of the first heavily doped region 140. The fourth well 143 may be exposed on the front side 100a. On the front side 100a, the fourth well 143 may surround the first heavily doped region 140. The conductivity type of the fourth well 144 may be n-type. For example, the doping concentration of the fourth well 143 may be 1x10¹⁵ to 5x10¹⁷ cm⁻³.

The first well 120 may be provided on the top surface of the fourth well 143. The first well 120 may be provided between the fourth well 143 and the buried region 110. The first well 120 may contact the fourth well 143 and the buried region 110. The first well 120 may have a smaller width than the fourth well 143. The conductivity type of the first well 120 may be p-type. For example, the doping concentration of the first well 120 may be 1x10¹⁵ to 1x10¹⁸ cm⁻³. As the first well 120 has a smaller width than the fourth well 143, an electric field with a large magnitude is generated in a region adjacent to the interface between the first well 120 and the fourth well 143 (i.e., a region adjacent to the PN junction surface). Accordingly, a premature breakdown phenomenon due to unintended electric field concentration may be prevented, and the operational stability of the single-photon avalanche diode 1600 may be improved. For example, the single-photon avalanche diode 1600 may operate stably even if it does not include the guard ring 142 described in other embodiments.

The first contact 121 may be provided on the side of the fourth well 143. The first contact 121 may be provided on the opposite side of the fourth well 143 with the first heavily doped region 140 interposed therebetween. The first contact 121 may be exposed on the front side 100a. On the front side 100a, the first contact 121 may surround the fourth well 143. In another example, a plurality of first contacts 121 may be provided. In this case, the plurality of contacts may each be electrically connected to a circuitry outside the single-photon avalanche diode (SPAD) 1600. The conductivity type of the first contact 121 may be a p-type. The doping concentration of the first contact 121 may be higher than the doping concentration of the first well 120. For example, the doping concentration of the first contact 121 may be 1x10¹⁵ ~ 2x10²⁰ cm⁻³. In one example, the first contact 121 may be electrically connected to at least one of an external power supply, a DC-to-DC converter, and other power management integrated circuits. In one example, the first contact 121 may be electrically connected to at least one of a quenching resistor (or quenching circuit) and other pixel circuits.

The first relief region 122 may be provided between the first contact 121 and the fourth well 143. The first relief region 122 may be electrically connected to the first contact 121 and the fourth well 143. The first relief region 122 may relieve the difference between the first contact 121 and the fourth well 143. The first relief region 122 may be extended along the first contact 121. The first relief region 122 may be provided on the side and top surfaces of the first contact 121. For example, the first relief region 122 may be in direct contact with the side and top surfaces of the first contact 121. The top and side surfaces of the first relief region 122 may contact the first well 120. The first relief region 122 may be exposed on the front side 100a. On the front side 100a, the first relief region 122 may surround the fourth well 143. The first relief region 122 may be spaced apart from the fourth well 143. The buried region 110 may extend between the first relief region 122 and the fourth well 143. For example, a region between the first relief region 122 and the fourth well 143 may be filled with the buried region 110. Between the first relief region 122 and the fourth well 143, the buried region 110 may be exposed on the front side 100a. In one example, the buried region 110 may not be provided in a region adjacent to the front side 100a. For example, a region adjacent to the front side 100a between the first relief region 122 and the fourth well 143 may be filled with the substrate region 102. Between the first relief region 122 and the fourth well 143, the substrate region 102 may be exposed on the front side 100a. The conductivity type of the first relief region 122 may be a p-type. The doping concentration of the first relief region 122 may be lower than the doping concentration of the first contact 121 and may be similar to or higher than the doping concentration of the first well 120. For example, the doping concentration of the first relief region 122 may be 1x10¹⁵ ~ 5x10¹⁷ cm-3

The device isolation pattern 104 may be provided on the side surface of the first relief region 122. The device isolation pattern 104 may be exposed on the front side 100a. On the front side 100a, the device isolation pattern 104 may surround the first relief region 122. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1600 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the first relief region 122 and the substrate region 102 as well as the buried region 110. In another example, the device isolation pattern 104 may be formed to contact the first contact 121. In another example, the single-photon avalanche diode (SPAD) 1600 may not include a device isolation pattern 104. Each region may have a conductivity type opposite to the conductivity type described above. For example, regions described as having n-type may have a p-type, and regions described as having p-type may have n-type.

The present disclosure may provide a single-photon avalanche diode 1600 with improved operational stability.

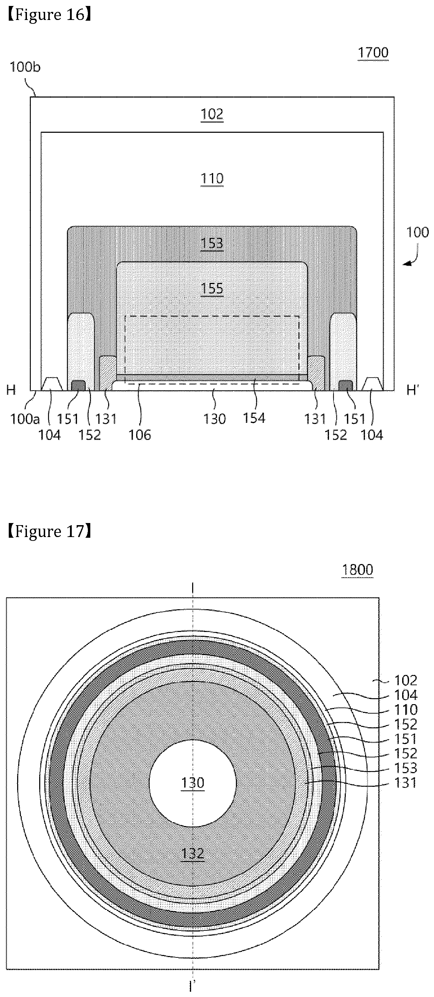

FIG. 15 is a plan view of a single-photon avalanche diode (SPAD) according to example embodiments. FIG. 16 is a cross-sectional view of the single-photon avalanche diode (SPAD) of FIG. 15 taken along line H-H'.

Referring to FIGS. 15 and 16, a single-photon avalanche diode (SPAD) 1700 may be provided. The single-photon avalanche diode (SPAD) 1700 may be referred to as a Geiger-mode Avalanche diode (Geiger-mode APD, G-APD). The single-photon avalanche diode (SPAD) 1700 may include a buried region 110, a sixth well 153, a second heavily doped region 130, a third lightly doped region 154, an eighth well 155, a second guard ring 131, a second contact 151, a second relief region 152, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the sixth well 153, the second heavily doped region 130, the third lightly doped region 154, the eighth well 155, the second guard ring 131, the second contact 151, and the second relief region 152 may be formed by implanting impurities into the semiconductor substrate 100. In the semiconductor substrate 100, the buried region 110, the sixth well 153, the second heavily doped region 130, the third lightly doped region 154, the eighth well 155, the second guard ring 131, the second contact 151, and the second relief region 152 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The sixth well 153 may be provided in the semiconductor substrate 100. The buried region 110 may be disposed between the sixth well 153 and the back side 100b. The upper and side surfaces of the sixth well 153 may be in direct contact with the buried region 110. The conductivity type of the sixth well 153 may be n-type. The sixth well 153 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the sixth well 153 may be 1x10¹⁵ ~ 1x10¹⁸ cm⁻³. In one example, the sixth well 153 may have a uniform doping concentration. In one example, the doping concentration of the sixth well 153 may be smaller as it is closer to the front side 100a of the single-photon avalanche diode (SPAD) 1100.

The second heavily doped region 130 may be configured to form a depletion region 106. The size of the depletion region 106 is shown as an example and is not limited. When reverse bias is applied to the single-photon avalanche diode (SPAD) 1700, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The second heavily doped region 130 may be provided between the sixth well 153 and the front side 100a. The second heavily doped region 130 may be exposed on the front side 100a. The conductivity type of the second heavily doped region 130 may be p-type. For example, the doping concentration of the second heavily doped region 130 may be 1x10¹⁵ ~ 2x10²⁰ cm⁻³. In one example, the second heavily doped region 130 may be electrically connected to at least one of an external power supply, a DC-to-DC converter, and other power management integrated circuits. In one example, the second heavily doped region 130 may be electrically connected to at least one of a quenching resistor (or quenching circuit) and other pixel circuits. A quenching resistor or quenching circuitry may be configured to stop the avalanche effect and allow the single photon avalanche diode (SPAD) 1700 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1700 or receive signals from the single-photon avalanche diode (SPAD) 1700.

The third lightly doped region 154 may be provided between the second heavily doped region 130 and the sixth well 153. The third lightly doped region 154 may be provided on the top surface of the second heavily doped region 130. The third lightly doped region 154 may be configured to reduce or prevent the short-channel effect that occurs as the size of the semiconductor device decreases. For example, the single-channel effect may be that current flows even though no photons are incident on the single-photon avalanche diode 1700. The conductivity type of the third lightly doped region 154 may be n-type. For example, the doping concentration of the third lightly doped region 154 may be 1x10¹⁵ to 1x10¹⁹ cm-³. In one embodiment, the third lightly doped region 154 may be configured to expand the size of the depletion region 106. For example, the third lightly doped region 154 is formed to overlap a portion of the second heavily doped region 150, so that the doping concentration of the second heavily doped region 150 overlapping the third lightly doped region 154 may be lowered. As the doping concentration of the second heavily doped region 150 decreases, the size of the depletion region 106 may be expanded. Accordingly, the tunneling noise and trap-assisted tunneling noise of the single-photon avalanche diode 1700 may be reduced. The operating wavelength of the single-photon avalanche diode 1700 may be broadened. In one embodiment, the third lightly doped region 154 may lower the breakdown voltage of the single-photon avalanche diode 1700. For example, when the third lightly doped region 154 is formed so as not to overlap the second heavily doped region 150 and has a higher doping concentration than the eighth well 155, the breakdown voltage of the single-photon avalanche diode 1700 may be lowered.

The eighth well 155 may be provided between the third lightly doped region 154 and the sixth well 153. The eighth well 155 may be provided on the top surface of the eighth well 155. The conductivity type of the eighth well 155 may be n-type. For example, the doping concentration of the eighth well 155 may be 1x10¹⁵ to 5x10¹⁷ cm⁻³.

The second guard ring 131 may be provided on the sides of the second heavily doped region 130, the third lightly doped region 154, and the eighth well 155. The second guard ring 131 may surround the second heavily doped region 130, the third lightly doped region 154, and the eighth well 155. For example, the second guard ring 131 may have a ring shape extending along the side of the second heavily doped region 130, the third lightly doped region 154, and the eighth well 155. The second guard ring 131 may be in direct contact with the second heavily doped region 130, the third lightly doped region 154, and the eighth well 155. In another example, the second guard ring 131 may be spaced apart from the second heavily doped region 130, the third lightly doped region 154, and the eighth well 155. The second guard ring 131 may be exposed on the front side 100a. On the front side 100a, the second guard ring 131 may surround the second heavily doped region 130. The second guard ring 131 may be extended along a direction from the front side 100a to the back side 100b. The distance between the second guard ring 131 and the back side 100b may be greater than the distance between the eighth well 155 and the back side 100b. The second guard ring 131 may contact the sixth well 153. The conductivity type of the second guard ring 131 may be p-type. The doping concentration of the second guard ring 131 may be lower than the doping concentration of the second heavily doped region 130. For example, the doping concentration of the second guard ring 131 may be 1x10¹⁵ ~ 5x10¹⁷ cm⁻³. The second guard ring 131 may improve breakdown characteristics of the single-photon avalanche diode (SPAD) 1700. Specifically, the second guard ring 131 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

The second contact 151 may be provided on the side surface of the second guard ring 131. The second contact 151 may be provided on the opposite side of the second heavily doped region 130 with the second guard ring 131 interposed therebetween. The second contact 151 may be exposed on the front side 100a. On the front side 100a, the second contact 151 may surround the second guard ring 131. In another example, a plurality of second contacts 151 may be provided. In this case, the plurality of second contacts 151 may be electrically connected to circuits outside the single-photon avalanche diode (SPAD) 1700, respectively. The conductivity type of the second contact 151 may be a n-type. The doping concentration of the second contact 151 may be higher than the doping concentration of the sixth well 153. For example, the doping concentration of the second contact 151 may be 1x10¹⁵ ~ 2x10²⁰ cm⁻³. In one example, the second contact 151 may be electrically connected to at least one of an external power supply, a DC-to-DC converter, and other power management integrated circuits. In one example, the second contact 151 may be electrically connected to at least one of a quenching resistor (or quenching circuit) and other pixel circuits.

The second relief region 152 may be provided between the second contact 151 and the sixth well 153. The second relief region 152 may be electrically connected to the second contact 151 and the sixth well 153. The second relief region 152 may relieve the difference between the second contact 151 and the sixth well 153. The second relief region 152 may be extended along the second contact 151. The second relief region 152 may be provided on the side and top surfaces of the second contact 151. For example, the second relief region 152 may be in direct contact with the side and top surfaces of the second contact 151. The top and one side surfaces of the second relief region 152 may contact the sixth well 153. The other side of the second relief region 152 may be exposed by the sixth well 153 and may contact the buried region 110. The second relief region 152 may be exposed on the front side 100a. On the front side 100a, the second relief region 152 may surround the second guard ring 131. The second relief region 152 may be spaced apart from the second guard ring 131. The sixth well 153 may extend between the second relief region 152 and the second guard ring 131. For example, a region between the second relief region 152 and the second guard ring 131 may be filled with the sixth well 153. Between the second relief region 152 and the second guard ring 131, the sixth well 153 may be exposed on the front side 100a. In one example, the sixth well 153 may not be provided in a region adjacent to the front side 100a. For example, a region adjacent to the front side 100a between the second relief region 152 and the second guard ring 131 may be filled with the buried region 110. Between the second relief region 152 and the second guard ring 131, the buried region 110 may be exposed on the front side 100a. For example, a region adjacent to the front side 100a between the second relief region 152 and the second guard ring 131 may be filled with the substrate region 102. Between the second relief region 152 and the second guard ring 131, the substrate region 102 may be exposed on the front side 100a. The second relief region 152 may extend along a direction from the front side 100a to the back side 100b. The distance between the second relief region 152 and the back side 100b may be smaller than the distance between the second guard ring 131 and the back side 100b. The doping concentration of the second relief region 152 may be lower than that of the second contact 151 and may be similar to or higher than the doping concentration of the sixth well 153. The conductivity type of the second relief region 152 may be n-type. For example, the doping concentration of the second relief region 152 may be 1x10¹⁵ to 5x10¹⁷ cm⁻³.

The device isolation pattern 104 may be provided on the side surface of the second relief region 152. The device isolation pattern 104 may be exposed on the front side 100a. On the front side 100a, the device isolation pattern 104 may surround the second relief region 152. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1700 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the second relief region 152 and the substrate region 102 as well as the buried region 110. In another example, the device isolation pattern 104 may be formed to contact the first contact 121. In another example, the single-photon avalanche diode (SPAD) 1700 may not include a device isolation pattern 104. Each region may have a conductivity type opposite to the conductivity type described above. For example, regions described as having n-type may have a p-type, and regions described as having p-type may have n-type.

The present disclosure may provide a single-photon avalanche diode 1700 that has improved tunneling noise characteristics and trap-assisted tunneling noise characteristics and operates in a wide wavelength band by using the third lightly doped region 154. The present disclosure may provide a single-photon avalanche diode 1700 with a low breakdown voltage by using the third lightly doped region 154.

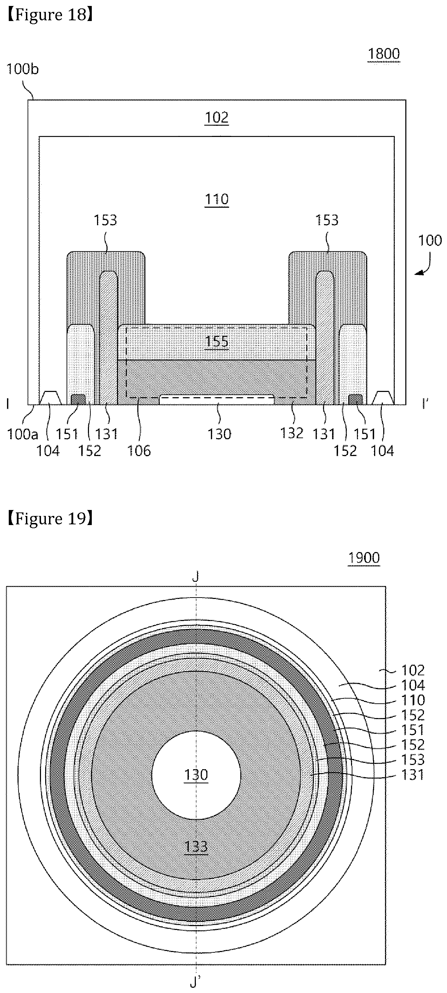

FIG. 17 is a plan view of a single-photon avalanche diode (SPAD) according to example embodiments. FIG. 18 is a cross-sectional view of the single-photon avalanche diode (SPAD) of FIG. 17 taken along line I-I'.

Referring to FIGS. 17 and 18, a single-photon avalanche diode (SPAD) 1800 may be provided. The single-photon avalanche diode (SPAD) 1800 may be referred to as a Geiger-mode Avalanche diode (Geiger-mode APD, G-APD). The single-photon avalanche diode (SPAD) 1800 may include a buried region 110, a sixth well 153, a second heavily doped region 130, a seventh well 132, an eighth well 155, a second guard ring 131, a second contact 151, a second relief region 152, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the sixth well 153, the second heavily doped region 130, the seventh well 132, the eighth well 155, the second guard ring 131, the second contact 151, and the second relief region 152 may be formed by implanting impurities into the semiconductor substrate 100. In the semiconductor substrate 100, the buried region 110, the sixth well 153, the second heavily doped region 130, the seventh well 132, the eighth well 155, the second guard ring 131, the second contact 151, and the second relief region 152 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The second heavily doped region 130 may be exposed on the front side 100a. The conductivity type of the second heavily doped region 130 may be p-type. For example, the doping concentration of the second heavily doped region 130 may be 1x10¹⁵ ~ 2x10²⁰ cm⁻³. In one example, the second heavily doped region 130 may be electrically connected to at least one of an external power supply, a DC-to-DC converter, and other power management integrated circuits. In one example, the second heavily doped region 130 may be electrically connected to at least one of a quenching resistor (or quenching circuit) and other pixel circuits. A quenching resistor or quenching circuitry may be configured to stop the avalanche effect and allow the single photon avalanche diode (SPAD) 1800 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1800 or receive signals from the single-photon avalanche diode (SPAD) 1800.

The seventh well 132 may be configured to form a depletion region 106. The size of the depletion region 106 is shown as an example and is not limiting. When a reverse bias is applied to the single-photon avalanche diode 1800, a strong electric field may be formed in the depletion region 106. For example, the maximum magnitude of the electric field may be about 3x10⁵ to 1x10⁶ V/cm. Since electrons may be multiplied by the electric field of the depletion region 106, the depletion region 106 may be referred to as a multiplication region. The seventh well 132 may be provided between the second heavily doped region 130 and the buried region 110. The seventh well 132 may contact the top and side surfaces of the second heavily doped region 130. The seventh well 132 may be exposed on the front side 100a. On the front side 100a, the seventh well 132 may surround the second heavily doped region 130. The conductivity type of the seventh well 132 may be p-type. For example, the doping concentration of the seventh well 132 may be 1x10¹⁵ to 5x10¹⁷ cm⁻³.

The eighth well 155 may be provided between the seventh well 132 and the buried region 110. The eighth well 155 may be provided on the top surface of the seventh well 132. The conductivity type of the eighth well 155 may be n-type. For example, the doping concentration of the eighth well 155 may be 1x10¹⁵ to 5x10¹⁷ cm⁻³. The eighth well 155 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. A depletion region 106 may be formed at a required depth by the seventh well 132 and the eighth well 155. Depth may refer to the distance from the front 100a along the direction from the front side 100a to the back side 100b. Depending on the depth of the depletion region 106, the detection efficiency according to the wavelength band of the single-photon avalanche diode 1800 may vary. For example, the wavelength band over which the single-photon avalanche diode 1800 has high detection efficiency may be controlled by the depth of the depletion region 106. Accordingly, the present disclosure may provide a single-photon avalanche diode 1800 with high detection efficiency for a required wavelength band.

The second guard ring 131 may be provided on the sides of the second heavily doped region 130, the seventh well 132, and the eighth well 155. The second guard ring 131 may surround the second heavily doped region 130, the seventh well 132, and the eighth well 155. For example, the second guard ring 131 may have a ring shape extending along the side of the second heavily doped region 130, the seventh well 132, and the eighth well 155. The second guard ring 131 may be in direct contact with the second heavily doped region 130, the seventh well 132, and the eighth well 155. In another example, the second guard ring 131 may be spaced apart from the second heavily doped region 130, the seventh well 132, and the eighth well 155. The second guard ring 131 may be exposed on the front side 100a. On the front side 100a, the second guard ring 131 may surround the second heavily doped region 130 and the seventh well 132. The second guard ring 131 may be extended along a direction from the front side 100a to the back side 100b. The distance between the second guard ring 131 and the back side 100b may be smaller than the distance between the eighth well 155 and the back side 100b. The conductivity type of the second guard ring 131 may be p-type. The doping concentration of the second guard ring 131 may be lower than the doping concentration of the second heavily doped region 130. For example, the doping concentration of the second guard ring 131 may be 1x10¹⁵ ~ 1x10¹⁸ cm⁻³. The second guard ring 131 may improve breakdown characteristics of the single-photon avalanche diode (SPAD) 1800. Specifically, the second guard ring 131 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

The sixth well 153 may be provided between the second guard ring 131 and the buried region 110. The sixth well 153 may cover the top and side surfaces of the second guard ring 131. For example, the sixth well 153 may have a ring shape extending along the second guard ring 131. The top surface of the eighth well 155 may be exposed inside the second guard ring 131. The top and side surfaces of the sixth well 153 may directly contact the buried region 110. The conductivity type of the sixth well 153 may be n-type. For example, the doping concentration of the sixth well 153 may be 1x10¹⁵ to 1x10¹⁸ cm⁻³. In one example, the sixth well 153 may have a uniform doping concentration. In one example, the doping concentration of the sixth well 153 may decrease as it approaches the front side 100a. The sixth well 153 may electrically connect the eighth well 155 to the second contact 151 and the second relief region 152. For example, the cathode voltage may be applied to the eighth well 155 through the sixth well 153.

The second contact 151 may be provided on the side surface of the second guard ring 131. The second contact 151 may be provided on the opposite side of the second heavily doped region 130 with the second guard ring 131 interposed therebetween. The second contact 151 may be exposed on the front side 100a. On the front side 100a, the second contact 151 may surround the second guard ring 131. In another example, a plurality of second contacts 151 may be provided. In this case, the plurality of second contacts 151 may be electrically connected to circuits outside the single-photon avalanche diode (SPAD) 1800, respectively. The conductivity type of the second contact 151 may be a n-type. The doping concentration of the second contact 151 may be higher than the doping concentration of the sixth well 153. For example, the doping concentration of the second contact 151 may be 1x10¹⁵ ~ 2x10²⁰ cm⁻³. In one example, the second contact 151 may be electrically connected to at least one of an external power supply, a DC-to-DC converter, and other power management integrated circuits. In one example, the second contact 151 may be electrically connected to at least one of a quenching resistor (or quenching circuit) and other pixel circuits.

The second relief region 152 may be provided between the second contact 151 and the sixth well 153. The second relief region 152 may be electrically connected to the second contact 151 and the sixth well 153. The second relief region 152 may relieve the difference between the second contact 151 and the sixth well 153. The second relief region 152 may be extended along the second contact 151. The second relief region 152 may be provided on the side and top surfaces of the second contact 151. For example, the second relief region 152 may be in direct contact with the side and top surfaces of the second contact 151. The top and one side surfaces of the second relief region 152 may contact the sixth well 153. The other side of the second relief region 152 may be exposed by the sixth well 153 and may contact the buried region 110. The second relief region 152 may be exposed on the front side 100a. On the front side 100a, the second relief region 152 may surround the second guard ring 131. The second relief region 152 may be spaced apart from the second guard ring 131. The sixth well 153 may extend between the second relief region 152 and the second guard ring 131. For example, a region between the second relief region 152 and the second guard ring 131 may be filled with the sixth well 153. Between the second relief region 152 and the second guard ring 131, the sixth well 153 may be exposed on the front side 100a. In one example, the sixth well 153 may not be provided in a region adjacent to the front side 100a. For example, a region adjacent to the front side 100a between the second relief region 152 and the second guard ring 131 may be filled with the buried region 110. Between the second relief region 152 and the second guard ring 131, the buried region 110 may be exposed on the front side 100a. For example, a region adjacent to the front side 100a between the second relief region 152 and the second guard ring 131 may be filled with the substrate region 102. Between the second relief region 152 and the second guard ring 131, the substrate region 102 may be exposed on the front side 100a. The second relief region 152 may extend along a direction from the front side 100a to the back side 100b. The distance between the second relief region 152 and the back side 100b may be bigger than the distance between the second guard ring 131 and the back side 100b. The conductivity type of the second relief region 152 may be n-type. The doping concentration of the second relief region 152 may be lower than that of the second contact 151. For example, the doping concentration of the second relief region 152 may be 1x10¹⁵ to 5x10¹⁷ cm⁻³.

The device isolation pattern 104 may be provided on the side surface of the second relief region 152. The device isolation pattern 104 may be exposed on the front side 100a. On the front side 100a, the device isolation pattern 104 may surround the second relief region 152. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1800 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the second relief region 152 and the substrate region 102 as well as the buried region 110. In another example, the device isolation pattern 104 may be formed to contact the first contact 121. In another example, the single-photon avalanche diode (SPAD) 1800 may not include a device isolation pattern 104. Each region may have a conductivity type opposite to the conductivity type described above. For example, regions described as having n-type may have a p-type, and regions described as having p-type may have n-type.

The present disclosure may provide a single-photon avalanche diode 1800 with high detection efficiency over a required wavelength band.

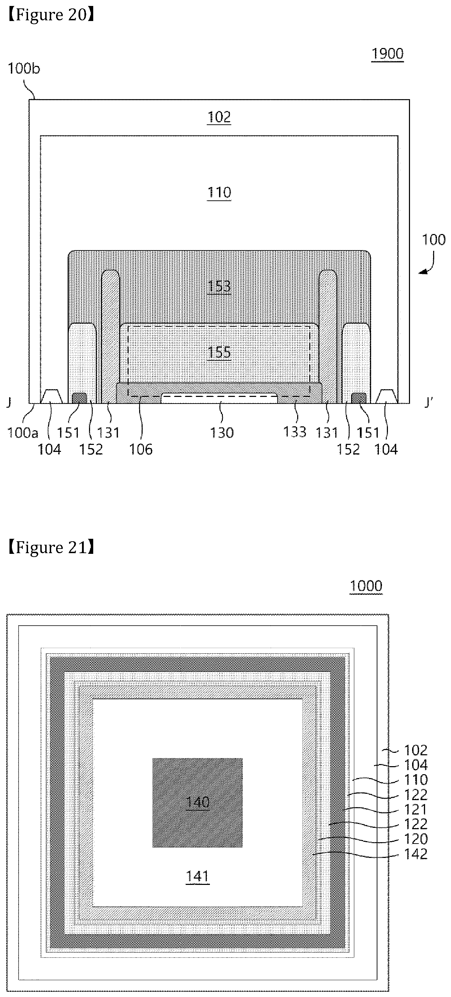

FIG. 19 is a plan view of a single-photon avalanche diode (SPAD) according to example embodiments. FIG. 20 is a cross-sectional view of the single-photon avalanche diode (SPAD) of FIG. 19 taken along line J-J'.

Referring to FIGS. 19 and 20, a single-photon avalanche diode (SPAD) 1900 may be provided. The single-photon avalanche diode (SPAD) 1900 may be referred to as a Geiger-mode Avalanche diode (Geiger-mode APD, G-APD). The single-photon avalanche diode (SPAD) 1900 may include a buried region 110, a sixth well 153, a second heavily doped region 130, a fourth lightly doped region 133, an eighth well 155, a second guard ring 131, a second contact 151, a second relief region 152, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the sixth well 153, the second heavily doped region 130, the fourth lightly doped region 133, the eighth well 155, the second guard ring 131, the second contact 151, and the second relief region 152 may be formed by implanting impurities into the semiconductor substrate 100. In the semiconductor substrate 100, the buried region 110, the sixth well 153, the second heavily doped region 130, the fourth lightly doped region 133, the eighth well 155, the second guard ring 131, the second contact 151, and the second relief region 152 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The second heavily doped region 130 may be exposed on the front side 100a. The conductivity type of the second heavily doped region 130 may be p-type. For example, the doping concentration of the second heavily doped region 130 may be 1x10¹⁵ ~ 2x10²⁰ cm⁻³. In one example, the second heavily doped region 130 may be electrically connected to at least one of an external power supply, a DC-to-DC converter, and other power management integrated circuits. In one example, the second heavily doped region 130 may be electrically connected to at least one of a quenching resistor (or quenching circuit) and other pixel circuits. A quenching resistor or quenching circuitry may be configured to stop the avalanche effect and allow the single photon avalanche diode (SPAD) 1900 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1900 or receive signals from the single-photon avalanche diode (SPAD) 1900.

The fourth lightly doped region 133 may be configured to form a depletion region 106. The size of the depletion region 106 is shown as an example and is not limiting. When a reverse bias is applied to the single-photon avalanche diode 1900, a strong electric field may be formed in the depletion region 106. For example, the maximum magnitude of the electric field may be about 3x10⁵ to 1x10⁶ V/cm. Since electrons may be multiplied by the electric field of the depletion region 106, the depletion region 106 may be referred to as a multiplication region. The fourth lightly doped region 133 may be configured to reduce or prevent the short-channel effect that occurs as the size of the semiconductor device decreases. For example, the single-channel effect may be that current flows even though no photons are incident on the single-photon avalanche diode 1900. The fourth lightly doped region 133 may be provided between the second heavily doped region 130 and the sixth well 153. The fourth lightly doped region 133 may contact the top and side surfaces of the second heavily doped region 130. The fourth lightly doped region 133 may be exposed on the front side 100a. On the front side 100a, the fourth lightly doping region 133 may surround the second heavily doping region 130. The conductivity type of the fourth lightly doped region 133 may be p-type. The fourth lightly doping region 133 may have a lower doping concentration than the second heavily doping region 130. For example, the doping concentration of the fourth lightly doping region 133 may be 1x10¹⁵ to 1x10¹⁸ cm⁻³. By forming the depletion region 106 using the fourth lightly doped region 133, tunneling noise and trap-assisted tunneling noise of the single-photon avalanche diode 1900 may be reduced. The operating wavelength band of the single-photon avalanche diode 1900 may be broadened.

The eighth well 155 may be provided between the fourth lightly doping region 133 and the buried region 110. The eighth well 155 may be provided on the top surface of the fourth lightly doping region 133. The conductivity type of the eighth well 155 may be n-type. For example, the doping concentration of the eighth well 155 may be 1x10¹⁵ to 5x10¹⁷ cm⁻³. The eighth well 155 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements.

The second guard ring 131 may be provided on the sides of the fourth lightly doping region 133 and the eighth well 155. The second guard ring 131 may surround the fourth lightly doping region 133 and the eighth well 155. For example, the second guard ring 131 may have a ring shape extending along the side of the fourth lightly doping region 133 and the eighth well 155. The second guard ring 131 may be in direct contact with the fourth lightly doping region 133 and the eighth well 155. In another example, the second guard ring 131 may be spaced apart from the fourth lightly doping region 133 and the eighth well 155. The second guard ring 131 may be exposed on the front side 100a. On the front side 100a, the second guard ring 131 may surround the fourth lightly doping region 133. The second guard ring 131 may be extended along a direction from the front side 100a to the back side 100b. The distance between the second guard ring 131 and the back side 100b may be smaller than the distance between the eighth well 155 and the back side 100b. The conductivity type of the second guard ring 131 may be p-type. The doping concentration of the second guard ring 131 may be lower than the doping concentration of the second heavily doped region 130. For example, the doping concentration of the second guard ring 131 may be 1x10¹⁵ ~ 1x10¹⁸ cm⁻³. The second guard ring 131 may improve breakdown characteristics of the single-photon avalanche diode (SPAD) 1900. Specifically, the second guard ring 131 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

The sixth well 153 may be provided between the second guard ring 131 and the buried region 110 and between the eighth well 155 and the buried region 110. The sixth well 153 may cover the second guard ring 131 and the eighth well 155. The sixth well 153 may cover the top surface and one side surface of the second relief region 152, and expose the other side surface of the second relief region 152. The top and side surfaces of the sixth well 153 may directly contact the buried region 110. The conductivity type of the sixth well 153 may be n-type. For example, the doping concentration of the sixth well 153 may be 1x10¹⁵ to 1x10¹⁸ cm⁻³. In one example, the sixth well 153 may have a uniform doping concentration. In one example, the doping concentration of the sixth well 153 may decrease as it approaches the front side 100a.

The second contact 151 may be provided on the side surface of the second guard ring 131. The second contact 151 may be provided on the opposite side of the second heavily doped region 130 with the second guard ring 131 interposed therebetween. The second contact 151 may be exposed on the front side 100a. On the front side 100a, the second contact 151 may surround the second guard ring 131. In another example, a plurality of second contacts 151 may be provided. In this case, the plurality of second contacts 151 may be electrically connected to circuits outside the single-photon avalanche diode (SPAD) 1900, respectively. The conductivity type of the second contact 151 may be a n-type. The doping concentration of the second contact 151 may be higher than the doping concentration of the sixth well 153. For example, the doping concentration of the second contact 151 may be 1x10¹⁵ ~ 2x10²⁰ cm⁻³. In one example, the second contact 151 may be electrically connected to at least one of an external power supply, a DC-to-DC converter, and other power management integrated circuits. In one example, the second contact 151 may be electrically connected to at least one of a quenching resistor (or quenching circuit) and other pixel circuits.

The second relief region 152 may be provided between the second contact 151 and the sixth well 153. The second relief region 152 may be electrically connected to the second contact 151 and the sixth well 153. The second relief region 152 may relieve the difference between the second contact 151 and the sixth well 153. The second relief region 152 may be extended along the second contact 151. The second relief region 152 may be provided on the side and top surfaces of the second contact 151. For example, the second relief region 152 may be in direct contact with the side and top surfaces of the second contact 151. The top and one side surfaces of the second relief region 152 may contact the sixth well 153. The other side of the second relief region 152 may be exposed by the sixth well 153 and may contact the buried region 110. The second relief region 152 may be exposed on the front side 100a. On the front side 100a, the second relief region 152 may surround the second guard ring 131. The second relief region 152 may be spaced apart from the second guard ring 131. The sixth well 153 may extend between the second relief region 152 and the second guard ring 131. For example, a region between the second relief region 152 and the second guard ring 131 may be filled with the sixth well 153. Between the second relief region 152 and the second guard ring 131, the sixth well 153 may be exposed on the front side 100a. In one example, the sixth well 153 may not be provided in a region adjacent to the front side 100a. For example, a region adjacent to the front side 100a between the second relief region 152 and the second guard ring 131 may be filled with the buried region 110. Between the second relief region 152 and the second guard ring 131, the buried region 110 may be exposed on the front side 100a. For example, a region adjacent to the front side 100a between the second relief region 152 and the second guard ring 131 may be filled with the substrate region 102. Between the second relief region 152 and the second guard ring 131, the substrate region 102 may be exposed on the front side 100a. The second relief region 152 may extend along a direction from the front side 100a to the back side 100b. The distance between the second relief region 152 and the back side 100b may be bigger than the distance between the second guard ring 131 and the back side 100b. The conductivity type of the second relief region 152 may be n-type. The doping concentration of the second relief region 152 may be lower than that of the second contact 151. For example, the doping concentration of the second relief region 152 may be 1x10¹⁵ to 5x10¹⁷ cm⁻³.

The device isolation pattern 104 may be provided on the side surface of the second relief region 152. The device isolation pattern 104 may be exposed on the front side 100a. On the front side 100a, the device isolation pattern 104 may surround the second relief region 152. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1900 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the second relief region 152 and the substrate region 102 as well as the buried region 110. In another example, the device isolation pattern 104 may be formed to contact the first contact 121. In another example, the single-photon avalanche diode (SPAD) 1900 may not include a device isolation pattern 104. Each region may have a conductivity type opposite to the conductivity type described above. For example, regions described as having n-type may have a p-type, and regions described as having p-type may have n-type.

The present disclosure may provide a single-photon avalanche diode 1900 using the fourth lightly doped region 133 to form the depletion region 106. The single-photon avalanche diode 1900 may have improved tunneling noise characteristics and trap assisted tunneling noise characteristics. The single-photon avalanche diode 1900 may operate in a wide wavelength band.

FIG. 21 is a plan view of the single-photon avalanche diode of FIG. 2 according to an example embodiment. Differences from those shown in FIG. 1 are described for brevity of explanation.

Referring to FIG. 21, a single-photon avalanche diode 1000 may be provided. Unlike that shown in FIG. 1, the single-photon avalanche diode 1000 may have a square shape. Specifically, the heavily doped region 140 may have a square shape, and the first lightly doped region 141, the first guard ring 142, the first well 120, the first relief region 122, the first contact 121, the buried region 110, and the device isolation pattern 104 may have a square ring shape surrounding the heavily doped region 140. The first lightly doped region 141, the first guard ring 142, the first well 120, the first relief region 122, the first contact 121, the buried reigon 110, and the device isolation pattern 104 may be sequentially arranged in a direction away from the heavily doped region 140. For example, the first lightly doped region 141, the first guard ring 142, the first well 120, the first relief region 122, the first contact 121, the buried region 110, and the device isolation pattern 104 may have the same center.

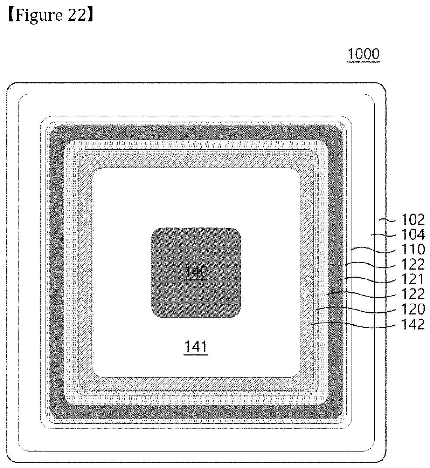

FIG. 22 is a plan view of the single-photon avalanche diode of FIG. 2 according to an example embodiment. Differences from those shown in FIG. 1 are described for brevity of explanation.

Referring to FIG. 22, a single-photon avalanche diode 1000 may be provided. Unlike that shown in FIG. 1, the single-photon avalanche diode 1000 may have a square shape with rounded corners. Specifically, the heavily doped region 140 may have a square shape with rounded corners, and the first lightly doped region 141, the first guard ring 142, the first well 120, the first relief region 122, the first contact 121, the buried region 110, and the device isolation pattern 104 may have a square ring shape with rounded corners surrounding the heavily doped region 140. The first lightly doped region 141, the first guard ring 142, the first well 120, the first relief region 122, the first contact 121, the buried region 110, and the device isolation pattern 104 may be sequentially arranged in a direction away from the heavily doped region 140. For example, the heavily doped region 140, the first lightly doped region 141, the first guard ring 142, the first well 120, the first relief region 122, the first contact 121, the buried region 110, and the device isolation pattern 104 may have the same center.

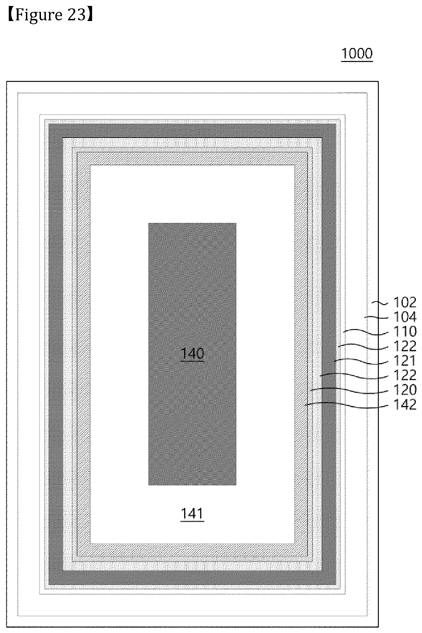

FIG. 23 is a plan view of the single-photon avalanche diode of FIG. 2 according to an example embodiment. Differences from those shown in FIG. 1 are described for brevity of explanation.

Referring to FIG. 23, a single-photon avalanche diode 1000 may be provided. Unlike that shown in FIG. 1, the single-photon avalanche diode 1000 may have a rectangular shape. Specifically, the heavily doped region 140 may have a rectangular shape, and the first lightly doped region 141, the first guard ring 142, the first well 120, the first relief region 122, the first contact 121, the buried region 110, and the device isolation pattern 104 may have a rectangular ring shape surrounding the heavily doped region 140. The first lightly doped region 141, the first guard ring 142, the first well 120, the first relief region 122, the first contact 121, the buried region 110, and the device isolation pattern 104 may be sequentially arranged in a direction away from the heavily doped region 140. For example, the heavily doped region 140, the first lightly doped region 141, the first guard ring 142, the first well 120, the first relief region 122, the first contact 121, the buried region 110, and the device isolation pattern 104 may have the same center.

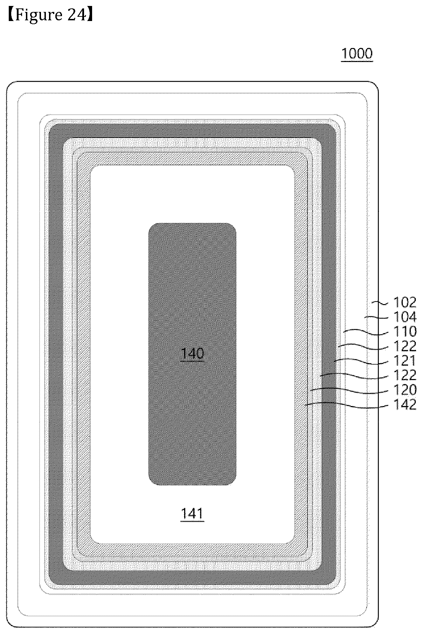

FIG. 24 is a plan view of the single-photon avalanche diode of FIG. 2 according to an example embodiment. Differences from those shown in FIG. 1 are described for brevity of explanation.

Referring to FIG. 24, a single-photon avalanche diode 1000 may be provided. Unlike that shown in FIG. 1, the single-photon avalanche diode 1000 may have a rectangular shape with rounded corners. Specifically, the heavily doped region 140 may have a rectangular shape with rounded corners, and the first lightly doped region 141, the first guard ring 142, the first well 120, the first relief region 122, the first contact 121, the buried region 110, and the device isolation pattern 104 may have a rectangular ring shape with rounded corners surrounding the heavily doped region 140. The first lightly doped region 141, the first guard ring 142, the first well 120, the first relief region 122, the first contact 121, the buried region 110, and the device isolation pattern 104 may be sequentially arranged in a direction away from the heavily doped region 140. For example, the heavily doped region 140, the first lightly doped region 141, the first guard ring 142, the first well 120, the first relief region 122, the first contact 121, the buried region 110, and the device isolation pattern 104 may have the same center.

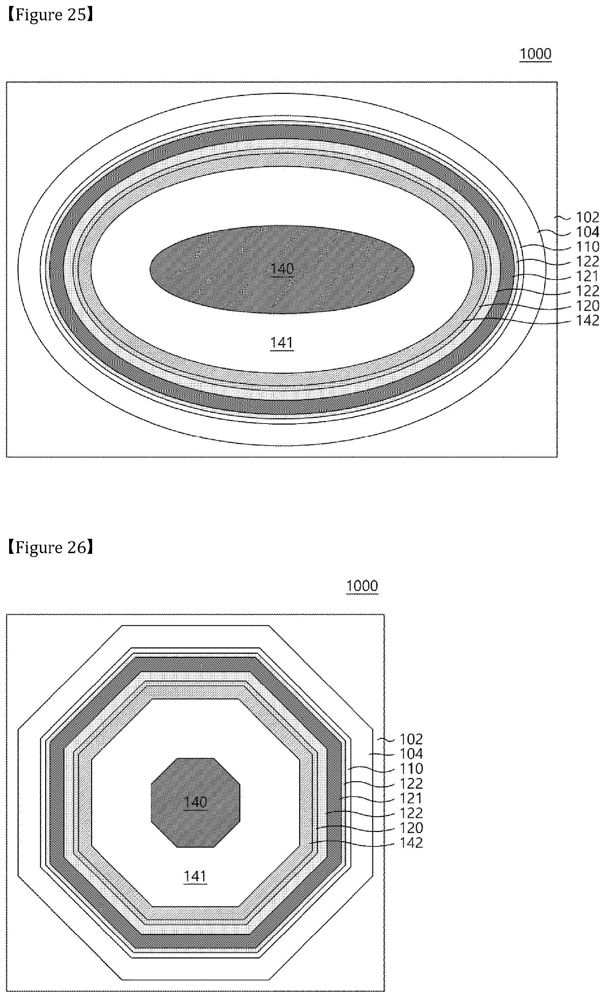

FIG. 25 is a plan view of the single-photon avalanche diode of FIG. 2 according to an example embodiment. Differences from those shown in FIG. 1 are described for brevity of explanation.

Referring to FIG. 25, a single-photon avalanche diode 1000 may be provided. Unlike that shown in FIG. 1, the single-photon avalanche diode 1000 may have an elliptical shape. Specifically, the heavily doped region 140 may have an elliptical shape, and the first lightly doped region 141, the first guard ring 142, the first relief region 122, the first well 120, the first contact 121, the buried region 110, and the device isolation pattern 104 may have an elliptical ring shape surrounding the heavily doped region 140. The first lightly doped region 141, the first guard ring 142, the first relief region 122, the first well 120, the first contact 121, the buried region 110, and the device isolation pattern 104 may be sequentially arranged in a direction away from the heavily doped region 140. For example, the heavily doped region 140, the first lightly doped region 141, the first guard ring 142, the first well 120, the first relief region 122, the first contact 121, the buried region 110, and the device isolation pattern 104 may have the same center.

FIG. 26 is a plan view of the single-photon avalanche diode of FIG. 2 according to an example embodiment. Differences from those shown in FIG. 1 are described for brevity of explanation.

Referring to FIG. 26, a single-photon avalanche diode 1000 may be provided. Unlike that shown in FIG. 1, the single-photon avalanche diode 1000 may have an octagonal shape. Specifically, the heavily doped region 140 may have an octagonal shape, and the first lightly doped region 141, the first guard ring 142, the first relief region 122, the first well 120, the first contact 121, the buried region 110, and the device isolation pattern 104 may have an octagonal ring shape surrounding the heavily doped region 140. The first lightly doped region 141, the first guard ring 142, the first relief region 122, the first well 120, the first contact 121, the buried region 110, and the device isolation pattern 104 may be sequentially arranged in a direction away from the heavily doped region 140. For example, the heavily doped region 140, the first lightly doped region 141, the first guard ring 142, the first well 120, the first relief region 122, the first contact 121, the buried region 110, and the device isolation pattern 104 may have the same center.

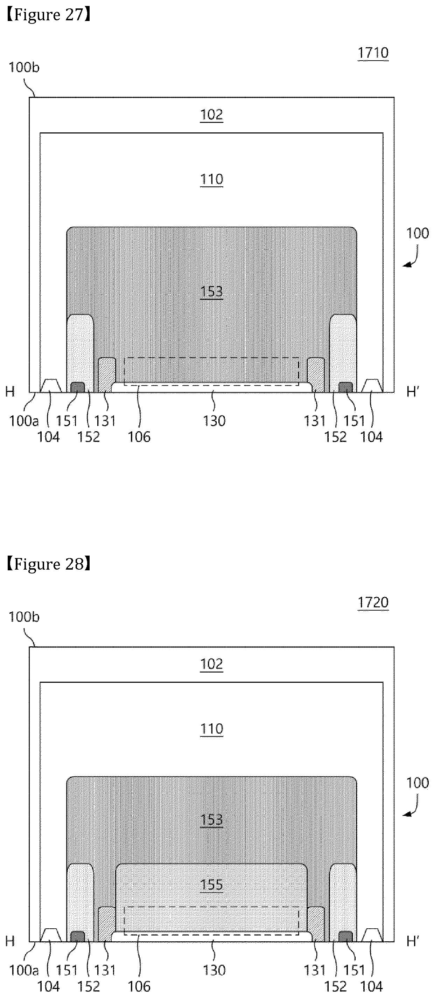

FIG. 27 is a cross-sectional view corresponding to line H-H' of FIG. 15 illustrating a single-photon avalanche diode according to example embodiments.

Referring to FIGS. 15 and 27, a single-photon avalanche diode (SPAD) 1710 may be provided. The single-photon avalanche diode (SPAD) 1710 may be referred to as a Geiger-mode Avalanche diode (Geiger-mode APD, G-APD). The single-photon avalanche diode (SPAD) 1710 may include a buried region 110, a sixth well 153, a second heavily doped region 130, a second guard ring 131, a second contact 151, a second relief region 152, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the sixth well 153, the second heavily doped region 130, the second guard ring 131, the second contact 151, and the second relief region 152 may be formed by implanting impurities into the semiconductor substrate 100. In the semiconductor substrate 100, the buried region 110, the sixth well 153, the second heavily doped region 130, the second guard ring 131, the second contact 151, and the second relief region 152 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The sixth well 153 may be provided in the semiconductor substrate 100. The buried region 110 may be disposed between the sixth well 153 and the back side 100b. The upper and side surfaces of the sixth well 153 may be in direct contact with the buried region 110. The conductivity type of the sixth well 153 may be n-type. The sixth well 153 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the sixth well 153 may be 1x10¹⁵ ~ 1x10¹⁸ cm⁻³. In one example, the sixth well 153 may have a uniform doping concentration. In one example, the doping concentration of the sixth well 153 may be smaller as it is closer to the front side 100a of the single-photon avalanche diode (SPAD) 1100.

The second heavily doped region 130 may be configured to form a depletion region 106. The size of the depletion region 106 is shown as an example and is not limited. When reverse bias is applied to the single-photon avalanche diode (SPAD) 1710, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The second heavily doped region 130 may be provided between the sixth well 153 and the front side 100a. The second heavily doped region 130 may be exposed on the front side 100a. The conductivity type of the second heavily doped region 130 may be p-type. For example, the doping concentration of the second heavily doped region 130 may be 1x10¹⁵ ~ 2x10²⁰ cm⁻³. In one example, the second heavily doped region 130 may be electrically connected to at least one of an external power supply, a DC-to-DC converter, and other power management integrated circuits. In one example, the second heavily doped region 130 may be electrically connected to at least one of a quenching resistor (or quenching circuit) and other pixel circuits. A quenching resistor or quenching circuitry may be configured to stop the avalanche effect and allow the single photon avalanche diode (SPAD) 1710 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1710 or receive signals from the single-photon avalanche diode (SPAD) 1710.

The second guard ring 131 may be provided on the sides of the second heavily doped region 130. The second guard ring 131 may surround the second heavily doped region 130. For example, the second guard ring 131 may have a ring shape extending along the side of the second heavily doped region 130. The second guard ring 131 may be in direct contact with the second heavily doped region 130, the third lightly doped region 154, and the eighth well 155. In another example, the second guard ring 131 may be spaced apart from the second heavily doped region 130. The second guard ring 131 may be exposed on the front side 100a. On the front side 100a, the second guard ring 131 may surround the second heavily doped region 130. The second guard ring 131 may be extended along a direction from the front side 100a to the back side 100b. The distance between the second guard ring 131 and the back side 100b may be greater than the distance between the eighth well 155 and the back side 100b. The second guard ring 131 may contact the sixth well 153. The conductivity type of the second guard ring 131 may be p-type. The doping concentration of the second guard ring 131 may be lower than the doping concentration of the second heavily doped region 130. For example, the doping concentration of the second guard ring 131 may be 1x10¹⁵ ~ 5x10¹⁷ cm⁻³. The second guard ring 131 may improve breakdown characteristics of the single-photon avalanche diode (SPAD) 1710. Specifically, the second guard ring 131 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

The second contact 151 may be provided on the side surface of the second guard ring 131. The second contact 151 may be provided on the opposite side of the second heavily doped region 130 with the second guard ring 131 interposed therebetween. The second contact 151 may be exposed on the front side 100a. On the front side 100a, the second contact 151 may surround the second guard ring 131. In another example, a plurality of second contacts 151 may be provided. In this case, the plurality of second contacts 151 may be electrically connected to circuits outside the single-photon avalanche diode (SPAD) 1710, respectively. The conductivity type of the second contact 151 may be a n-type. The doping concentration of the second contact 151 may be higher than the doping concentration of the sixth well 153. For example, the doping concentration of the second contact 151 may be 1x10¹⁵ ~ 2x10²⁰ cm⁻³. In one example, the second contact 151 may be electrically connected to at least one of an external power supply, a DC-to-DC converter, and other power management integrated circuits. In one example, the second contact 151 may be electrically connected to at least one of a quenching resistor (or quenching circuit) and other pixel circuits.

The second relief region 152 may be provided between the second contact 151 and the sixth well 153. The second relief region 152 may be electrically connected to the second contact 151 and the sixth well 153. The second relief region 152 may relieve the difference between the second contact 151 and the sixth well 153. The second relief region 152 may be extended along the second contact 151. The second relief region 152 may be provided on the side and top surfaces of the second contact 151. For example, the second relief region 152 may be in direct contact with the side and top surfaces of the second contact 151. The top and one side surfaces of the second relief region 152 may contact the sixth well 153. The other side of the second relief region 152 may be exposed by the sixth well 153 and may contact the buried region 110. The second relief region 152 may be exposed on the front side 100a. On the front side 100a, the second relief region 152 may surround the second guard ring 131. The second relief region 152 may be spaced apart from the second guard ring 131. The sixth well 153 may extend between the second relief region 152 and the second guard ring 131. For example, a region between the second relief region 152 and the second guard ring 131 may be filled with the sixth well 153. Between the second relief region 152 and the second guard ring 131, the sixth well 153 may be exposed on the front side 100a. In one example, the sixth well 153 may not be provided in a region adjacent to the front side 100a. For example, a region adjacent to the front side 100a between the second relief region 152 and the second guard ring 131 may be filled with the buried region 110. Between the second relief region 152 and the second guard ring 131, the buried region 110 may be exposed on the front side 100a. For example, a region adjacent to the front side 100a between the second relief region 152 and the second guard ring 131 may be filled with the substrate region 102. Between the second relief region 152 and the second guard ring 131, the substrate region 102 may be exposed on the front side 100a. The second relief region 152 may extend along a direction from the front side 100a to the back side 100b. The distance between the second relief region 152 and the back side 100b may be smaller than the distance between the second guard ring 131 and the back side 100b. The doping concentration of the second relief region 152 may be lower than that of the second contact 151 and may be similar to or higher than the doping concentration of the sixth well 153. The conductivity type of the second relief region 152 may be n-type. For example, the doping concentration of the second relief region 152 may be 1x10¹⁵ to 5x10¹⁷ cm⁻³.

The device isolation pattern 104 may be provided on the side surface of the second relief region 152. The device isolation pattern 104 may be exposed on the front side 100a. On the front side 100a, the device isolation pattern 104 may surround the second relief region 152. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1710 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the second relief region 152 and the substrate region 102 as well as the buried region 110. In another example, the device isolation pattern 104 may be formed to contact the first contact 121. In another example, the single-photon avalanche diode (SPAD) 1710 may not include a device isolation pattern 104. Each region may have a conductivity type opposite to the conductivity type described above. For example, regions described as having n-type may have a p-type, and regions described as having p-type may have n-type.

FIG. 28 is a cross-sectional view corresponding to line H-H' of FIG. 15 illustrating a single-photon avalanche diode according to example embodiments.

Referring to FIGS. 15 and 28, a single-photon avalanche diode (SPAD) 1720 may be provided. The single-photon avalanche diode (SPAD) 1720 may be referred to as a Geiger-mode Avalanche diode (Geiger-mode APD, G-APD). The single-photon avalanche diode (SPAD) 1720 may include a buried region 110, a sixth well 153, a second heavily doped region 130, an eighth well 155, a second guard ring 131, a second contact 151, a second relief region 152, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the sixth well 153, the second heavily doped region 130, the eighth well 155, the second guard ring 131, the second contact 151, and the second relief region 152 may be formed by implanting impurities into the semiconductor substrate 100. In the semiconductor substrate 100, the buried region 110, the sixth well 153, the second heavily doped region 130, the eighth well 155, the second guard ring 131, the second contact 151, and the second relief region 152 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The sixth well 153 may be provided in the semiconductor substrate 100. The buried region 110 may be disposed between the sixth well 153 and the back side 100b. The upper and side surfaces of the sixth well 153 may be in direct contact with the buried region 110. The conductivity type of the sixth well 153 may be n-type. The sixth well 153 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the sixth well 153 may be 1x10¹⁵ ~ 1x10¹⁸ cm⁻³. In one example, the sixth well 153 may have a uniform doping concentration. In one example, the doping concentration of the sixth well 153 may be smaller as it is closer to the front side 100a of the single-photon avalanche diode (SPAD) 1100.

The second heavily doped region 130 may be configured to form a depletion region 106. The size of the depletion region 106 is shown as an example and is not limited. When reverse bias is applied to the single-photon avalanche diode (SPAD) 1720, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The second heavily doped region 130 may be provided between the sixth well 153 and the front side 100a. The second heavily doped region 130 may be exposed on the front side 100a. The conductivity type of the second heavily doped region 130 may be p-type. For example, the doping concentration of the second heavily doped region 130 may be 1x10¹⁵ ~ 2x10²⁰ cm⁻³. In one example, the second heavily doped region 130 may be electrically connected to at least one of an external power supply, a DC-to-DC converter, and other power management integrated circuits. In one example, the second heavily doped region 130 may be electrically connected to at least one of a quenching resistor (or quenching circuit) and other pixel circuits. A quenching resistor or quenching circuitry may be configured to stop the avalanche effect and allow the single photon avalanche diode (SPAD) 1720 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1720 or receive signals from the single-photon avalanche diode (SPAD) 1720.

The eighth well 155 may be provided between the second heavily doped region 130 and the sixth well 153. The eighth well 155 may be provided on the top surface of the eighth well 155. The conductivity type of the eighth well 155 may be n-type. For example, the doping concentration of the eighth well 155 may be 1x10¹⁵ to 5x10¹⁷ cm⁻³.

The second guard ring 131 may be provided on the sides of the second heavily doped region 130 and the eighth well 155. The second guard ring 131 may surround the second heavily doped region 130 and the eighth well 155. For example, the second guard ring 131 may have a ring shape extending along the side of the second heavily doped region 130 and the eighth well 155. The second guard ring 131 may be in direct contact with the second heavily doped region 130 and the eighth well 155. In another example, the second guard ring 131 may be spaced apart from the second heavily doped region 130 and the eighth well 155. The second guard ring 131 may be exposed on the front side 100a. On the front side 100a, the second guard ring 131 may surround the second heavily doped region 130. The second guard ring 131 may be extended along a direction from the front side 100a to the back side 100b. The distance between the second guard ring 131 and the back side 100b may be greater than the distance between the eighth well 155 and the back side 100b. The second guard ring 131 may contact the sixth well 153. The conductivity type of the second guard ring 131 may be p-type. The doping concentration of the second guard ring 131 may be lower than the doping concentration of the second heavily doped region 130. For example, the doping concentration of the second guard ring 131 may be 1x10¹⁵ ~ 5x10¹⁷ cm⁻³. The second guard ring 131 may improve breakdown characteristics of the single-photon avalanche diode (SPAD) 1720. Specifically, the second guard ring 131 may relieve concentration of electric field in a portion of the depletion region 106 to prevent premature breakdown phenomenon. The premature breakdown phenomenon occurs when breakdown occurs first in a portion of the depletion region 106 before an electric field of sufficient magnitude is applied throughout the depletion region 106. The premature breakdown phenomenon occurs as the electric field is concentrated at a portion of the depletion region 106.

The second contact 151 may be provided on the side surface of the second guard ring 131. The second contact 151 may be provided on the opposite side of the second heavily doped region 130 with the second guard ring 131 interposed therebetween. The second contact 151 may be exposed on the front side 100a. On the front side 100a, the second contact 151 may surround the second guard ring 131. In another example, a plurality of second contacts 151 may be provided. In this case, the plurality of second contacts 151 may be electrically connected to circuits outside the single-photon avalanche diode (SPAD) 1720, respectively. The conductivity type of the second contact 151 may be a n-type. The doping concentration of the second contact 151 may be higher than the doping concentration of the sixth well 153. For example, the doping concentration of the second contact 151 may be 1x10¹⁵ ~ 2x10²⁰ cm⁻³. In one example, the second contact 151 may be electrically connected to at least one of an external power supply, a DC-to-DC converter, and other power management integrated circuits. In one example, the second contact 151 may be electrically connected to at least one of a quenching resistor (or quenching circuit) and other pixel circuits.

The second relief region 152 may be provided between the second contact 151 and the sixth well 153. The second relief region 152 may be electrically connected to the second contact 151 and the sixth well 153. The second relief region 152 may relieve the difference between the second contact 151 and the sixth well 153. The second relief region 152 may be extended along the second contact 151. The second relief region 152 may be provided on the side and top surfaces of the second contact 151. For example, the second relief region 152 may be in direct contact with the side and top surfaces of the second contact 151. The top and one side surfaces of the second relief region 152 may contact the sixth well 153. The other side of the second relief region 152 may be exposed by the sixth well 153 and may contact the buried region 110. The second relief region 152 may be exposed on the front side 100a. On the front side 100a, the second relief region 152 may surround the second guard ring 131. The second relief region 152 may be spaced apart from the second guard ring 131. The sixth well 153 may extend between the second relief region 152 and the second guard ring 131. For example, a region between the second relief region 152 and the second guard ring 131 may be filled with the sixth well 153. Between the second relief region 152 and the second guard ring 131, the sixth well 153 may be exposed on the front side 100a. In one example, the sixth well 153 may not be provided in a region adjacent to the front side 100a. For example, a region adjacent to the front side 100a between the second relief region 152 and the second guard ring 131 may be filled with the buried region 110. Between the second relief region 152 and the second guard ring 131, the buried region 110 may be exposed on the front side 100a. For example, a region adjacent to the front side 100a between the second relief region 152 and the second guard ring 131 may be filled with the substrate region 102. Between the second relief region 152 and the second guard ring 131, the substrate region 102 may be exposed on the front side 100a. The second relief region 152 may extend along a direction from the front side 100a to the back side 100b. The distance between the second relief region 152 and the back side 100b may be smaller than the distance between the second guard ring 131 and the back side 100b. The doping concentration of the second relief region 152 may be lower than that of the second contact 151 and may be similar to or higher than the doping concentration of the sixth well 153. The conductivity type of the second relief region 152 may be n-type. For example, the doping concentration of the second relief region 152 may be 1x10¹⁵ to 5x10¹⁷ cm⁻³.

The device isolation pattern 104 may be provided on the side surface of the second relief region 152. The device isolation pattern 104 may be exposed on the front side 100a. On the front side 100a, the device isolation pattern 104 may surround the second relief region 152. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1720 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the second relief region 152 and the substrate region 102 as well as the buried region 110. In another example, the device isolation pattern 104 may be formed to contact the first contact 121. In another example, the single-photon avalanche diode (SPAD) 1720 may not include a device isolation pattern 104. Each region may have a conductivity type opposite to the conductivity type described above. For example, regions described as having n-type may have a p-type, and regions described as having p-type may have n-type.

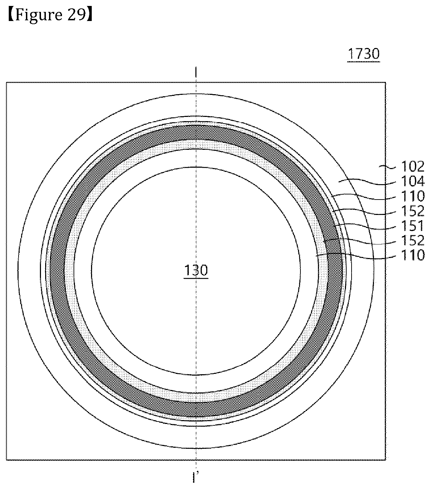

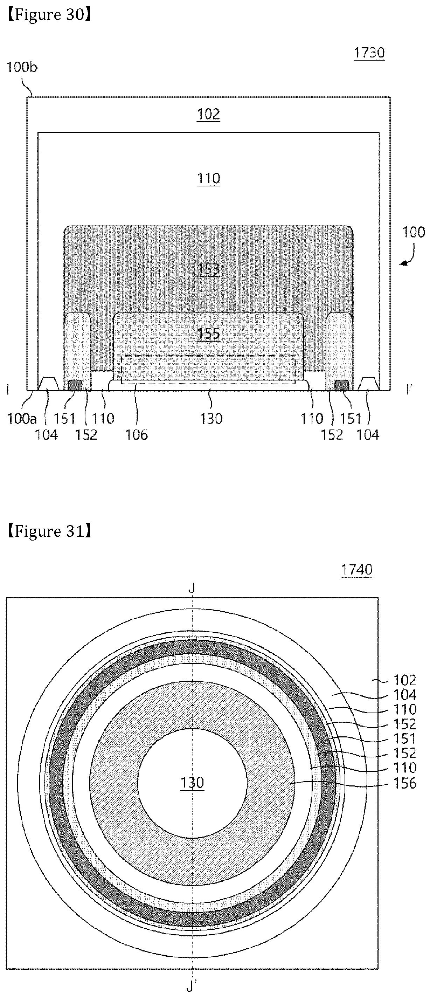

FIG. 29 is a plan view of a single-photon avalanche diode (SPAD) according to example embodiments. FIG. 30 is a cross-sectional view of the single-photon avalanche diode (SPAD) of FIG. 29 taken along line I-I'.

Referring to FIGS. 29 and 30, a single-photon avalanche diode (SPAD) 1730 may be provided. The single-photon avalanche diode (SPAD) 1730 may be referred to as a Geiger-mode Avalanche diode (Geiger-mode APD, G-APD). The single-photon avalanche diode (SPAD) 1730 may include a buried region 110, a sixth well 153, a second heavily doped region 130, an eighth well 155, a second contact 151, a second relief region 152, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the sixth well 153, the second heavily doped region 130, the the eighth well 155, the second contact 151, and the second relief region 152 may be formed by implanting impurities into the semiconductor substrate 100. In the semiconductor substrate 100, the buried region 110, the sixth well 153, the second heavily doped region 130, the the eighth well 155, the second contact 151, and the second relief region 152 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The sixth well 153 may be provided in the semiconductor substrate 100. The buried region 110 may be disposed between the sixth well 153 and the back side 100b. The upper and side surfaces of the sixth well 153 may be in direct contact with the buried region 110. The conductivity type of the sixth well 153 may be n-type. The sixth well 153 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the sixth well 153 may be 1x10¹⁵ ~ 1x10¹⁸ cm⁻³. In one example, the sixth well 153 may have a uniform doping concentration. In one example, the doping concentration of the sixth well 153 may be smaller as it is closer to the front side 100a of the single-photon avalanche diode (SPAD) 1100.

The second heavily doped region 130 may be configured to form a depletion region 106. The size of the depletion region 106 is shown as an example and is not limited. When reverse bias is applied to the single-photon avalanche diode (SPAD) 1730, a strong electric field may be formed in the depletion region 106. For example, the maximum strength of the electric field may be about 3x10⁵ ~ 1x10⁶ V / cm. Since electrons may be multiplied by the electric field of the depletion region 106, the depletion region 106 may be referred to as the multiplication region. The second heavily doped region 130 may be provided between the sixth well 153 and the front side 100a. The second heavily doped region 130 may be exposed on the front side 100a. The conductivity type of the second heavily doped region 130 may be p-type. For example, the doping concentration of the second heavily doped region 130 may be 1x10¹⁵ ~ 2x10²⁰ cm⁻³. In one example, the second heavily doped region 130 may be electrically connected to at least one of an external power supply, a DC-to-DC converter, and other power management integrated circuits. In one example, the second heavily doped region 130 may be electrically connected to at least one of a quenching resistor (or quenching circuit) and other pixel circuits. A quenching resistor or quenching circuitry may be configured to stop the avalanche effect and allow the single photon avalanche diode (SPAD) 1730 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1730 or receive signals from the single-photon avalanche diode (SPAD) 1730.

The eighth well 155 may be provided between the second heavily doped region 130 and the sixth well 153. The eighth well 155 may be provided on the top surface of the eighth well 155. The conductivity type of the eighth well 155 may be n-type. For example, the doping concentration of the eighth well 155 may be 1x10¹⁵ to 5x10¹⁷ cm⁻³.

The buried region 110 may be further provided on the side surface of the second heavily doped region 130 and the eighth well 155. The buried region 110 may surround the second heavily doped region 130 and the eighth well 155. For example, the buried region 110 may have a ring shape extending along the sides of the second heavlily doped region 130 and the eighth well 155. The buried region 110 may directly contact the second heavily doped region 130 and the eighth well 155.

The second contact 151 may be provided on the opposite side of the second heavily doped region 130 with the buried region 110 interposed therebetween. The second contact 151 may be exposed on the front side 100a. On the front side 100a, the second contact 151 may surround the buried region 110. In another example, a plurality of second contacts 151 may be provided. In this case, the plurality of second contacts 151 may be electrically connected to circuits outside the single-photon avalanche diode (SPAD) 1730, respectively. The conductivity type of the second contact 151 may be a n-type. The doping concentration of the second contact 151 may be higher than the doping concentration of the sixth well 153. For example, the doping concentration of the second contact 151 may be 1x10¹⁵ ~ 2x10²⁰ cm⁻³. In one example, the second contact 151 may be electrically connected to at least one of an external power supply, a DC-to-DC converter, and other power management integrated circuits. In one example, the second contact 151 may be electrically connected to at least one of a quenching resistor (or quenching circuit) and other pixel circuits.

The second relief region 152 may be provided between the second contact 151 and the sixth well 153. The second relief region 152 may be electrically connected to the second contact 151 and the sixth well 153. The second relief region 152 may relieve the difference between the second contact 151 and the sixth well 153. The second relief region 152 may be extended along the second contact 151. The second relief region 152 may be provided on the side and top surfaces of the second contact 151. For example, the second relief region 152 may be in direct contact with the side and top surfaces of the second contact 151. The top and one side surfaces of the second relief region 152 may contact the sixth well 153. The other side of the second relief region 152 may be exposed by the sixth well 153 and may contact the buried region 110. The second relief region 152 may be exposed on the front side 100a. On the front side 100a, the second relief region 152 may surround the buried region 110. The second relief region 152 may be spaced apart from the buried region 110. The sixth well 153 may extend between the second relief region 152 and the buried region 110. The sixth well 153 may not be provided in a region adjacent to the front side 100a. A region adjacent to the front side 100a between the second relief region 152 and the eighth well 155 may be filled with the buried region 110. The second relief region 152 may extend along a direction from the front side 100a to the back side 100b. The distance between the second relief region 152 and the back side 100b may be smaller than the distance between the buried region 110 on the side surface of the second heavily doped region 130 and the back side 100b. The doping concentration of the second relief region 152 may be lower than that of the second contact 151 and may be similar to or higher than the doping concentration of the sixth well 153. The conductivity type of the second relief region 152 may be n-type. For example, the doping concentration of the second relief region 152 may be 1x10¹⁵ to 5x10¹⁷ cm⁻³.

The device isolation pattern 104 may be provided on the side surface of the second relief region 152. The device isolation pattern 104 may be exposed on the front side 100a. On the front side 100a, the device isolation pattern 104 may surround the second relief region 152. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1730 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the second relief region 152 and the substrate region 102 as well as the buried region 110. In another example, the device isolation pattern 104 may be formed to contact the first contact 121. In another example, the single-photon avalanche diode (SPAD) 1730 may not include a device isolation pattern 104. Each region may have a conductivity type opposite to the conductivity type described above. For example, regions described as having n-type may have a p-type, and regions described as having p-type may have n-type.

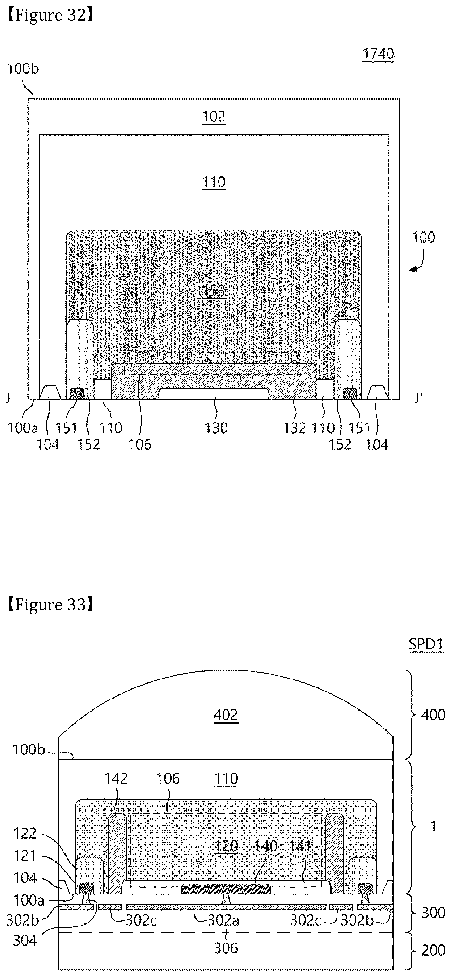

FIG. 31 is a plan view of a single-photon avalanche diode (SPAD) according to example embodiments. FIG. 32 is a cross-sectional view of the single-photon avalanche diode (SPAD) of FIG. 31 taken along line J-J'.

Referring to FIGS. 31 and 32, a single-photon avalanche diode (SPAD) 1740 may be provided. The single-photon avalanche diode (SPAD) 1740 may be referred to as a Geiger-mode Avalanche diode (Geiger-mode APD, G-APD). The single-photon avalanche diode (SPAD) 1740 may include a buried region 110, a sixth well 153, a second heavily doped region 130, a seventh well 132, a second contact 151, a second relief region 152, and a device isolation pattern 104. The semiconductor substrate 100 may be an epi layer formed by an epitaxial growth process. For example, the semiconductor substrate 100 may be a silicon substrate. The conductivity type of the semiconductor substrate 100 may be a p-type. However, the conductivity type of the semiconductor substrate 100 is not limited to the p type. In another example, the conductivity type of the semiconductor substrate 100 may be n-type. The semiconductor substrate 100 may include a front side 100a and a back side 100b facing opposite directions. For example, the buried region 110, the sixth well 153, the second heavily doped region 130, the seventh well 132, the second contact 151, and the second relief region 152 may be formed by implanting impurities into the semiconductor substrate 100. In the semiconductor substrate 100, the buried region 110, the sixth well 153, the second heavily doped region 130, the seventh well 132, the second contact 151, and the second relief region 152 may be referred to as the substrate region 102.

The buried region 110 may be provided to extend from the front side 100a to the region adjacent to the back side 100b. The upper and side surfaces of the buried region 110 may contact the substrate region 102. For example, the conductivity type of the buried region 110 may be a p-type. The buried region 110 may include group 3 elements (e.g., boron (B), aluminum (Al), gallium (Ga), indium (In, etc.) or group 2 element as impurities. Hereinafter, a region with a p-type conductivity may include group 3 or group 2 elements with impurities. For example, the doping concentration of the buried region 110 may be 1x10¹⁴ ~ 1x10¹⁸ cm-³. In one example, the buried region 110 may have a uniform doping concentration. In one example, the doping concentration of the buried region 110 may be smaller as it is closer to the front side 100a.

The sixth well 153 may be provided in the semiconductor substrate 100. The buried region 110 may be disposed between the sixth well 153 and the back side 100b. The upper and side surfaces of the sixth well 153 may be in direct contact with the buried region 110. The conductivity type of the sixth well 153 may be n-type. The sixth well 153 may include group 5 elements (e.g., phosphorus (P), arsenic (As), antimony (Sb), etc.), group 6, or group 7 elements as impurities. Hereinafter, the region with a n-type conductivity may contain impurities of group 5, group 6, or group 7 elements. For example, the doping concentration of the sixth well 153 may be 1x10¹⁵ ~ 1x10¹⁸ cm⁻³. In one example, the sixth well 153 may have a uniform doping concentration. In one example, the doping concentration of the sixth well 153 may be smaller as it is closer to the front side 100a of the single-photon avalanche diode (SPAD) 1100.

The second heavily doped region 130 may be provided between the sixth well 153 and the front side 100a. The second heavily doped region 130 may be exposed on the front side 100a. The conductivity type of the second heavily doped region 130 may be p-type. For example, the doping concentration of the second heavily doped region 130 may be 1x10¹⁵ ~ 2x10²⁰ cm⁻³. In one example, the second heavily doped region 130 may be electrically connected to at least one of an external power supply, a DC-to-DC converter, and other power management integrated circuits. In one example, the second heavily doped region 130 may be electrically connected to at least one of a quenching resistor (or quenching circuit) and other pixel circuits. A quenching resistor or quenching circuitry may be configured to stop the avalanche effect and allow the single photon avalanche diode (SPAD) 1740 to detect another photon. Other pixel circuits may include, for example, reset or recharge circuits, memories, amplifier circuits, counters, gate circuits, time-to-digital converters, and the like. Other pixel circuits may transmit signals to the single-photon avalanche diode (SPAD) 1740 or receive signals from the single-photon avalanche diode (SPAD) 1740.

The seventh well 132 may be configured to form a depletion region 106. The size of the depletion region 106 is shown as an example and is not limiting. When a reverse bias is applied to the single-photon avalanche diode 1740, a strong electric field may be formed in the depletion region 106. For example, the maximum magnitude of the electric field may be about 3x10⁵ to 1x10⁶ V/cm. Since electrons may be multiplied by the electric field of the depletion region 106, the depletion region 106 may be referred to as a multiplication region. The seventh well 132 may be provided between the second heavily doped region 130 and the sixth well 153. The seventh well 132 may contact the top and side surfaces of the second heavily doped region 130. The seventh well 132 may be exposed on the front side 100a. On the front side 100a, the seventh well 132 may surround the second heavily doped region 130. The conductivity type of the seventh well 132 may be p-type. For example, the doping concentration of the seventh well 132 may be 1x10¹⁵ to 5x10¹⁷ cm⁻³.

A buried region 110 may be further provided on the side of the seventh well 132. The buried region 110 may surround the seventh well 132. For example, the buried region 110 may have a ring shape extending along the side of the eighth well 155. The buried region 110 may directly contact the eighth well 155.

The second contact 151 may be provided on the opposite side of the second heavily doped region 130 with the buried region 110 interposed therebetween. The second contact 151 may be exposed on the front side 100a. On the front side 100a, the second contact 151 may surround the buried region 110. In another example, a plurality of second contacts 151 may be provided. In this case, the plurality of second contacts 151 may be electrically connected to circuits outside the single-photon avalanche diode (SPAD) 1740, respectively. The conductivity type of the second contact 151 may be a n-type. The doping concentration of the second contact 151 may be higher than the doping concentration of the sixth well 153. For example, the doping concentration of the second contact 151 may be 1x10¹⁵ ~ 2x10²⁰ cm⁻³. In one example, the second contact 151 may be electrically connected to at least one of an external power supply, a DC-to-DC converter, and other power management integrated circuits. In one example, the second contact 151 may be electrically connected to at least one of a quenching resistor (or quenching circuit) and other pixel circuits.

The second relief region 152 may be provided between the second contact 151 and the sixth well 153. The second relief region 152 may be electrically connected to the second contact 151 and the sixth well 153. The second relief region 152 may relieve the difference between the second contact 151 and the sixth well 153. The second relief region 152 may be extended along the second contact 151. The second relief region 152 may be provided on the side and top surfaces of the second contact 151. For example, the second relief region 152 may be in direct contact with the side and top surfaces of the second contact 151. The top and one side surfaces of the second relief region 152 may contact the sixth well 153. The other side of the second relief region 152 may be exposed by the sixth well 153 and may contact the buried region 110. The second relief region 152 may be exposed on the front side 100a. On the front side 100a, the second relief region 152 may surround the buried region 110. The second relief region 152 may be spaced apart from the buried region 110. The sixth well 153 may extend between the second relief region 152 and the seventh well 132. The sixth well 153 may not be provided in a region adjacent to the front side 100a. A region adjacent to the front side 100a between the second relief region 152 and the seventh well 132 may be filled with the buried region 110. The second relief region 152 may extend along a direction from the front side 100a to the back side 100b. The distance between the second relief region 152 and the back side 100b may be smaller than the distance between the buried region 110 on the side surface of the second heavily doped region 130 and the back side 100b. The doping concentration of the second relief region 152 may be lower than that of the second contact 151 and may be similar to or higher than the doping concentration of the sixth well 153. The conductivity type of the second relief region 152 may be n-type. For example, the doping concentration of the second relief region 152 may be 1x10¹⁵ to 5x10¹⁷ cm⁻³.

The device isolation pattern 104 may be provided on the side surface of the second relief region 152. The device isolation pattern 104 may be exposed on the front side 100a. On the front side 100a, the device isolation pattern 104 may surround the second relief region 152. The device isolation pattern 104 may be formed, for example, by filling an insulating material in a recess region formed by etching the semiconductor substrate 100. For example, the device isolation pattern 104 may be Shallow Trench Isolation (STI). The device isolation pattern 104 may electrically separate the single-photon avalanche diode (SPAD) 1740 and other semiconductor devices (e.g., other single-photon avalanche diode (SPAD)s). The device isolation pattern 104 is shown to contact only the buried region 110, but this is illustrative. In another example, the device isolation pattern 104 may be formed to contact the second relief region 152 and the substrate region 102 as well as the buried region 110. In another example, the device isolation pattern 104 may be formed to contact the first contact 121. In another example, the single-photon avalanche diode (SPAD) 1740 may not include a device isolation pattern 104. Each region may have a conductivity type opposite to the conductivity type described above. For example, regions described as having n-type may have a p-type, and regions described as having p-type may have n-type.

FIG. 33 is a cross-sectional view of a single-photon detector according to an example embodiment. For brevity of explanation, content substantially the same as that described with reference to FIGS. 1 and 2 may not be described.

Referring to FIG. 33, a single photon detector SPD1 may be provided. The single-photon detector SPD1 may include a single-photon avalanche diode 1, a control layer 200, a connection layer 300, and a lens unit 400. The single photon detector SPD1 may be a back side illumination (BSI) type image sensor. The frontside may be a side on which various semiconductor processes are performed when manufacturing the single-photon avalanche diode 1, and the backside may be a side disposed opposite to the front side. For example, the top and bottom surfaces of the single-photon avalanche diodes 1000 to 1900 of the present disclosure may be the front side 100a and the back side 100b, respectively. The back side illumination type may refer to light entering the back side 100b of the single-photon avalanche diode 1. The front side illumination type described later may refer to light entering the front side of the single-photon avalanche diode 1. The single-photon avalanche diode 1 may be substantially the same as the single-photon avalanche diode 1000 described with reference to FIGS. 1 and 2. In another example, single-photon avalanche diode 1 may be any one of the single-photon avalanche diodes 1100 to 1900 described above. For convenience of explanation, the single-photon avalanche diode 1 is shown with the top and bottom of the single-photon avalanche diode 1000 shown in FIG. 2 reversed. Accordingly, the top and bottom surfaces of the single-photon avalanche diode 1 may be the back side 100b and the front side 100a, respectively.

The control layer 200 may be provided on the front side of the single-photon avalanche diode 1. The control layer 200 may include a circuitry necessary for operation of the single-photon avalanche diode 1. For example, the control layer 200 may be a chip on which a circuitry is formed. The circuitry may be implemented by various electronic devices as needed. The circuitry may include a quenching resistor (or quenching circuitry) and a pixel circuitry. A quenching resistor (or quenching circuitry) may be configured to stop the avalanche effect and allow the single-photon avalanche diode 1 to detect another photon. The pixel circuitry may be composed of a reset or recharge circuitry, memory, amplifier circuitry, counter, gate circuitry, time-to-digital converter, etc. Additionally, the circuitry may include a DC-to-DC converter and other power management integrated circuitrys. The circuitry may transmit a signal to the single-photon avalanche diode 1 or receive a signal from the single-photon avalanche diode 1.

The connection layer 300 may be provided between the single-photon avalanche diode 1 and the control layer 200. The connection layer 300 may include an insulating layer 306, an output pattern 302a, a bias pattern 302b, a shield pattern 302c, and a vertical connection portion 304. For example, the insulating layer 306 may include silicon oxide (e.g., SiO2), silicon nitride (e.g., SiN), silicon oxynitride (e.g., SiON), or combinations thereof.. For example, the vertical connection portion 304 may include a contact or via.

The output pattern 302a may be electrically connected to the first heavily doped region 140. The output pattern 302a may include an electrically conductive material. For example, the output pattern 302a may include copper (Cu), aluminum (Al), tungsten (W), titanium (Ti), titanium nitride (TiN), or a combination thereof. The output pattern 302a may electrically connect the first heavily doped region 140 and the circuitry of the control layer 200. For example, a vertical connection 304 may be provided between the first heavily doped region 140 and the output pattern 302a, and Cu-Cu bonding may be provided between the output pattern 302a and the control layer 200. there is. The output pattern 302a may be configured to extract a detection signal from the single-photon avalanche diode 1.

The bias pattern 302b may be electrically connected to the first contact 121. Bias pattern 302b may include an electrically conductive material. For example, the bias pattern 302b may include copper (Cu), aluminum (Al), tungsten (W), titanium (Ti), titanium nitride (TiN), or a combination thereof. The bias pattern 302b may electrically connect the first contact 121 and the circuitry of the control layer 200. For example, a vertical connection 304 may be provided between the first contact 121 and the bias pattern 302b, and Cu-Cu bonding may be provided between the bias pattern 302b and the control layer 200. The bias pattern 302b may be configured to apply a bias to the single-photon avalanche diode 1.

The shield pattern 302c may electrically shield between the output pattern 302a and the bias pattern 302b. For example, the shield pattern 302c may be configured so that the detection signal extracted by the output pattern 302a is not affected by the bias signal applied to the bias pattern 302b. The shield pattern 302c may be electrically separated from the output pattern 302a and the bias pattern 302b. For example, the shield pattern 302c may be spaced apart from the output pattern 302a and the bias pattern 302b.

The output pattern 302a, bias pattern 302b, and shield pattern 302c may serve as a reflective layer. Light that is not absorbed in the single-photon avalanche diode 1 is reflected by the output pattern 302a, bias pattern 302b, and shield pattern 302c, and may be incident again on the single-photon avalanche diode 1. Accordingly, the light absorption efficiency of the single-photon avalanche diode 1 may be improved.

The lens unit 400 may be provided on the back side 100b of the single-photon avalanche diode 1. The lens unit 400 may include a lens 402. The lens 402 may focus the incident light and deliver it to the single-photon avalanche diode 1. For example, the lens 402 may include a microlens, a Fresnel lens, or a metalens. However, the type of lens 402 is not limited and may be determined as needed. In one example, the central axis of lens 402 may be aligned with the central axis of the single-photon avalanche diode 1. The central axis of the lens 402 and the central axis of the single-photon avalanche diode 1 may pass through the center of the lens 402 and the center of the single-photon avalanche diode 1, respectively, and may be a virtual axis parallel to the stacking direction of the single-photon avalanche diode 1 and the lens 402. In one example, the central axis of the lens 402 may be aligned misaligned with the central axis of the single-photon avalanche diode 1. In one embodiment, the width of the lens 402 is about half the width of the single-photon avalanche diode 1 and may be implemented in a 2x2 shape. In one embodiment, at least one optical element may be inserted between lens 402 and single-photon avalanche diode 1. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

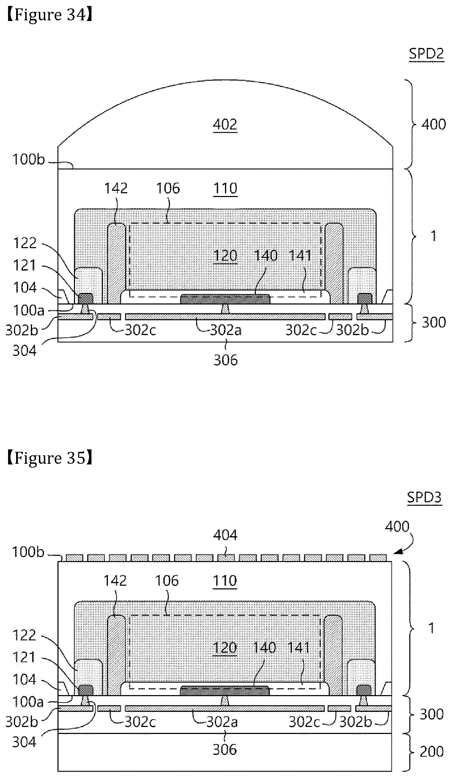

FIG. 34 is a cross-sectional view of a single-photon detector according to an example embodiment. For brevity of explanation, content substantially the same as that described with reference to FIGS. 1 and 2 may not be described.

Referring to FIG. 34, a single photon detector SPD2 may be provided. The single-photon detector SPD2 may include a single-photon avalanche diode 1, a connection layer 300, and a lens unit 400. The single photon detector SPD2 may be a back side illumination (BSI) type image sensor. The single-photon avalanche diode 1 may be substantially the same as the single-photon avalanche diode 1000 described with reference to FIGS. 1 and 2. In another example, single-photon avalanche diode 1 may be any one of the single-photon avalanche diodes 1100 to 1900 described above. For convenience of explanation, the single-photon avalanche diode 1 is shown with the top and bottom of the single-photon avalanche diode 1000 shown in FIG. 2 reversed. Accordingly, the top and bottom surfaces of the single-photon avalanche diode 1 may be the back side 100b and the front side 100a, respectively.

The single-photon avalanche diode 1 may include circuitry necessary for operation of the single-photon avalanche diode 1 in a region adjacent to the front side 100a. The circuitry may be implemented by various electronic devices as needed. The circuitry may include a quenching resistor (or quenching circuitry) and a pixel circuitry. A quenching resistor (or quenching circuitry) may be configured to stop the avalanche effect and allow the single-photon avalanche diode 1 to detect another photon. The pixel circuitry may be composed of a reset or recharge circuitry, memory, amplifier circuitry, counter, gate circuitry, time-to-digital converter, etc. Additionally, the circuitry may include a DC-to-DC converter and other power management integrated circuitrys. The circuitry may transmit a signal to the single-photon avalanche diode 1 or receive a signal from the single-photon avalanche diode 1.

The connection layer 300 may be provided on the front side 100a of the single-photon avalanche diode 1. The connection layer 300 may include an insulating layer 306, an output pattern 302a, a bias pattern 302b, a shield pattern 302c, and a vertical connection portion 304. For example, the insulating layer 306 may include silicon oxide (e.g., SiO2), silicon nitride (e.g., SiN), silicon oxynitride (e.g., SiON), or combinations thereof.. For example, the vertical connection portion 304 may include a contact or via.

The output pattern 302a may be electrically connected to the first heavily doped region 140. The output pattern 302a may include an electrically conductive material. For example, the output pattern 302a may include copper (Cu), aluminum (Al), tungsten (W), titanium (Ti), titanium nitride (TiN), or a combination thereof. The output pattern 302a may electrically connect the first heavily doped region 140 and the circuitry included in the the single-photon avalanche diode 1. For example, a vertical connection 304 may be provided between the first heavily doped region 140 and the output pattern 302a and between the output pattern 302a and the circuitry. The output pattern 302a may be configured to extract a detection signal from the single-photon avalanche diode 1.

The bias pattern 302b may be electrically connected to the first contact 121. Bias pattern 302b may include an electrically conductive material. For example, the bias pattern 302b may include copper (Cu), aluminum (Al), tungsten (W), titanium (Ti), titanium nitride (TiN), or a combination thereof. The bias pattern 302b may electrically connect the first contact 121 and the circuitry included in the the single-photon avalanche diode 1. For example, a vertical connection 304 may be provided between the first contact 121 and the bias pattern 302b and between the bias pattern 302b and the circuitry. The bias pattern 302b may be configured to apply a bias to the single-photon avalanche diode 1.

The shield pattern 302c may electrically shield between the output pattern 302a and the bias pattern 302b. For example, the shield pattern 302c may be configured so that the detection signal extracted by the output pattern 302a is not affected by the bias signal applied to the bias pattern 302b.

The output pattern 302a, bias pattern 302b, and shield pattern 302c may serve as a reflective layer. Light that is not absorbed in the single-photon avalanche diode 1 is reflected by the output pattern 302a, bias pattern 302b, and shield pattern 302c, and may be incident again on the single-photon avalanche diode 1. Accordingly, the light absorption efficiency of the single-photon avalanche diode 1 may be improved.

The lens unit 400 may be provided on the back side 100b of the single-photon avalanche diode 1. The lens unit 400 may include a lens 402. The lens 402 may focus the incident light and deliver it to the single-photon avalanche diode 1. For example, the lens 402 may include a microlens, a Fresnel lens, or a metalens. However, the type of lens 402 is not limited and may be determined as needed. In one example, the central axis of lens 402 may be aligned with the central axis of the single-photon avalanche diode 1. The central axis of the lens 402 and the central axis of the single-photon avalanche diode 1 may pass through the center of the lens 402 and the center of the single-photon avalanche diode 1, respectively, and may be a virtual axis parallel to the stacking direction of the single-photon avalanche diode 1 and the lens 402. In one example, the central axis of the lens 402 may be aligned misaligned with the central axis of the single-photon avalanche diode 1. In one embodiment, the width of the lens 402 is about half the width of the single-photon avalanche diode 1 and may be implemented in a 2x2 shape. In one embodiment, at least one optical element may be inserted between lens 402 and single-photon avalanche diode 1. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

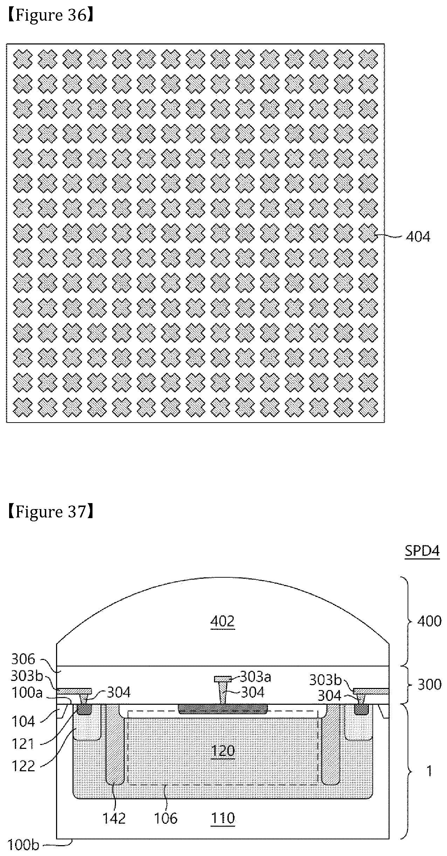

FIG. 35 is a cross-sectional view of a single-photon detector according to an example embodiment. FIG. 36 is a top view of the first diffraction pattern of FIG. 35. For brevity of explanation, content substantially the same as that described with reference to FIGS. 1 and 2 may not be described.

Referring to FIG. 35, a single photon detector SPD3 may be provided. The single-photon detector SPD3 may include a single-photon avalanche diode 1, a control layer 200, a connection layer 300, and a lens unit 400. The single photon detector SPD3 may be a back side illumination (BSI) type image sensor. The frontside may be a side on which various semiconductor processes are performed when manufacturing the single-photon avalanche diode 1, and the backside may be a side disposed opposite to the front side. For example, the top and bottom surfaces of the single-photon avalanche diodes 1000 to 1900 of the present disclosure may be the front side 100a and the back side 100b, respectively. The back side illumination type may refer to light entering the back side 100b of the single-photon avalanche diode 1. The front side illumination type described later may refer to light entering the front side of the single-photon avalanche diode 1. The single-photon avalanche diode 1 may be substantially the same as the single-photon avalanche diode 1000 described with reference to FIGS. 1 and 2. In another example, single-photon avalanche diode 1 may be any one of the single-photon avalanche diodes 1100 to 1900 described above. For convenience of explanation, the single-photon avalanche diode 1 is shown with the top and bottom of the single-photon avalanche diode 1000 shown in FIG. 2 reversed. Accordingly, the top and bottom surfaces of the single-photon avalanche diode 1 may be the back side 100b and the front side 100a, respectively.

The control layer 200 may be provided on the front side of the single-photon avalanche diode 1. The control layer 200 may include a circuitry necessary for operation of the single-photon avalanche diode 1. For example, the control layer 200 may be a chip on which a circuitry is formed. The circuitry may be implemented by various electronic devices as needed. The circuitry may include a quenching resistor (or quenching circuitry) and a pixel circuitry. A quenching resistor (or quenching circuitry) may be configured to stop the avalanche effect and allow the single-photon avalanche diode 1 to detect another photon. The pixel circuitry may be composed of a reset or recharge circuitry, memory, amplifier circuitry, counter, gate circuitry, time-to-digital converter, etc. Additionally, the circuitry may include a DC-to-DC converter and other power management integrated circuitrys. The circuitry may transmit a signal to the single-photon avalanche diode 1 or receive a signal from the single-photon avalanche diode 1.

The connection layer 300 may be provided between the single-photon avalanche diode 1 and the control layer 200. The connection layer 300 may include an insulating layer 306, an output pattern 302a, a bias pattern 302b, a shield pattern 302c, and a vertical connection portion 304. For example, the insulating layer 306 may include silicon oxide (e.g., SiO2), silicon nitride (e.g., SiN), silicon oxynitride (e.g., SiON), or combinations thereof.. For example, the vertical connection portion 304 may include a contact or via.

The output pattern 302a may be electrically connected to the first heavily doped region 140. The output pattern 302a may include an electrically conductive material. For example, the output pattern 302a may include copper (Cu), aluminum (Al), tungsten (W), titanium (Ti), titanium nitride (TiN), or a combination thereof. The output pattern 302a may electrically connect the first heavily doped region 140 and the circuitry of the control layer 200. For example, a vertical connection 304 may be provided between the first heavily doped region 140 and the output pattern 302a, and Cu-Cu bonding may be provided between the output pattern 302a and the control layer 200. there is. The output pattern 302a may be configured to extract a detection signal from the single-photon avalanche diode 1.

The bias pattern 302b may be electrically connected to the first contact 121. Bias pattern 302b may include an electrically conductive material. For example, the bias pattern 302b may include copper (Cu), aluminum (Al), tungsten (W), titanium (Ti), titanium nitride (TiN), or a combination thereof. The bias pattern 302b may electrically connect the first contact 121 and the circuitry of the control layer 200. For example, a vertical connection 304 may be provided between the first contact 121 and the bias pattern 302b, and Cu-Cu bonding may be provided between the bias pattern 302b and the control layer 200. The bias pattern 302b may be configured to apply a bias to the single-photon avalanche diode 1.

The shield pattern 302c may electrically shield between the output pattern 302a and the bias pattern 302b. For example, the shield pattern 302c may be configured so that the detection signal extracted by the output pattern 302a is not affected by the bias signal applied to the bias pattern 302b.

The output pattern 302a, bias pattern 302b, and shield pattern 302c may serve as a reflective layer. Light that is not absorbed in the single-photon avalanche diode 1 is reflected by the output pattern 302a, bias pattern 302b, and shield pattern 302c, and may be incident again on the single-photon avalanche diode 1. Accordingly, the light absorption efficiency of the single-photon avalanche diode 1 may be improved.

The lens unit 400 may be provided on the back side 100b of the single-photon avalanche diode 1. Referring to FIG. 36 , the lens unit 400 may include first diffraction patterns 404. The first diffraction patterns 404 may diffract incident light and increase the absorption length of light within the single-photon avalanche diode 1. In another example, scattering patterns may be provided on the back side 100b of the single-photon avalanche diode 1 instead of the first diffraction patterns 404. Scattering patterns may be, for example, cross or X shaped patterns. In another example, the scattering patterns may be a combination of a cross and an x shape, or patterns of each shape connected together. The light absorption efficiency of the single-photon avalanche diode 1 may be improved by the lens unit 400. In one embodiment, at least one optical element may be inserted between the first diffraction patterns 404 and the single-photon avalanche diode 1. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

FIG. 37 is a cross-sectional view of a single-photon detector according to an example embodiment. For brevity of explanation, content substantially the same as that described with reference to FIGS. 1 and 2 may not be described.

Referring to FIG. 37, a single photon detector SPD4 may be provided. The single-photon detector SPD4 may include a single-photon avalanche diode 1, a control layer 200, a connection layer 300, and a lens unit 400. The single photon detector SPD4 may be a front side illumination (FSI) type image sensor. The single-photon avalanche diode 1 may be substantially the same as the single-photon avalanche diode 1000 described with reference to FIGS. 1 and 2. In another example, single-photon avalanche diode 1 may be any one of the single-photon avalanche diodes 1100 to 1900 described above. The top and bottom surfaces of the single-photon avalanche diode 1 may be the front side 100a and the back side 100b, respectively.

The single-photon avalanche diode 1 may include circuitry necessary for operation of the single-photon avalanche diode 1 in a region adjacent to the front side 100a. The circuitry may be implemented by various electronic devices as needed. The circuitry may include a quenching resistor (or quenching circuitry) and a pixel circuitry. A quenching resistor (or quenching circuitry) may be configured to stop the avalanche effect and allow the single-photon avalanche diode 1 to detect another photon. The pixel circuitry may be composed of a reset or recharge circuitry, memory, amplifier circuitry, counter, gate circuitry, time-to-digital converter, etc. Additionally, the circuitry may include a DC-to-DC converter and other power management integrated circuitrys. The circuitry may transmit a signal to the single-photon avalanche diode 1 or receive a signal from the single-photon avalanche diode 1.

The connection layer 300 may be provided on the front side 100a of the single-photon avalanche diode 1. The connection layer 300 may include an insulating layer 306, an output conductive line 303a, a bias conductive line 303b, and a vertical connection portion 304. For example, the insulating layer 306 may include silicon oxide (e.g., SiO2), silicon nitride (e.g., SiN), silicon oxynitride (e.g., SiON), or combinations thereof. For example, the vertical connection portion 304 may include a contact or via.

The output conductive line 303a may be electrically connected to the first heavily doped region 140. The output conductive line 303a may include an electrically conductive material. For example, the output conductive line 303a may include copper (Cu), aluminum (Al), tungsten (W), titanium (Ti), titanium nitride (TiN), or a combination thereof. The output conductive line 303a may electrically connect the first heavily doped region 140 and the circuitry included in the single-photon avalanche diode 1. For example, a vertical connection 304 may be provided between the first heavily doped region 140 and the output conductive line 303a and between output conductive line 303a and the circuitry. The output conductive line 303a may be configured to extract a detection signal from the single-photon avalanche diode 1.

The bias conductive line 303b may be electrically connected to the first contact 121. The bias conductive line 303b may include an electrically conductive material. For example, the bias conductive line 303b may include copper (Cu), aluminum (Al), tungsten (W), titanium (Ti), titanium nitride (TiN), or a combination thereof. The bias conductive line 303b may electrically connect the first contact 121 and the circuitry included in the single-photon avalanche diode 1. For example, a vertical connection 304 may be provided between the first contact 121 and the bias conductive line 303b and between the bias conductive line 303b and the circuitry. The bias conductive line 303b may be configured to apply a bias to the single-photon avalanche diode 1.

The lens unit 400 may be provided on the connection layer 300. The lens unit 400 may be provided on the opposite side of the single-photon avalanche diode 1 with the connection layer 300 interposed therebetween. The lens unit 400 may include a lens 402. The lens 402 may focus the incident light and deliver it to the single-photon avalanche diode 1. For example, the lens 402 may include a microlens, a Fresnel lens, or a metalens. However, the type of lens 402 is not limited and may be determined as needed. In one example, the central axis of lens 402 may be aligned with the central axis of the single-photon avalanche diode 1. The central axis of the lens 402 and the central axis of the single-photon avalanche diode 1 may pass through the center of the lens 402 and the center of the single-photon avalanche diode 1, respectively, and may be a virtual axis parallel to the stacking direction of the single-photon avalanche diode 1 and the lens 402. In one example, the central axis of the lens 402 may be aligned misaligned with the central axis of the single-photon avalanche diode 1. In one embodiment, the width of the lens 402 is about half the width of the single-photon avalanche diode 1 and may be implemented in a 2x2 shape. In one embodiment, at least one optical element may be inserted between lens 402 and single-photon avalanche diode 1. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

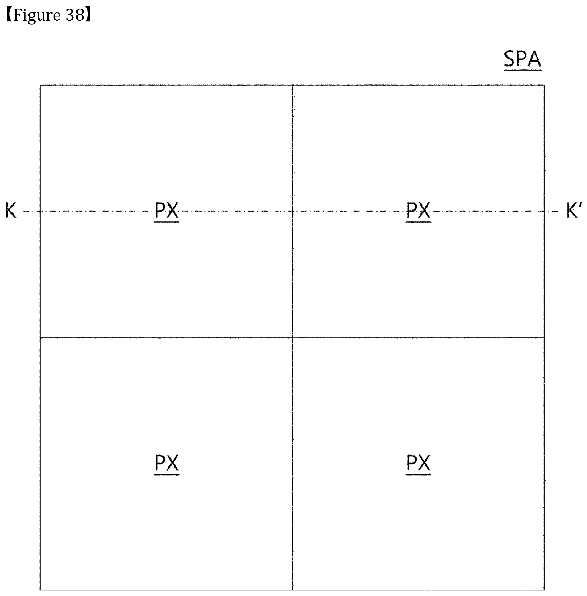

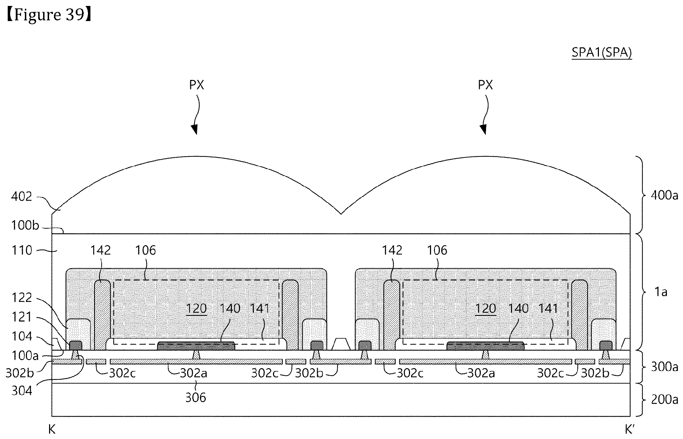

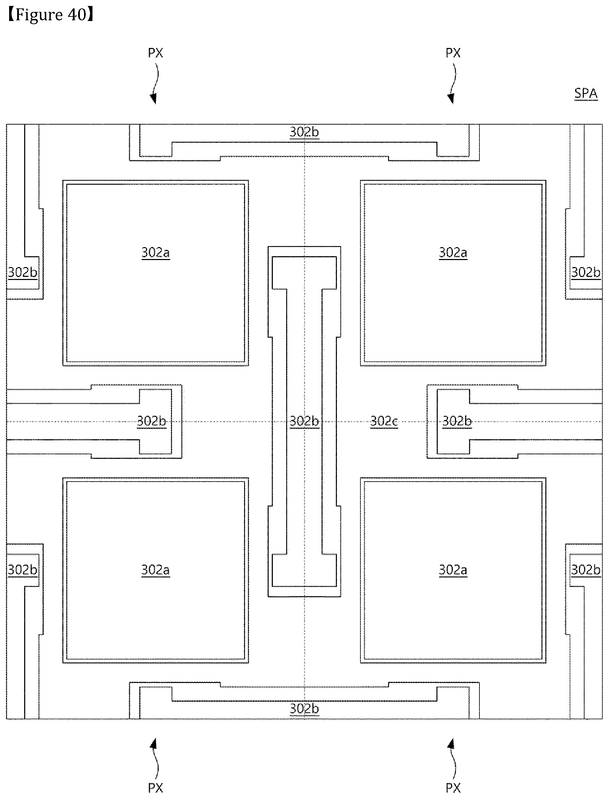

FIG. 38 is a top view of a single-photon detector array according to an example embodiment. FIG. 39 is a cross-sectional view taken along line K-K' of FIG. 38. FIG. 40 is a top view of the output pattern, the bias pattern, and the shield pattern of FIG. 39. For brevity of explanation, content substantially the same as that described with reference to FIG. 33 may not be described.

FIGS. 38 and 39, a single-photon detector array SPA1(SPA) may be provided. The single-photon detector array SPA1(SPA) may include pixels PX arranged in two dimensions. Each of the pixels PX may include a single photon detector SPD1 in FIG. 33 described with reference to FIG. 33 . The buried regions 110, control layers 200, connection layers 300, and lens units 400 of the single photon detector SPD1 in FIG. 33 may be connected to each other. The single-photon avalanche diodes 1 of the single-photon detectors SPD1 in Figure 33 may be connected to form the single-photon avalanche diode layer 1a of the single-photon detector array SPA1(SPA). The connection layers 300 of the single-photon detectors SPD1 in FIG. 33 may be connected to form the connection layer 300a of the single-photon detector array SPA1(SPA). The control layers 200 of the single-photon detectors SPD1 in FIG. 33 may be connected to form the control layer 200a of the single-photon detector array SPA1(SPA). The lens units 400 of the single-photon detectors SPD1 in FIG. 33 may be connected to form the lens unit 400a of the single-photon detector array SPA1(SPA). In one embodiment, at least one optical element may be inserted between lens 402 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

The connection layer 300 may include an output pattern 302a, a bias pattern 302b, and a shield pattern 302c. The output pattern 302a, bias pattern 302b, and shield pattern 302c may serve as a reflective layer. The light that is not absorbed in the single-photon avalanche diode layer 1a is reflected by the output pattern 302a, the bias pattern 302b, and the shield pattern 302c, and may be returned to the single-photon avalanche diode layer 1a. Accordingly, the light absorption efficiency of the single-photon avalanche diode layer 1a may be improved.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. For example, the vertical connection portion 304 may include a contact or via.

A device isolation pattern 104 may be disposed between pixels PX that are immediately adjacent to each other. For example, the device isolation pattern 104 may be Shallow Trench Isolation (STI).

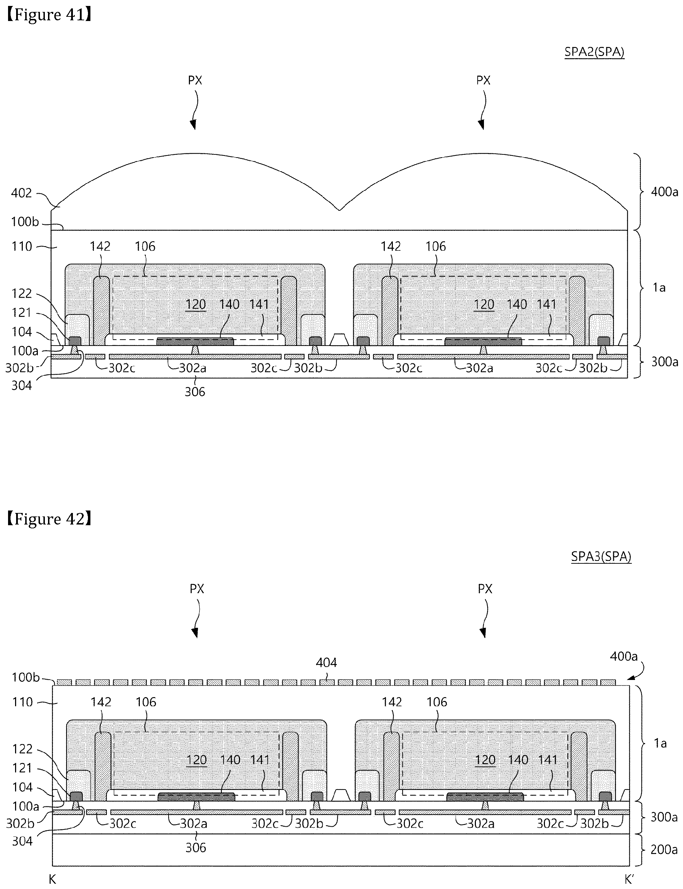

FIG. 41 is a cross-sectional view taken along line K-K' of FIG. 38. For brevity of explanation, content substantially the same as that described with reference to FIG. 34 may not be described.

FIGS. 38 and 41, a single-photon detector array SPA1(SPA) may be provided. The single-photon detector array SPA1(SPA) may include pixels PX arranged in two dimensions. Each of the pixels PX may include a single photon detector SPD2 in FIG. 34 described with reference to FIG. 34. The buried regions 110, connection layers 300, and lens units 400 of the single photon detector SPD2 in FIG. 34 may be connected to each other. The single-photon avalanche diodes 1 of the single-photon detectors SPD2 in Figure 34 may be connected to form the single-photon avalanche diode layer 1a of the single-photon detector array SPA2(SPA). The connection layers 300 of the single-photon detectors SPD2 in FIG. 33 may be connected to form the connection layer 300a of the single-photon detector array SPA1(SPA)). The lens units 400 of the single-photon detectors SPD2 in FIG. 34 may be connected to form the lens unit 400a of the single-photon detector array SPA2(SPA). In one embodiment, at least one optical element may be inserted between lens 402 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

The connection layer 300 may include an output pattern 302a, a bias pattern 302b, and a shield pattern 302c. The output pattern 302a, bias pattern 302b, and shield pattern 302c may serve as a reflective layer. The light that is not absorbed in the single-photon avalanche diode layer 1a is reflected by the output pattern 302a, the bias pattern 302b, and the shield pattern 302c, and may be returned to the single-photon avalanche diode layer 1a. Accordingly, the light absorption efficiency of the single-photon avalanche diode layer 1a may be improved.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. A device isolation pattern 104 may be disposed between pixels PX that are immediately adjacent to each other. For example, the device isolation pattern 104 may be Shallow Trench Isolation (STI). For example, the vertical connection portion 304 may include a contact or via.

FIG. 42 is a cross-sectional view taken along line K-K' of FIG. 38. For brevity of explanation, content substantially the same as that described with reference to FIG. 35 may not be described.

FIGS. 38 and 42, a single-photon detector array SPA3(SPA) may be provided. The single-photon detector array SPA3(SPA) may include pixels PX arranged in two dimensions. Each of the pixels PX may include a single photon detector SPD3 in FIGS. 35 described with reference to FIGS. 35 and 36. The buried regions 110, control layers 200, connection layers 300, and lens units 400 of the single photon detector SPD3 in FIG. 35 may be connected to each other. The single-photon avalanche diodes 1 of the single-photon detectors SPD3 in FIGS. 35 may be connected to form the single-photon avalanche diode layer 1a of the single-photon detector array SPA3(SPA). The connection layers 300 of the single-photon detectors SPD3 in FIG. 33 may be connected to form the connection layer 300a of the single-photon detector array SPA3(SPA). The control layers 200 of the single-photon detectors SPD3 in FIG. 33 may be connected to form the control layer 200a of the single-photon detector array SPA3(SPA). The lens units 400 of the single-photon detectors SPD3 in FIG. 33 may be connected to form the lens unit 400a of the single-photon detector array SPA3(SPA).

The lens unit 400a may include diffraction patterns 404. The diffraction patterns 404 may diffract incident light and increase the absorption length of light within the single-photon avalanche diode layer 1a. In another example, scattering patterns may be provided instead of diffraction patterns 404 on the back side 100b of the single-photon avalanche diode layer 1a. Scattering patterns may be, for example, cross or X shaped patterns. In another example, the scattering patterns may be a combination of a cross and an x shape, or patterns of each shape connected together. The light absorption efficiency of the single-photon avalanche diode layer 1a may be improved by the lens unit 400. In one embodiment, at least one optical element may be inserted between diffraction patterns 404 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer.

The connection layer 300 may include an output pattern 302a, a bias pattern 302b, and a shield pattern 302c. The output pattern 302a, bias pattern 302b, and shield pattern 302c may serve as a reflective layer. The light that is not absorbed in the single-photon avalanche diode layer 1a is reflected by the output pattern 302a, the bias pattern 302b, and the shield pattern 302c, and may be returned to the single-photon avalanche diode layer 1a. Accordingly, the light absorption efficiency of the single-photon avalanche diode layer 1a may be improved.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. A device isolation pattern 104 may be disposed between pixels PX that are immediately adjacent to each other. For example, the device isolation pattern 104 may be Shallow Trench Isolation (STI). For example, a pair of the vertical connection portions 304 may include a contact or via.

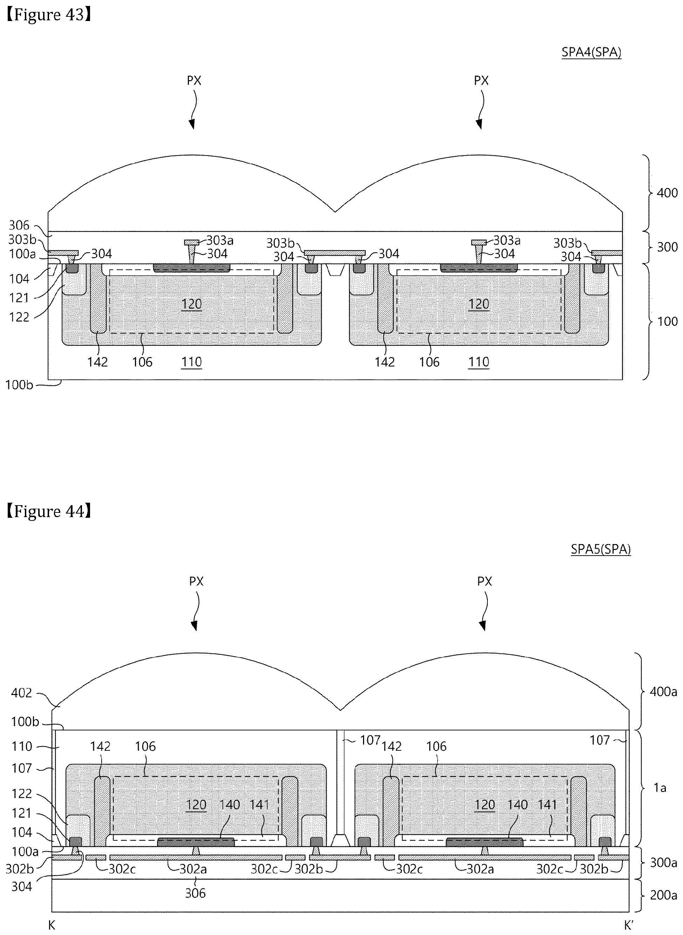

FIG. 43 is a cross-sectional view taken along line K-K' of FIG. 38. For brevity of explanation, content substantially the same as that described with reference to FIG. 37 may not be described.

FIGS. 38 and 43, a single-photon detector array SPA4(SPA) may be provided. The single-photon detector array SPA4(SPA) may include pixels PX arranged in two dimensions. Each of the pixels PX may include a single photon detector SPD4 in FIG. 37 described with reference to FIG. 37 . The buried regions 110, control layers 200, connection layers 300, and lens units 400 of the single photon detector SPD4 in FIG. 37 may be connected to each other. The single-photon avalanche diodes 1 of the single-photon detectors SPD4 in Figure 33 may be connected to form the single-photon avalanche diode layer 1a of the single-photon detector array SPA4(SPA). The connection layers 300 of the single-photon detectors SPD4 in FIG. 37 may be connected to form the connection layer 300a of the single-photon detector array SPA4(SPA). The control layers 200 of the single-photon detectors SPD4 in FIG. 37 may be connected to form the control layer 200a of the single-photon detector array SPA4(SPA). The lens units 400 of the single-photon detectors SPD4 in FIG. 37 may be connected to form the lens unit 400a of the single-photon detector array SPA4(SPA). In one embodiment, at least one optical element may be inserted between lens 402 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

The connection layer 300 may include an insulating layer 306, an output conductive line 303a, a bias conductive line 303b, and a vertical connection portion 304. The vertical connection portion 304 may include a contact or via. For example, the insulating layer 306 may include silicon oxide (e.g., SiO2), silicon nitride (e.g., SiN), silicon oxynitride (e.g., SiON), or combinations thereof. Since the single-photon detector array SPA4(SPA) of the present disclosure is configured to allow light to enter the front side 100a, the incident light sequentially passes through the lens unit 400a and the connection layer 300a and may be reached to the single-photon avalanche diode layer 1a. Therefore, unlike the single-photon detector arrays SPA1, SPA2, and SPA3 shown in FIGS. 39, 41, and 42, the output conductive line 303a and bias conductive line 303b may be used instead of the output pattern 302a, bias pattern 302b, and shield pattern 302c to prevent incident light from reaching the single-photon avalanche diode layer 1a.

The output conductive line 303a may be electrically connected to the first heavily doped region 140. The output conductive line 303a may include an electrically conductive material. For example, the output conductive line 303a may include copper (Cu), aluminum (Al), tungsten (W), titanium (Ti), titanium nitride (TiN), or a combination thereof. The output conductive line 303a may electrically connect the first heavily doped region 140 and the circuitry included in the single-photon avalanche diode layer 1a. For example, the vertical connection portion 304 may be provided between the first heavily doped region 140 and the output conductive line 303a and between the output conductive line 303a and the circuitry. The output conductive line 303a may be configured to extract a detection signal from the single-photon avalanche diode layer 1a.

The bias conductive line 303b may be electrically connected to the first contact 121. The bias conductive line 303b may include an electrically conductive material. For example, the bias conductive line 303b may include copper (Cu), aluminum (Al), tungsten (W), titanium (Ti), titanium nitride (TiN), or a combination thereof. The bias conductive line 303b may electrically connect the first contact 121 and the circuitry included in the single-photon avalanche diode layer 1a. For example, a vertical connection portion 304 may be provided between the first contact 121 and the bias conductive line 303b and between the bias conductive line 303b and the circuitry. The bias conductive line 303b may be configured to apply a bias to the single-photon avalanche diode layer 1a.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. A device isolation pattern 104 may be disposed between pixels PX that are immediately adjacent to each other. For example, the device isolation pattern 104 may be Shallow Trench Isolation (STI).

FIG. 44 is a cross-sectional view taken along line K-K' of FIG. 38. For brevity of explanation, content substantially the same as that described with reference to FIG. 33 may not be described.

FIGS. 38 and 44, a single-photon detector array SPA5(SPA) may be provided. The single-photon detector array SPA5(SPA) may include pixels PX arranged in two dimensions. Each of the pixels PX may include a single photon detector SPD1 in FIG. 33 described with reference to FIG. 33 . The buried regions 110, control layers 200, connection layers 300, and lens units 400 of the single photon detector SPD1 in FIG. 33 may be connected to each other. The single-photon avalanche diodes 1 of the single-photon detectors SPD1 in Figure 33 may be connected to form the single-photon avalanche diode layer 1a of the single-photon detector array SPA5(SPA). The connection layers 300 of the single-photon detectors SPD1 in FIG. 33 may be connected to form the connection layer 300a of the single-photon detector array SPA5(SPA). The control layers 200 of the single-photon detectors SPD1 in FIG. 33 may be connected to form the control layer 200a of the single-photon detector array SPA5(SPA). The lens units 400 of the single-photon detectors SPD1 in FIG. 33 may be connected to form the lens unit 400a of the single-photon detector array SPA5(SPA). In one embodiment, at least one optical element may be inserted between lens 402 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

The connection layer 300 may include an output pattern 302a, a bias pattern 302b, and a shield pattern 302c. The output pattern 302a, bias pattern 302b, and shield pattern 302c may serve as a reflective layer. The light that is not absorbed in the single-photon avalanche diode layer 1a is reflected by the output pattern 302a, the bias pattern 302b, and the shield pattern 302c, and may be returned to the single-photon avalanche diode layer 1a. Accordingly, the light absorption efficiency of the single-photon avalanche diode layer 1a may be improved.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. For example, the vertical connection portion 304 may include a contact or via.

A device isolation pattern 104 may be disposed between pixels PX that are immediately adjacent to each other. For example, the device isolation pattern 104 may be Shallow Trench Isolation (STI).

A vertical separation pattern 107 may be provided between the device isolation pattern 104 and the back side 100b. One end of the vertical isolation pattern 107 may be in direct contact with the device isolation pattern 104, and the other end may be exposed on the back side 100b. For example, the top surface of the vertical separation pattern 107 may be located at substantially the same level as the back side 100b. The vertical separation pattern 107 may be formed by filling a recessed region formed by etching the buried region 110 with an insulating material. For example, the vertical separation pattern 107 may be Full Trench Isolation (FTI). In one embodiment, the vertical separation pattern 107 may include a metal(such as copper (Cu), aluminum (Al), tungsten (W), and titanium (Ti)), polysilicon, or a high-k materials(such as hafnium oxide (HfO2), zirconium oxide (zirconia, ZrO2), and tantalum oxide (TaO)).

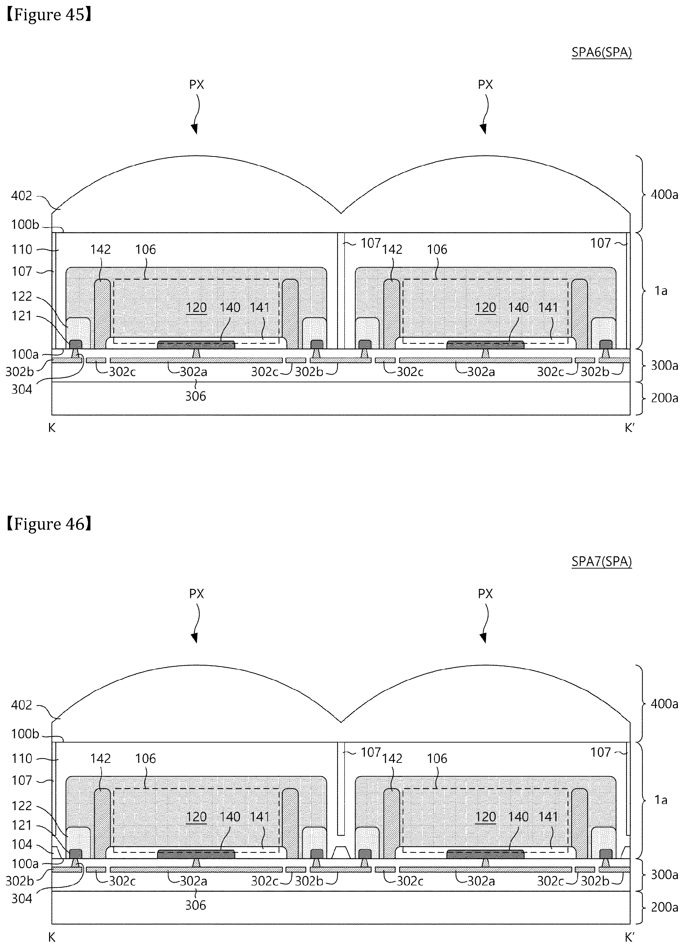

FIG. 45 is a cross-sectional view taken along line K-K' of FIG. 38. For brevity of explanation, content substantially the same as that described with reference to FIG. 33 may not be described.

FIGS. 38 and 45, a single-photon detector array SPA6(SPA) may be provided. The single-photon detector array SPA6(SPA) may include pixels PX arranged in two dimensions. Each of the pixels PX may include a single photon detector SPD1 in FIG. 33 described with reference to FIG. 33 . The buried regions 110, control layers 200, connection layers 300, and lens units 400 of the single photon detector SPD1 in FIG. 33 may be connected to each other. The single-photon avalanche diodes 1 of the single-photon detectors SPD1 in Figure 33 may be connected to form the single-photon avalanche diode layer 1a of the single-photon detector array SPA6(SPA). The connection layers 300 of the single-photon detectors SPD1 in FIG. 33 may be connected to form the connection layer 300a of the single-photon detector array SPA6(SPA). The control layers 200 of the single-photon detectors SPD1 in FIG. 33 may be connected to form the control layer 200a of the single-photon detector array SPA6(SPA). The lens units 400 of the single-photon detectors SPD1 in FIG. 33 may be connected to form the lens unit 400a of the single-photon detector array SPA6(SPA). In one embodiment, at least one optical element may be inserted between lens 402 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

The connection layer 300 may include an output pattern 302a, a bias pattern 302b, and a shield pattern 302c. The output pattern 302a, bias pattern 302b, and shield pattern 302c may serve as a reflective layer. The light that is not absorbed in the single-photon avalanche diode layer 1a is reflected by the output pattern 302a, the bias pattern 302b, and the shield pattern 302c, and may be returned to the single-photon avalanche diode layer 1a. Accordingly, the light absorption efficiency of the single-photon avalanche diode layer 1a may be improved.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. For example, the vertical connection portion 304 may include a contact or via.

A vertical separation pattern 107 may be provided between pixels PX that are immediately adjacent to each other. One end of the vertical separation pattern 107 may be exposed on the front side 100a, and the other end may be exposed on the back side 100b. For example, the bottom surface and top surface of the vertical separation pattern 107 may be located at substantially the same level as the front side 100a and the back side 100b, respectively. The vertical separation pattern 107 may be formed by filling a recessed region formed by etching the buried region 110 with an insulating material. For example, the vertical separation pattern 107 may be Full Trench Isolation (FTI). In one embodiment, the vertical separation pattern 107 may include a metal(such as copper (Cu), aluminum (Al), tungsten (W), and titanium (Ti)), polysilicon, or a high-k materials(such as hafnium oxide (HfO2), zirconium oxide (zirconia, ZrO2), and tantalum oxide (TaO)).

FIG. 46 is a cross-sectional view taken along line K-K' of FIG. 38. For brevity of explanation, content substantially the same as that described with reference to FIG. 33 may not be described.

FIGS. 38 and 46, a single-photon detector array SPA7(SPA) may be provided. The single-photon detector array SPA7(SPA) may include pixels PX arranged in two dimensions. Each of the pixels PX may include a single photon detector SPD1 in FIG. 33 described with reference to FIG. 33 . The buried regions 110, control layers 200, connection layers 300, and lens units 400 of the single photon detector SPD1 in FIG. 33 may be connected to each other. The single-photon avalanche diodes 1 of the single-photon detectors SPD1 in Figure 33 may be connected to form the single-photon avalanche diode layer 1a of the single-photon detector array SPA7(SPA). The connection layers 300 of the single-photon detectors SPD1 in FIG. 33 may be connected to form the connection layer 300a of the single-photon detector array SPA7(SPA). The control layers 200 of the single-photon detectors SPD1 in FIG. 33 may be connected to form the control layer 200a of the single-photon detector array SPA7(SPA). The lens units 400 of the single-photon detectors SPD1 in FIG. 33 may be connected to form the lens unit 400a of the single-photon detector array SPA7(SPA). In one embodiment, at least one optical element may be inserted between lens 402 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

The connection layer 300 may include an output pattern 302a, a bias pattern 302b, and a shield pattern 302c. The output pattern 302a, bias pattern 302b, and shield pattern 302c may serve as a reflective layer. The light that is not absorbed in the single-photon avalanche diode layer 1a is reflected by the output pattern 302a, the bias pattern 302b, and the shield pattern 302c, and may be returned to the single-photon avalanche diode layer 1a. Accordingly, the light absorption efficiency of the single-photon avalanche diode layer 1a may be improved.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. For example, the vertical connection portion 304 may include a contact or via.

A device isolation pattern 104 may be disposed between pixels PX that are immediately adjacent to each other. For example, the device isolation pattern 104 may be Shallow Trench Isolation (STI).

A vertical separation pattern 107 may be provided between the device isolation pattern 104 and the back side 100b. One end of the vertical isolation pattern 107 may be disposed adjacent to the device isolation pattern 104, and the other end may be exposed on the back side 100b. The vertical isolation pattern 107 may be spaced apart from the device isolation pattern 104. The bottom surface of the vertical isolation pattern 107 may face the device isolation pattern 104. A buried region 110 may be provided between the vertical isolation pattern 107 and the device isolation pattern 104. For example, the top surface of the vertical separation pattern 107 may be located at substantially the same level as the back side 100b. The vertical separation pattern 107 may be formed by filling a recessed region formed by etching the buried region 110 with an insulating material. For example, the vertical separation pattern 107 may be Deep Trench Isolation (DTI). For example, the vertical separation pattern 107 may be Partial DTI (Deep Trench Isolation). In one embodiment, the vertical separation pattern 107 may include a metal(such as copper (Cu), aluminum (Al), tungsten (W), and titanium (Ti)), polysilicon, or a high-k materials(such as hafnium oxide (HfO2), zirconium oxide (zirconia, ZrO2), and tantalum oxide (TaO)).

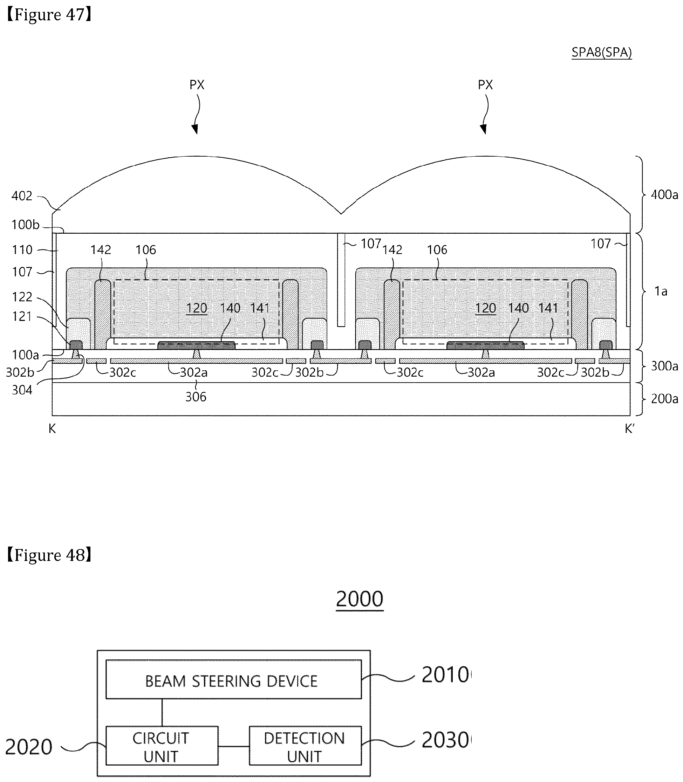

FIG. 47 is a cross-sectional view taken along line K-K' of FIG. 38. For brevity of explanation, content substantially the same as that described with reference to FIG. 33 may not be described.

FIGS. 38 and 47, a single-photon detector array SPA8(SPA) may be provided. The single-photon detector array SPA8(SPA) may include pixels PX arranged in two dimensions. Each of the pixels PX may include a single photon detector SPD1 in FIG. 33 described with reference to FIG. 33 . The buried regions 110, control layers 200, connection layers 300, and lens units 400 of the single photon detector SPD1 in FIG. 33 may be connected to each other. The single-photon avalanche diodes 1 of the single-photon detectors SPD1 in Figure 33 may be connected to form the single-photon avalanche diode layer 1a of the single-photon detector array SPA8(SPA). The connection layers 300 of the single-photon detectors SPD1 in FIG. 33 may be connected to form the connection layer 300a of the single-photon detector array SPA8(SPA). The control layers 200 of the single-photon detectors SPD1 in FIG. 33 may be connected to form the control layer 200a of the single-photon detector array SPA8(SPA). The lens units 400 of the single-photon detectors SPD1 in FIG. 33 may be connected to form the lens unit 400a of the single-photon detector array SPA8(SPA). In one embodiment, at least one optical element may be inserted between lens 402 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

The connection layer 300 may include an output pattern 302a, a bias pattern 302b, and a shield pattern 302c. The output pattern 302a, bias pattern 302b, and shield pattern 302c may serve as a reflective layer. The light that is not absorbed in the single-photon avalanche diode layer 1a is reflected by the output pattern 302a, the bias pattern 302b, and the shield pattern 302c, and may be returned to the single-photon avalanche diode layer 1a. Accordingly, the light absorption efficiency of the single-photon avalanche diode layer 1a may be improved.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. For example, the vertical connection portion 304 may include a contact or via.

A vertical separation pattern 107 may be provided between pixels PX that are immediately adjacent to each other. One end of the vertical separation pattern 107 may be spaced apart from the front side 100a. A buried region 110 may be provided between one end of the vertical separation pattern 107 and the connection layer 300a. The other end of the vertical separation pattern 107 may be exposed on the back side 100b. For example, the top surface of the vertical separation pattern 107 may be located at substantially the same level as the back side 100b. The vertical separation pattern 107 may be formed by filling a recessed region formed by etching the buried region 110 with an insulating material. For example, the vertical separation pattern 107 may be Deep Trench Isolation (DTI). For example, the vertical separation pattern 107 may be Partial DTI (Deep Trench Isolation). In one embodiment, the vertical separation pattern 107 may include a metal(such as copper (Cu), aluminum (Al), tungsten (W), and titanium (Ti)), polysilicon, or a high-k materials(such as hafnium oxide (HfO2), zirconium oxide (zirconia, ZrO2), and tantalum oxide (TaO)).

FIG. 48 is a block diagram for describing an electronic device according to an example embodiment.

Referring to FIG. 48, an electronic device 2000 may be provided. The electronic device 2000 may radiate light toward a subject (not shown) and detect light reflected by the subject and returned to the electronic device 2000. The electronic device 2000 may include a beam steering device 2010. The beam steering device 2010 may adjust a direction of irradiation of light emitted to the outside of the electronic device 2000. The beam steering device 2010 may be a mechanical or non-mechanical (semiconductor) beam steering device. The electronic device 2000 may include a light source unit within the beam steering device 2010 or may include a light source unit provided separately from the beam steering device 2010. The beam steering device 2010 may be a scanning type light emitting device. However, the light emitting device of the electronic device 2000 is not limited to the beam steering device 2010. In another example, the electronic device 2000 may include a flash type light emitting device instead of the beam steering device 2010 or together with the beam steering device 2010. A flash-type light emitting device may radiate light to an area including an entire field of view at once without a scanning process.

The light steered by the beam steering device 2010 may return to the electronic device 2000 after being reflected by the subject. The electronic device 2000 may include a detector 2030 for detecting light reflected by the subject. The detector 2030 may include a plurality of light detection elements and may further include other optical members. The plurality of light detection elements may include any one of the single photon detection elements 1000 to 1900 described above. In addition, the electronic device 2000 may further include a circuit unit 2020 connected to at least one of the beam steering device 2010 and the detection unit 2030. The circuit unit 2020 may include a calculation unit that acquires and calculates data, and may further include a driving unit and a control unit. In addition, the circuit unit 2020 may further include a power supply unit and a memory.

Although the case where the electronic device 2000 includes the beam steering device 2010 and the detection unit 2030 in one device is shown, the beam steering device 2010 and the detection unit 2030 are not provided as one device. The beam steering device 2010 and the detection unit 2030 may be provided separately in devices. In addition, the circuit unit 2020 may be connected to the beam steering device 2010 or the detection unit 2030 through wireless communication without being wired.

The electronic device 2000 according to the above-described embodiment may be applied to various electronic devices. As an example, the electronic device 2000 may be applied to a Light Detection And Ranging (LiDAR) device. The LiDAR device may be a phase-shift type device or a time-of-flight (TOF) type device. In addition, the single photon detection elements 1000 to 1900 according to the embodiment or the electronic device 2000 including the same may be used in smart phones, wearable devices (glasses-type devices realizing augmented reality and virtual reality, etc.), and the Internet of Things (Internet of Things). IoT) devices, home appliances, tablet PCs (personal computers), PDAs (personal digital assistants), PMPs (portable multimedia players), navigation, drones, robots, unmanned vehicles, self-driving cars, and Advanced Drivers Assistance System (ADAS).

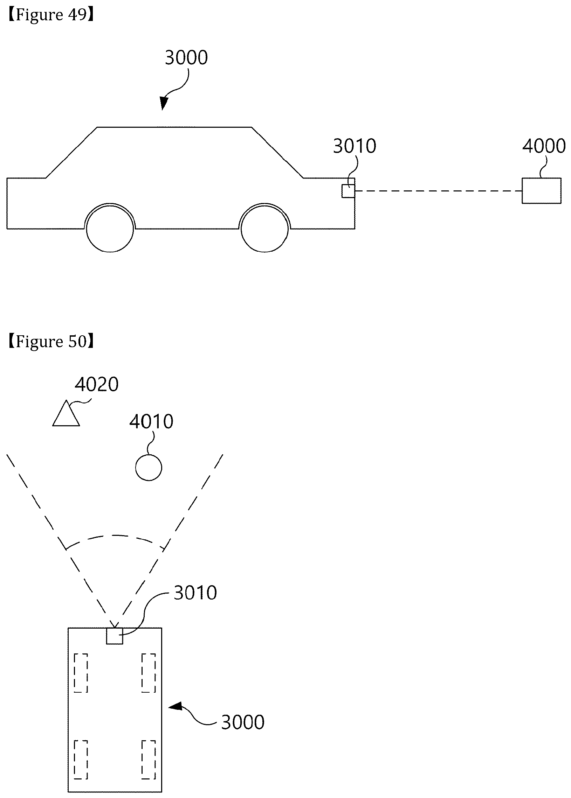

FIGS. 49 and 50 are conceptual diagrams illustrating cases in which a LiDAR device according to an example embodiment is applied to a vehicle.

Referring to FIGS. 49 and 50, a LiDAR device 3010 may be applied to a vehicle 3000. Information on the subject 4000 may be obtained using a LiDAR device 3010 applied to a vehicle. The vehicle 3000 may be an automobile having an autonomous driving function. The LiDAR device 3010 may detect an object or person, ie, the subject 4000, in the direction in which the vehicle 3000 travels. The LiDAR device 3010 may measure the distance to the subject 4000 using information such as a time difference between a transmission signal and a detection signal. The LiDAR device 3010 may obtain information about a near subject 4010 and a far subject 4020 within a scanning range. The LiDAR device 3010 may include the electronic device 2000 described with reference to FIG. 38. It is illustrated that a LiDAR device 3010 is disposed in front of the vehicle 3000 to detect the subject 4000 in the direction in which the vehicle 3000 is traveling, but this is not limiting. In another example, the LiDAR device 3010 may be disposed at a plurality of locations on the vehicle 3000 to detect all subjects 4000 around the vehicle 3000. For example, four LiDAR devices 4010 may be disposed at the front, rear, and both sides of the vehicle 3000, respectively. In another example, the LiDAR device 3010 is disposed on the roof of the vehicle 3000 and rotates to detect all subjects 4000 around the vehicle 3000.

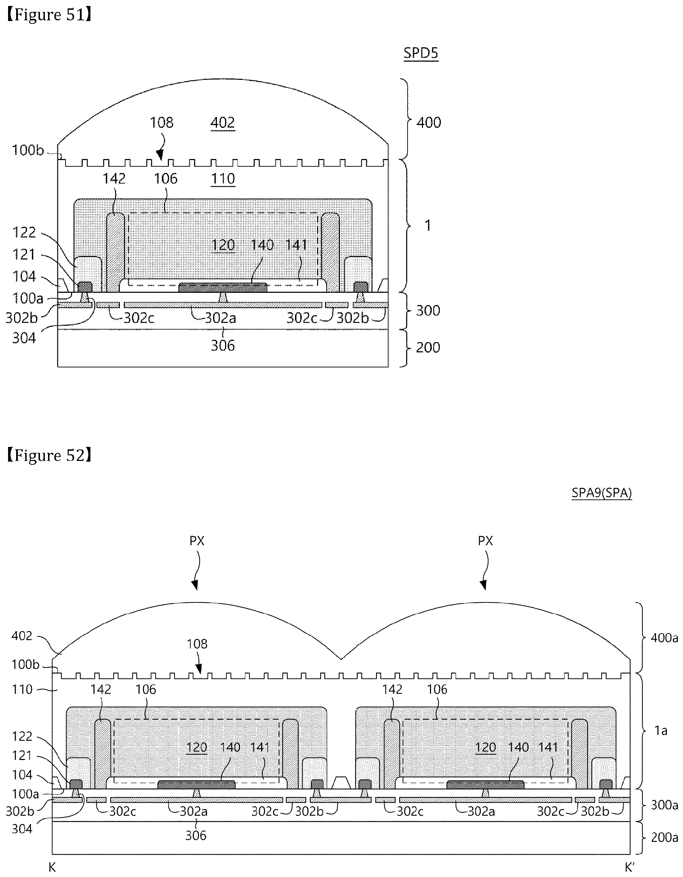

FIG. 51 is a cross-sectional view of a single-photon detector according to an example embodiment. For brevity of explanation, content substantially the same as that described with reference to FIGS. 1 and 2 may not be described.

Referring to FIG. 51, a single photon detector SPD5 may be provided. The single-photon detector SPD5 may include a single-photon avalanche diode 1, a control layer 200, a connection layer 300, and a lens unit 400. The single photon detector SPD5 may be a back side illumination (BSI) type image sensor. The frontside may be a side on which various semiconductor processes are performed when manufacturing the single-photon avalanche diode 1, and the backside may be a side disposed opposite to the front side. For example, the top and bottom surfaces of the single-photon avalanche diodes 1000 to 1900 of the present disclosure may be the front side 100a and the back side 100b, respectively. The back side illumination type may refer to light entering the back side 100b of the single-photon avalanche diode 1. The front side illumination type described later may refer to light entering the front side of the single-photon avalanche diode 1. The single-photon avalanche diode 1 may be substantially the same as the single-photon avalanche diode 1000 described with reference to FIGS. 1 and 2. In another example, single-photon avalanche diode 1 may be any one of the single-photon avalanche diodes 1100 to 1900 described above. For convenience of explanation, the single-photon avalanche diode 1 is shown with the top and bottom of the single-photon avalanche diode 1000 shown in FIG. 2 reversed. Accordingly, the top and bottom surfaces of the single-photon avalanche diode 1 may be the back side 100b and the front side 100a, respectively.

The control layer 200 may be provided on the front side of the single-photon avalanche diode 1. The control layer 200 may include a circuitry necessary for operation of the single-photon avalanche diode 1. For example, the control layer 200 may be a chip on which a circuitry is formed. The circuitry may be implemented by various electronic devices as needed. The circuitry may include a quenching resistor (or quenching circuitry) and a pixel circuitry. A quenching resistor (or quenching circuitry) may be configured to stop the avalanche effect and allow the single-photon avalanche diode 1 to detect another photon. The pixel circuitry may be composed of a reset or recharge circuitry, memory, amplifier circuitry, counter, gate circuitry, time-to-digital converter, etc. Additionally, the circuitry may include a DC-to-DC converter and other power management integrated circuitrys. The circuitry may transmit a signal to the single-photon avalanche diode 1 or receive a signal from the single-photon avalanche diode 1.

The connection layer 300 may be provided between the single-photon avalanche diode 1 and the control layer 200. The connection layer 300 may include an insulating layer 306, an output pattern 302a, a bias pattern 302b, a shield pattern 302c, and a vertical connection portion 304. For example, the insulating layer 306 may include silicon oxide (e.g., SiO2), silicon nitride (e.g., SiN), silicon oxynitride (e.g., SiON), or combinations thereof. For example, the vertical connection portion 304 may include a contact or via.

The output pattern 302a may be electrically connected to the first heavily doped region 140. The output pattern 302a may include an electrically conductive material. For example, the output pattern 302a may include copper (Cu), aluminum (Al), tungsten (W), titanium (Ti), titanium nitride (TiN), or a combination thereof. The output pattern 302a may electrically connect the first heavily doped region 140 and the circuitry of the control layer 200. For example, a vertical connection 304 may be provided between the first heavily doped region 140 and the output pattern 302a, and Cu-Cu bonding may be provided between the output pattern 302a and the control layer 200. there is. The output pattern 302a may be configured to extract a detection signal from the single-photon avalanche diode 1.

The bias pattern 302b may be electrically connected to the first contact 121. Bias pattern 302b may include an electrically conductive material. For example, the bias pattern 302b may include copper (Cu), aluminum (Al), tungsten (W), titanium (Ti), titanium nitride (TiN), or a combination thereof. The bias pattern 302b may electrically connect the first contact 121 and the circuitry of the control layer 200. For example, a vertical connection 304 may be provided between the first contact 121 and the bias pattern 302b, and Cu-Cu bonding may be provided between the bias pattern 302b and the control layer 200. The bias pattern 302b may be configured to apply a bias to the single-photon avalanche diode 1.

The shield pattern 302c may electrically shield between the output pattern 302a and the bias pattern 302b. For example, the shield pattern 302c may be configured so that the detection signal extracted by the output pattern 302a is not affected by the bias signal applied to the bias pattern 302b.

The output pattern 302a, bias pattern 302b, and shield pattern 302c may serve as a reflective layer. Light that is not absorbed in the single-photon avalanche diode 1 is reflected by the output pattern 302a, bias pattern 302b, and shield pattern 302c, and may be incident again on the single-photon avalanche diode 1. Accordingly, the light absorption efficiency of the single-photon avalanche diode 1 may be improved.

Second diffraction patterns 108 may be provided on the back side 100b of the single-photon avalanche diode 1. For example, the second diffraction patterns 108 may be formed by etching the back side 100b of the single-photon avalanche diode 1. The second diffraction patterns 108 may diffract incident light and increase the absorption length of light within the single-photon avalanche diode 1. In another example, scattering patterns may be formed on the back side 100b of the single-photon avalanche diode 1 instead of the second diffraction patterns 108. Scattering patterns may be formed by etching the back side 100b of the single-photon avalanche diode 1. Scattering patterns may be, for example, cross or X shaped patterns. In another example, the scattering patterns may be a combination of a cross and an x shape, or patterns of each shape connected together.

The lens unit 400 may be provided on the back side 100b of the single-photon avalanche diode 1. The lens unit 400 may cover the second diffraction patterns 108. The lens unit 400 may include a lens 402. The lens 402 may focus the incident light and deliver it to the single-photon avalanche diode 1. For example, the lens 402 may include a microlens, a Fresnel lens, or a metalens. However, the type of lens 402 is not limited and may be determined as needed. In one example, the central axis of lens 402 may be aligned with the central axis of the single-photon avalanche diode 1. The central axis of the lens 402 and the central axis of the single-photon avalanche diode 1 may pass through the center of the lens 402 and the center of the single-photon avalanche diode 1, respectively, and may be a virtual axis parallel to the stacking direction of the single-photon avalanche diode 1 and the lens 402. In one example, the central axis of the lens 402 may be aligned misaligned with the central axis of the single-photon avalanche diode 1. In one embodiment, the width of the lens 402 is about half the width of the single-photon avalanche diode 1 and may be implemented in a 2x2 shape. In one embodiment, at least one optical element may be inserted between lens 402 and single-photon avalanche diode 1. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

FIG. 52 is a cross-sectional view taken along line K-K' of FIG. 38. For brevity of explanation, content substantially the same as that described with reference to FIG. 51 may not be described.

FIGS. 38 and 52, a single-photon detector array SPA9(SPA) may be provided. The single-photon detector array SPA9(SPA) may include pixels PX arranged in two dimensions. Each of the pixels PX may include a single photon detector SPD5 in FIG. 51 described with reference to FIG. 51. The buried regions 110, control layers 200, connection layers 300, and lens units 400 of the single photon detector SPD5 in FIG. 51 may be connected to each other. The single-photon avalanche diodes 1 of the single-photon detectors SPD5 in Figure 33 may be connected to form the single-photon avalanche diode layer 1a of the single-photon detector array SPA9(SPA). The connection layers 300 of the single-photon detectors SPD5 in FIG. 51 may be connected to form the connection layer 300a of the single-photon detector array SPA9(SPA). The control layers 200 of the single-photon detectors SPD5 in FIG. 51 may be connected to form the control layer 200a of the single-photon detector array SPA9(SPA).

Second diffraction patterns 108 may be provided on the back side 100b of the single-photon avalanche diode layer 1a. For example, the second diffraction patterns 108 may be formed by etching the back side 100b of the single-photon avalanche diode layer 1a. The second diffraction patterns 108 may diffract incident light and increase the absorption length of light within the single-photon avalanche diode layer 1a. In another example, scattering patterns may be formed on the back side 100b of the single-photon avalanche diode layer 1a instead of the second diffraction patterns 108. Scattering patterns may be formed by etching the back side 100b of the single-photon avalanche diode layer 1a. Scattering patterns may be, for example, cross or X shaped patterns. In another example, the scattering patterns may be a combination of a cross and an x shape, or patterns of each shape connected together.

The lens units 400 of the single-photon detectors SPD5 in FIG. 51 may be connected to form the lens unit 400a of the single-photon detector array SPA9(SPA). In one embodiment, at least one optical element may be inserted between lens 402 and single-photon avalanche diode layer 1a. For example, optical elements include color filters, bandpass filters, metal grids, air grids, grids based on low refractive index materials, anti-reflective elements, an anti-reflection coating, a 2D nanomaterial layer, or an organic material layer. In one example, an anti-reflective coating may be formed on top of lens 402.

The connection layer 300 may include an output pattern 302a, a bias pattern 302b, and a shield pattern 302c. The output pattern 302a, bias pattern 302b, and shield pattern 302c may serve as a reflective layer. The light that is not absorbed in the single-photon avalanche diode layer 1a is reflected by the output pattern 302a, the bias pattern 302b, and the shield pattern 302c, and may be returned to the single-photon avalanche diode layer 1a. Accordingly, the light absorption efficiency of the single-photon avalanche diode layer 1a may be improved.

A pair of first contacts 121 included in different pixels PX and immediately adjacent to each other may be configured to share one bias pattern 302b. For example, one bias pattern 302b and a pair of first contacts 121 may be electrically connected to each other by a pair of vertical connection portions 304. For example, the vertical connection portion 304 may include a contact or via.

A device isolation pattern 104 may be disposed between pixels PX that are immediately adjacent to each other. For example, the device isolation pattern 104 may be Shallow Trench Isolation (STI).

The above description of embodiments of the technical idea of the present disclosure provides examples for explanation of the technical idea of the present disclosure. Therefore, the technical spirit of the present disclosure is not limited to the above embodiments, and it is clear that many modifications and changes, such as combining and implementing the above embodiments, are possible by those skilled in the art within the technical spirit of the present disclosure.

## Claims

1. A single-photon avalanche diode comprising:
a heavily doped region;
a first lightly doped region covering the heavily doped region;
a guard ring provided on a side surface of the first lightly doped region;
a first well covering the first lightly doped region and the guard ring; and
a contact electrically connected to the first well;
wherein the heavily doped region, the first lightly doped region, and the guard ring have a first conductivity type,
wherein the first well and the contact have a second conductivity type.

2. The single-photon avalanche diode of claim 1, further comprising:
a relief area provided between the first well and the contact;
whrein the relief region has the second conductivity type and has a lower doping concentration than the contact.

3. The single-photon avalanche diode of claim 1, further comprising:
a polysilicon pattern provided on the guard ring.

4. The single-photon avalanche diode of claim 1, further comprising:
a second lightly doped region provided on the first lightly doped region; and
a second well provided between the second lightly doped region and the first well,
wherein the second lightly doped region and the second well have the second conductivity type.

5. The single-photon avalanche diode of claim 4, wherein the guard ring protrudes from a top surface of the second well.

6. A single-photon avalanche diode comprising:
a heavily doped region;
a first lightly doped region covering the heavily doped region;
a guard ring provided on a side surface of the first lightly doped region;
a first well covering the first lightly doped region and the guard ring; and
a contact electrically connected to the first well;
wherein the heavily doped region and the guard ring have a first conductivity type,
wherein the first lightly doped region, the first well, and the contact have a second conductivity type.

7. The single-photon avalanche diode of claim 6, further comprising:
a second well provided on the first lightly doped region,
wherein the second well has the second conductivity type.

8. The single-photon avalanche diode of claim 7, wherein a top surface of the second well is disposed higher than a top surface of the guard ring.

9. The single-photon avalanche diode of claim 6, further comprising:
a relief region provided between the first well and the contact,
wherein the relief region has the second conductivity type and has a lower doping concentration than the contact.

10. The single-photon avalanche diode of claim 6, further comprising: a polysilicon pattern provided on the guard ring.

11. A electronic device comprising:
a single-photon avalanche diode including a heavily doped region, a first lightly doped region covering the heavily doped region, a guard ring provided on a side surface of the first lightly doped region, a first well covering the first lightly doped region and the guard ring, and a contact electrically connected to the first well,
wherein the heavily doped region, the first lightly doped region, and the guard ring have a first conductivity type,
wherein the first well and the contact have a second conductivity type.

12. A LiDAR device comprising:
an electronic device including a single-photon avalanche diode,
wherein the single-photon avalanche diode includes a heavily doped region, a first lightly doped region covering the heavily doped region, a guard ring provided on a side surface of the first lightly doped region, a first well covering the first lightly doped region and the guard ring, and a contact electrically connected to the first well,
wherein the heavily doped region, the first lightly doped region, and the guard ring have a first conductivity type,
wherein the first well and the contact have a second conductivity type.
